# EUROPÄISCHE PATENTSCHRIFT

(11) **EP 1 957 604 B1**
(45) Veröffentlichungstag und Bekanntmachung des Hinweises auf die Patenterteilung: **23.09.2015**
(21) Anmeldenummer: 06818610.5
(22) Anmeldetag: 17.11.2006
(51) Int. Cl.: C09K 11/06, H05B 33/14, C07C 211/54, C07C 15/28, H01L 51/00

(54) **NEUE MATERIALIEN FÜR ORGANISCHE ELEKTROLUMINESZENZVORRICHTUNGEN**
NOVEL MATERIALS FOR ORGANIC ELECTROLUMINESCENT DEVICES
NOUVELLES MATIÈRES POUR DISPOSITIFS ÉLECTROLUMINESCENTS ORGANIQUES

(30) Priorität: 08.12.2005 DE 102005058557; 02.03.2006 DE 102006009630
(43) Veröffentlichungstag der Anmeldung: 20.08.2008
(73) Patentinhaber: Merck Patent GmbH, 64293 Darmstadt (DE)
(72) Erfinder: HEIL, Holger, 64295 Darmstadt (DE); STOESSEL, Philipp, 60487 Frankfurt/Main (DE); PARHAM, Amir, 65929 Frankfurt (DE); VESTWEBER, Horst, 34630 Gilersberg-Winterscheid (DE)
(86) Internationale Anmeldenummer: PCT/EP2006/011029
(87) Internationale Veröffentlichungsnummer: WO 2007/065550

(56) Entgegenhaltungen:
- EP-A- 1 533 289
- EP-A- 1 533 290
- EP-A- 1 553 154
- EP-A1- 1 167 488
- EP-A2- 0 681 019
- JP-A- 2004 103 463
- US-A1- 2006 226 768
- US-B1- 6 506 504

## Beschreibung

Die vorliegende Erfindung beschreibt neue Anthracenderivate, die Verwendung dieser Verbindungen in organischen Elektrolumineszenzvorrichtungen und organische Elektrolumineszenzvorrichtungen enthaltend diese Verbindungen.

Organische Halbleiter werden als funktionelle Materialien in einer Reihe verschiedenartiger Anwendungen, die im weitesten Sinn der Elektronikindustrie zugerechnet werden können, verwendet. Der allgemeine Aufbau organischer Elektrolumineszenzvorrichtungen, die zur Emission von Licht im sichtbaren Spektralbereich befähigt sind, ist beispielsweise in US 4539507, US 5151629, EP 0676461 und WO 98/27136 beschrieben.

Allerdings zeigen diese Vorrichtungen immer noch erhebliche Probleme, die für die Verwendung in hochwertigen Vollfarbdisplays einer dringenden Verbesserung bedürfen:
1. Die verwendeten Verbindungen sind nicht ausreichend thermisch stabil und weisen keine ausreichend hohe Glasübergangstemperatur auf.
2. Die verwendeten Verbindungen sind nicht ausreichend gut löslich in organischen Lösemitteln, was ihre Reinigung bei der Herstellung sowie die Reinigung der Aufdampfanlagen (beispielsweise der Schattenmasken) erschwert.
3. Die Loch- und Elektronenstabilität (Redoxstabilität) der bislang verwendeten Verbindungen ist noch nicht ausreichend.

Als nächstliegender Stand der Technik kann die Verwendung verschiedener kondensierter Aromaten, insbesondere Anthracen- oder Pyrenderivate, als Host-Materialien vor allem für blau emittierende Elektrolumineszenzvorrichtungen genannt werden. Als Host-Material gemäß dem Stand der Technik ist 9,10-Bis(2-naphthyl)anthracen (US 5935721) bekannt. Weitere Anthracenderivate, die sich als Host-Materialien eignen, sind beispielsweise in WO 01/076323, in WO 01/021729, in WO 04/013073, in WO 04/018588, in WO 03/087023 oder in WO 04/018587 beschrieben. Host-Materialien, basierend auf arylsubstituierten Pyrenen und Chrysenen, werden in WO 04/016575 beschrieben, wobei hier prinzipiell auch entsprechende Anthracen- und Phenanthrenderivate mit umfasst sind. In WO 03/095445 und in CN 1362464 werden 9,10-Bis(1-naphthyl)anthracen-Derivate für die Verwendung in OLEDs beschrieben.

Es war die Aufgabe der vorliegenden Erfindung, Verbindungen mit verbesserten Eigenschaften, insbesondere verbesserte Hostmaterialien und verbesserte blaue und grüne Emitter, bereitzustellen.

Überraschend wurde gefunden, dass organische Elektrolumineszenzvorrichtungen, welche bestimmte Anthracenderivate enthalten, die mit Trialkylsilylgruppen substituiert sind, deutliche Verbesserungen gegenüber dem Stand der Technik aufweisen. Diese Verbindungen weisen eine hohe thermische Stabilität, eine hohe Glasübergangstemperatur, eine hohe Redoxstabilität und eine gute Löslichkeit in organischen Lösemitteln auf. Diese Verbindungen und deren Verwendung in OLEDs sind daher der Gegenstand der vorliegenden Erfindung.

Gegenstand der Erfindung sind silyl-substituierte Verbindungen der Formel (1), 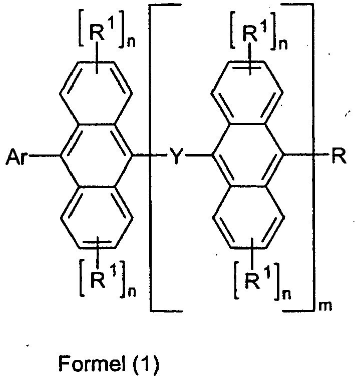 wobei für die verwendeten Symbole und Indizes gilt:
- Ar: ist eine 1-Naphthylgruppe oder eine 9-Anthrylgruppe, in welcher ein oder zwei Kohlenstoffatome durch N ersetzt sein können und welche mit einem oder mehreren Resten R¹ substituiert sein kann und/oder welche mit einem oder mehreren Resten N(Ar¹)₂ substituiert sein kann, wobei die beiden Reste Ar¹ auch durch eine Einfachbindung oder eine Gruppe O, S, N(R¹) oder C(R¹)₂ miteinander verbunden sein können;
- R: ist ein aromatisches oder heteroaromatisches Ringsystem mit 5 bis 40 aromatischen Ringatomen, welches mit einem oder mehreren Resten R¹ substituiert sein kann, oder eine Gruppe N(Ar¹)₂, wobei die beiden Reste Ar¹ auch durch eine Einfachbindung oder eine Gruppe O, S, N(R¹) oder C(R¹)₂ miteinander verbunden sein können;
- Ar¹: ist bei jedem Auftreten gleich oder verschieden ein aromatisches oder heteroaromatisches Ringsystem mit 5 bis 40 aromatischen Ringatomen, welches durch einen oder mehrere Reste R¹ substituiert sein kann;
- Y: ist bei jedem Auftreten gleich oder verschieden eine bivalente Gruppe enthaltend 1 bis 40 C-Atome oder -O-, -S-, -NR¹-, -P(=O)R¹- oder eine Einfachbindung;
- R¹: ist gleich oder verschieden bei jedem Auftreten Si(R²)₃, F, Cl, Br, I, CN, N(R³)₂, NO₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch -R³C=CR³-, -C≡C-, Si(R³)₂, Ge(R³)₂, Sn(R³)₂, C=O C=S, C=Se, C=NR³, -O-, -S-, -N(R³)- oder -CONR³- ersetzt sein können und wobei ein oder mehrere H-Atome durch F, Cl, Br, I, CN oder NO₂ ersetzt sein können, oder eine Aryl- oder Heteroarylgruppe mit 5 bis 24 aromatischen Ringatomen, die mit einem oder mehreren Resten R³ substituiert sein kann, oder eine Aryloxy- oder Heteroaryloxygruppe mit 5 bis 24 aromatischen Ringatomen, die durch einen oder mehrere Reste R³ substituiert sein kann, oder eine Kombination aus zwei, drei, vier oder fünf dieser Systeme; dabei können auch zwei oder mehrere benachbarte Substituenten R¹ miteinander ein mono- oder polycyclisches, aliphatisches Ringsystem bilden;
- R²: ist bei jedem Auftreten gleich oder verschieden eine geradkettige Alkylgruppe mit 1 bis 40 C-Atomen oder eine verzweigte oder cyclische Alkylgruppe mit 3 bis 40 C-Atomen, wobei jeweils eine oder mehrere nicht benachbarte CH₂-Gruppen, die nicht direkt an das Silicium binden, durch -R³C=CR³-, -C≡C-, Si(R³)₂, Ge(R³)₂, Sn(R³)₂, C=O, C=S, C=Se, C=NR³, -O-, -S-, -N(R³)- oder -CONR³-ersetzt sein können und wobei jeweils ein oder mehrere H-Atome durch F, Cl, Br, I, CN oder NO₂ ersetzt sein können, welche auch durch eine Aryl- oder Heteroarylgruppe mit 5 bis 24 aromatischen Ringatomen, die mit einem oder mehreren Resten R³ substituiert sein kann, oder durch eine Aryloxy- oder Heteroaryloxygruppe mit 5 bis 24 aromatischen Ringatomen, die durch einen oder mehrere Reste R³ substituiert sein kann, substituiert sein kann; dabei können auch zwei oder mehrere Substituenten R² miteinander ein mono- oder polycyclisches Ringsystem bilden;
- R³: ist bei jedem Auftreten gleich oder verschieden H oder ein Kohlenwasserstoffrest mit 1 bis 20 C-Atomen, welcher aliphatisch oder aromatisch oder eine Kombination aus aliphatisch und aromatisch sein kann und welcher auch durch F substituiert sein kann; dabei können auch zwei oder mehrere Reste R³ miteinander ein mono- oder polycyclisches, aliphatisches oder aromatisches Ringsystem bilden;
- n: ist gleich oder verschieden bei jedem Auftreten 0, 1, 2, 3 oder 4;
- m: ist 0, 1, 2, 3, 4 oder 5;
dadurch gekennzeichnet, dass mindestens ein Rest R¹ im Molekül anwesend ist, welcher eine Gruppe Si(R²)₃ darstellt.

Unter einer Arylgruppe bzw. einer Heteroarylgruppe im Sinne dieser Erfindung wird eine aromatische Gruppe bzw. heteroaromatische Gruppe mit einem gemeinsamen aromatischen π-Elektronensystem verstanden. Dies kann im Sinne dieser Erfindung ein einfacher Homo- oder Heterocyclus sein, beispielsweise Benzol, Pyridin, Thiophen, etc., oder es kann eine kondensierte Aryl- oder Heteroarylgruppe sein, in der mindestens zwei aromatische oder heteroaromatische Ringe, beispielsweise Benzolringe, miteinander "verschmolzen", d. h. durch Anellierung einander ankondensiert sind, also mindestens eine gemeinsame Kante und dadurch auch ein gemeinsames aromatisches π-Elektronensystem aufweisen. Diese Aryl- oder Heteroarylgruppen können substituiert oder unsubstituiert sein; ebenso können gegebenenfalls vorhandene Substituenten weitere Ringsysteme bilden. So sind beispielsweise Systeme wie Naphthalin, Anthracen, Phenanthren, Pyren, etc. als Arylgruppen und Chinolin, Acridin, Benzothiophen, Carbazol, etc. als Heteroarylgruppen im Sinne dieser Erfindung zu sehen, während beispielsweise Biphenyl, Fluoren, Spirobifluoren, etc. keine Arylgruppen darstellen, da es sich hierbei um separate aromatische Elektronensysteme handelt.

Ein aromatisches Ringsystem im Sinne dieser Erfindung enthält 6 bis 40 C-Atome im Ringsystem. Ein heteroaromatisches Ringsystem im Sinne dieser Erfindung enthält 2 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nicht-aromatische Einheit (weniger als 10 % der von H verschiedenen Atome, bevorzugt weniger als 5 % der von H verschiedenen Atome), wie z. B. ein sp³-hybridisiertes C-, N- oder O-Atom, unterbrochen sein können. So sollen beispielsweise auch Systeme wie 9,9'-Spirobifluoren, Fluoren, 9,9-Diarylfluoren, Triarylamin, Diarylether, etc. als aromatische Ringsysteme im Sinne dieser Erfindung verstanden werden. Dabei kann ein Teil des aromatischen oder heteroaromatischen Ringsystems auch eine kondensierte Gruppe sein.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 1 bis 30 aromatischen Ringatomen, welches noch jeweils mit den oben genannten Resten R¹ bzw. R² substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Tetracen, Pentacen, Benzpyren, Biphenyl, Biphenylen, Terphenyl, Terphenylen, Fluoren, Spirobifluoren, Truxen, Isotruxen, Dihydrophenanthren, Dihydropyren, Tetrahydropyren, cis- oder trans-Indenofluoren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind Verbindungen der Formel (1), in denen das Symbol Ar für eine 1-Naphthylgruppe, eine 9-Anthrylgruppe, eine 1-, 4-, 5- oder 8-Isochinolinylgruppe oder eine 4- oder 5-Chinolinylgruppe steht. Besonders bevorzugt sind Verbindungen der Formel (1), in denen das Symbol Ar für eine 1-Naphthylgruppe oder eine 9-Anthrylgruppe steht. Ganz besonders bevorzugt sind die Verbindungen der Formel (1 a) bis (1d), 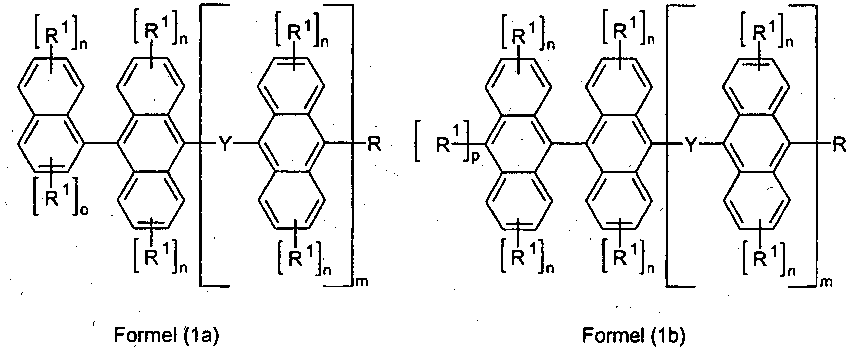 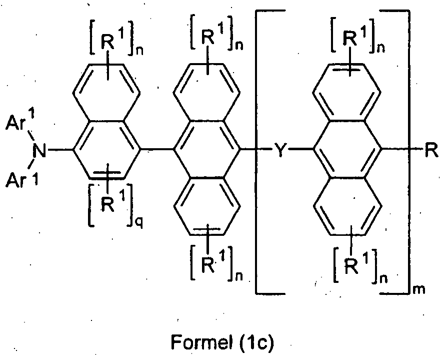 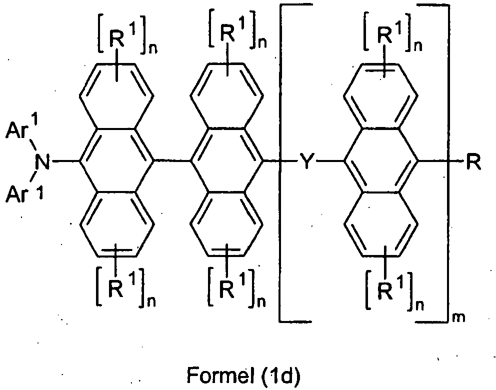 wobei R, Ar¹, R¹, Y, m und n die oben definierte Bedeutung haben, wobei die beiden Reste Ar¹ auch durch eine Einfachbindung oder eine Gruppe O, S, N(R¹) oder C(R¹)₂ miteinander verbunden sein können, und weiterhin gilt:
- o: ist 0, 1, 2 oder 3;
- p: ist 0 oder 1;
- q: ist 0, 1 oder 2;
dadurch gekennzeichnet, dass mindestens ein Rest R¹ anwesend ist, der für eine Gruppe Si(R²)₃ steht.

In Verbindungen gemäß Formel (1b) ist der Index p bevorzugt 1, d. h. an die Anthrylgruppe ist bevorzugt in 10-Position ein weiterer Substituent ungleich Wasserstoff gebunden.

Bevorzugt sind weiterhin Verbindungen der Formel (1) bzw. (1a) bis (1d), in denen das Symbol R für ein aromatisches oder heteroaromatisches Ringsystem mit 6 bis 24 aromatischen Ringatomen steht, welches mit einem oder mehreren Resten R¹ substituiert sein kann, oder in denen das Symbol R für eine Gruppe der Formel (2a) oder (2b) steht, 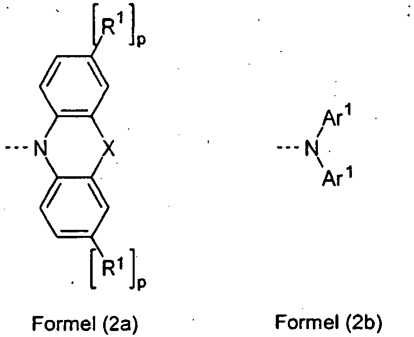 wobei R¹ und p die oben aufgeführte Bedeutung haben und weiterhin gilt:
- X: steht für eine Einfachbindung, O, S, N(R¹) oder C(R¹)₂;
- Ar¹: ist gleich oder verschieden bei jedem Auftreten eine Aryl- oder Heteroarylgruppe mit 5 bis 20 aromatischen Ringatomen, welche mit einem oder mehreren Resten R¹ substituiert sein kann, bevorzugt eine Aryl- oder Heteroarylgruppe mit 6 bis 14 aromatischen Ringatomen, welche mit einem oder mehreren Resten R¹ substituiert sein kann, besonders bevorzugt Phenyl, 1-Naphthyl oder 2-Naphthyl, welches jeweils mit einem oder mehreren Resten R¹ substituiert sein kann.

Wenn ein Substituent an der Gruppe Ar für eine Gruppe N(Ar¹)₂ steht, so ist auch dieser Substituent bevorzugt aus den oben aufgeführten Formeln (2a) und (2b) gewählt.

Wenn das Symbol R für ein aromatisches oder heteroaromatisches Ringsystem steht, so steht es bevorzugt für ein aromatisches oder heteroaromatisches Ringsystem mit 9 bis 24 aromatischen Ringatomen, welches durch einen oder mehrere Reste R¹ substituiert sein kann. Besonders bevorzugt sind Verbindungen der Formel (1), in denen das Symbol R für eine kondensierte Aryl- oder Heteroarylgruppe mit 10 bis 16 aromatischen Ringatomen oder für eine aromatische, gegebenenfalls überbrückte, Biarylgruppe steht, die jeweils mit einem oder mehreren Resten R¹ substituiert sein können. Ganz besonders bevorzugt sind Verbindungen der Formel (1), in denen das Symbol R, wenn er für ein aromatisches oder heteroaromatisches Ringsystem steht, gleich oder verschieden bei jedem Auftreten, für eine 1-Naphthyl-, 2-Naphthyl-, 9-Anthryl-, 2-Phenanthrenyl-, 9-Phenanthrenyl-, Chinolinyl-, Isochinolinyl-, ortho-, meta- oder para-Biphenyl-, 2-Fluorenyl- oder 2-Spirobifluorenylgruppe steht, die jeweils mit einem oder mehreren Resten R¹ substituiert sein kann, insbesondere für 1-Naphthyl, welches mit einem oder mehreren Resten R¹ substituiert sein kann.

Bevorzugt sind weiterhin Verbindungen gemäß Formel (1) bzw. (1 a) bis (1d), die, wenn die Gruppe R für ein aromatisches oder heteroaromatisches Ringsystem steht, gehinderte Rotation um die Anthracen-R-Bindung aufweisen. Unter gehinderter Rotation im Sinne dieser Erfindung wird eine Rotationsbarriere von mindestens 80 kJ/mol, bevorzugt mindestens 100 kJ/mol, besonders bevorzugt mindestens 120 kJ/mol bei Raumtemperatur verstanden. Diese Rotationsbarriere lässt sich experimentell durch temperaturabhängige NMR-Messungen bestimmen. Wenn die Verbindung der Formel (1) bzw. (1a) bzw. (1b) Atropisomerie um eine oder um mehrere Bindungen zeigt, so sind jeweils auch OLEDs enthaltend die entsprechenden isolierten oder angereicherten Atropisomere Gegenstand der Erfindung. Dies bezieht sich sowohl auf Enantiomere wie auch auf Diastereomere. Gehinderte Rotation um die Anthracen-R-Bindung wird erreicht, wenn die Gruppe R mindestens einen organischen Substituenten in ortho-Position aufweist und/oder wenn es sich bei der Gruppe R beispielsweise um eine 1-Naphthylgruppe handelt, die peri-Wasserstoffatome aufweist.

Es sind sowohl Verbindungen gemäß Formel (1) erfindungsgemäß, in denen die beiden Gruppen Ar und R gleich gewählt sind, wie auch Verbindungen gemäß Formel (1), in denen die Gruppen Ar und R unterschiedlich sind.

Bevorzugt sind weiterhin Verbindungen gemäß Formel (1) bzw. (1 a) bis (1d), in denen das Symbol R¹, gleich oder verschieden bei jedem Auftreten, für Si(R²)₃, F, eine geradkettige Alkyl- oder Alkoxygruppe mit 1 bis 6 C-Atomen oder eine verzweigte oder cyclische Alkyl- oder Alkoxygruppe mit 3 bis 10 C-Atomen, wobei jeweils ein oder mehrere CH₂-Gruppen durch -R³C=CR³-, Si(R³)₂, -O-, -S- oder -N(R³)- ersetzt sein können und wobei jeweils ein oder mehrere H-Atome durch F ersetzt sein können, oder eine Aryl- oder Heteroarylgruppe mit 5 bis 14 aromatischen Ringatomen, die mit einem oder mehreren Resten R³ substituiert sein kann, oder eine Kombination aus zwei oder drei dieser Systeme steht; dabei können auch zwei oder mehrere Reste R¹ miteinander ein mono- oder polycyclisches, aliphatisches Ringsystem bilden. Besonders bevorzugte Reste R¹ sind ausgewählt aus der Gruppe bestehend aus Si(R²)₃, F, geradkettigen Alkylgruppen mit 1 bis 4 C-Atomen oder verzweigten Alkylgruppen mit 3 bis 5 C-Atomen, wobei jeweils ein oder mehrere H-Atome durch F ersetzt sein können, oder Aryl- oder Heteroarylgruppen mit 6 bis 10 aromatischen Ringatomen oder eine Kombination aus zwei dieser Systeme; dabei können auch zwei oder mehrere benachbarte Reste R¹ miteinander ein mono- oder polycyclisches, aliphatisches Ringsystem bilden.

Bevorzugt sind weiterhin Verbindungen gemäß Formel (1) bzw. (1 a) bis (1d), in denen das Symbol Y, gleich oder verschieden bei jedem Auftreten, eine lineare Alkylengruppe mit 1 bis 10 C-Atomen oder eine verzweigte oder cyclische Alkylen- oder Alkylidengruppe mit 3 bis 10 C-Atomen, eine bivalente aromatische Gruppe mit 6 bis 25 C-Atomen, C=O, -O-, -S- oder eine Gruppe der Formel -N(R¹)- oder -P(=O)R¹- oder eine Einfachbindung darstellt. Besonders bevorzugt sind Verbindungen, in denen das Symbol Y, gleich oder verschieden bei jedem Auftreten, für eine lineare Alkylengruppe mit 1 bis 4 C-Atomen, für eine verzweigte Alkylen- oder Alkylidengruppe mit 3 bis 5 C-Atomen, für eine cyclische Alkylengruppe mit 3 bis 10 C-Atomen, für eine bivalente aromatische Gruppe, ausgewählt aus Gruppen, die sich ableiten von Benzol, Naphthalin, Biphenyl oder Terphenyl, oder C=O, -N(R³)- oder -P(=O)R³- oder eine Einfachbindung darstellt.

Bevorzugt sind weiterhin Verbindungen gemäß Formel (1) bzw. (1a) bis (1d), in denen der Index m für 0, 1 oder 2 steht, besonders bevorzugt für 0 oder 1.

Bevorzugt sind weiterhin Verbindungen gemäß Formel (1) bzw. (1 a) bis (1d), in denen der Index n für 0, 1 oder 2 steht, besonders bevorzugt für 0 oder 1, wobei mindestens ein Rest R¹ im Molekül anwesend ist, der für Si(R²)₃ steht. Bevorzugt enthält die Verbindung gemäß Formel (1) bzw. (1a) bis (1d) eine, zwei, drei oder vier Gruppen der Formel Si(R²)₃, besonders bevorzugt eine oder zwei Gruppen der Formel Si(R²)₃.

Die Gruppen der Formel Si(R²)₃ können in verschiedenen Positionen des Moleküls gebunden sein. In einer bevorzugten Ausführungsform der Erfindung ist mindestens eine Gruppe der Formel Si(R²)₃ an die zentrale Anthraceneinheit gebunden, bevorzugt in 2-Position und/oder in 6-Position des Anthracens. In einer weiteren bevorzugten Ausführungsform der Erfindung ist mindestens eine Gruppe der Formel Si(R²)₃ an die Gruppe Ar gebunden. Wenn die Gruppe Ar eine 1-Naphthylgruppe darstellt, ist die Gruppe der Formel Si(R²)₃ bevorzugt in der 4-Position der Naphthylgruppe gebunden. Wenn die Gruppe Ar eine 9-Anthrylgruppe darstellt, ist die Gruppe der Formel Si(R²)₃ bevorzugt in der 10-Position der Anthracengruppe gebunden oder in der 2-Position bzw. in der 2,6-Position, falls in der 10-Position ein anderer Rest R¹ gebunden ist. In nochmals einer weiteren bevorzugten Ausführungsform der Erfindung ist mindestens eine Gruppe der Formel Si(R²)₃ an die Gruppe R gebunden. Wenn die Gruppe R eine Arylgruppe oder eine Heteroarylgruppe darstellt, ist die Gruppe der Formel Si(R²)₃ bevorzugt in der para-Position an der Arylgruppe gebunden. Wenn die Gruppe R eine Gruppe der Formel N(Ar¹)₂ darstellt, ist die Gruppe der Formel Si(R²)₃ bevorzugt an einer oder beiden Gruppen Ar¹ in der Position para zum Stickstoff gebunden.

Bevorzugte Reste R² an der Silylgruppe sind gewählt aus geradkettigen Alkylgruppen mit 1 bis 10 C-Atomen oder verzweigten oder cyclischen Alkylgruppen mit 3 bis 10 C-Atomen, wobei jeweils eine oder mehrere nicht benachbarte CH₂-Gruppen, die nicht direkt an das Silicium binden, durch O ersetzt sein können und wobei jeweils ein oder mehrere H-Atome durch F ersetzt sein können; dabei können auch zwei oder mehrere Substituenten R² miteinander ein mono- oder polycyclisches Ringsystem bilden. Besonders bevorzugte Reste R² an der Silylgruppe sind gewählt aus geradkettigen Alkylgruppen mit 1 bis 4 C-Atomen oder verzweigten Alkylgruppen mit 3 oder 4 C-Atomen, wobei jeweils ein oder mehrere H-Atome durch F ersetzt sein können. Ganz besonders bevorzugte Gruppen R² sind Methyl, CF₃, Ethyl, iso-Propyl und tert-Butyl. Ganz besonders bevorzugte Gruppen Si(R²)₃ sind Si(Me)₃, Si(Me)₂(t-Bu), SiMe(t-Bu)₂ und Si(i=Pr)₃.

Bevorzugt sind weiterhin Verbindungen gemäß Formel (1), deren Molekulargewicht zwischen 400 und 1500 g/mol liegt, besonders bevorzugt zwischen 400 und 900 g/mol.

Es stehen verschiedene Verfahren zur Herstellung der erfindungsgemäßen Verbindungen zur Verfügung. Soll die Silylgruppe am Anthracen eingeführt werden, so eignet sich als Ausgangsverbindung 2-Bromanthrachinon oder 2,6-Dibromanthrachinon bzw. das entsprechende Chloranthrachinönderivat. Dieses kann jeweils mit einem reaktiven Organometallreagenz, beispielsweise einem Arylgrignardreagenz oder Aryllithiumreagenz umgesetzt und in einem Folgeschritt, beispielsweise mit Zinn(II)-chlorid reduziert werden. Dadurch erhält man 9,10-Diarylanthracenderivate, welche noch in 2- bzw. 2,6-Position Brom oder Chlor tragen. Die Metallierung, beispielsweise Lithiierung, und Umsetzung mit einem Silylhalogenid, beispielsweise Trialkylsilylchlorid, führt zur entsprechenden silylierten Zielverbindung.

Soll die Silylgruppe nicht am zentralen Anthracen, sondern an den aromatischen Gruppen Ar bzw. R eingeführt werden, so bietet es sich auch an, diese in einem ersten Schritt einzuführen und dann erst in einem weiteren Schritt die aromatische Gruppe mit dem Anthracen zu kuppeln. So kann ein Dibromaromat selektiv monolithiiert und mit einem Silylhalogenid zu einem Brom-silylaromaten umgesetzt werden. Dieser kann wiederum durch Lithiierung zur entsprechenden Boronsäure bzw. einem Boronsäurederivat umgesetzt werden, welche dann mit Dibromanthracen oder einem anderen Anthracenderivat in einer Suzuki-Kupplung unter Palladiumkatalyse gekuppelt werden kann. Analog dazu kommen weitere Kupplungsreaktionen zwischen dem Aromaten und dem Anthracen in Frage, beispielsweise die Kupplung nach Stille. Wenn die Gruppe R eine Diarylaminogruppe darstellt, eignet sich eine Kupplung nach Hartwig-Buchwald.

Ein weiterer Gegenstand dieser Erfindung ist ein Verfahren zur Herstellung der erfindungsgemäßen Verbindungen nach Formel (1), welche eine oder mehrere Gruppen Si(R²)₃ an der Gruppe Ar bzw. R tragen, durch Kupplung einer funktionalisierten Gruppe Ar bzw. R, welche durch eine oder mehrere Gruppen Si(R²)₃ substituiert ist, mit einem entsprechenden Anthracenderivat. Die Kupplung ist bevorzugt eine übergangsmetallkatalysierte Kupplungsreaktion, insbesondere eine Suzuki-Kupplung, eine Stille-Kupplung oder eine Hartwig-Buchwald-Kupplung. Dabei kann die Funktionalisierung der Gruppe Ar bzw. R ein Boronsäurederivat für den Einsatz in einer Suzuki-Kupplung sein. Die Gruppe kann ein Trialkylzinnderivat für den Einsatz in einer Stille-Kupplung sein. Sie kann eine N-H-Funktionalität für den Einsatz in einer Hartwig-Buchwald-Kupplung sein. Weiterhin kann sie eine bromierte Verbindung sein, wenn das Anthracen entsprechend durch ein Boronsäurederivat oder durch ein Trialkylzinnderivat substituiert ist. Dabei ist überraschend, dass die Silylgruppe an der Gruppe Ar bzw. R unbeschadet in der metallkatalysierten Kupplungsreaktion eingesetzt werden kann und dass diese nicht zu Nebenreaktionen führt.

Beispiele für bevorzugte Verbindungen gemäß Formel (1) sind die im Folgenden abgebildeten Verbindungen (A1) bis (A68).

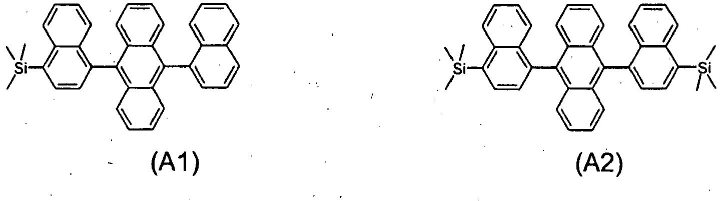

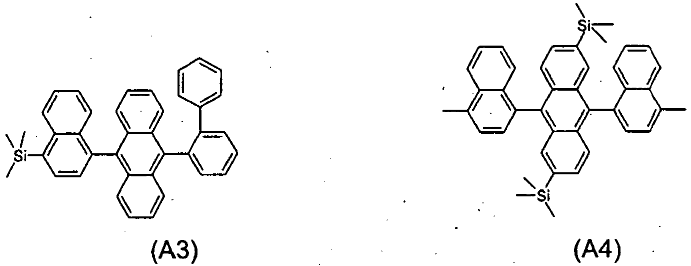

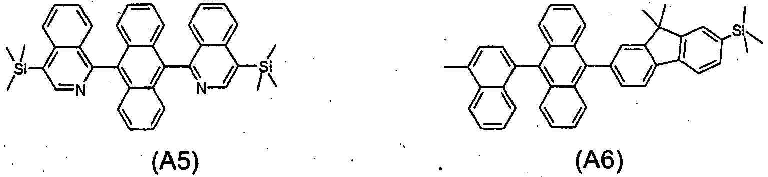

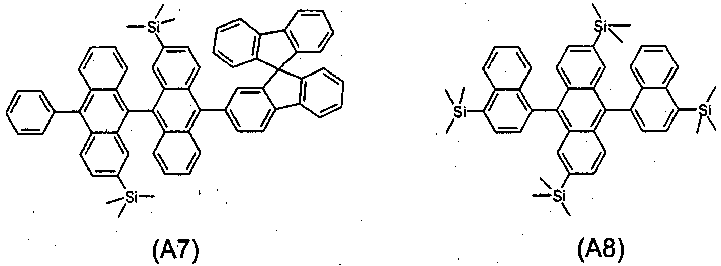

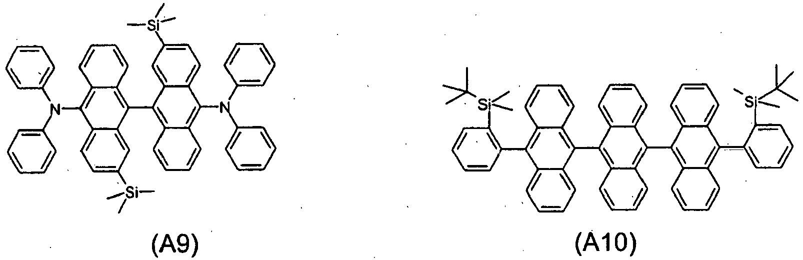

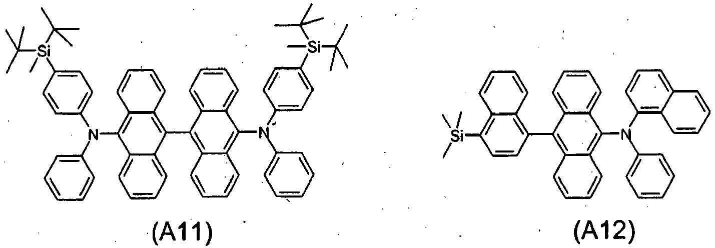

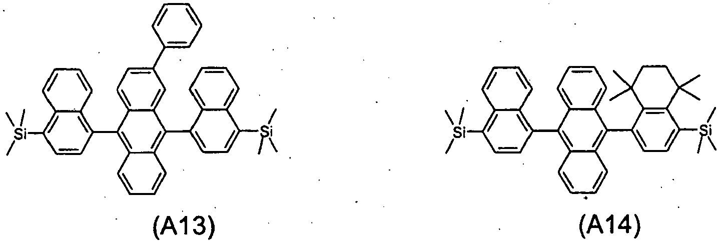

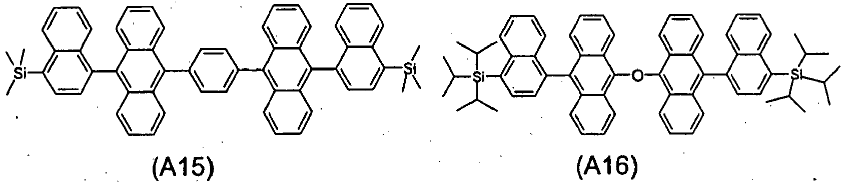

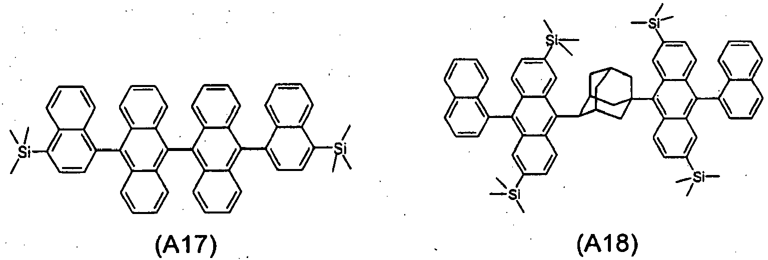

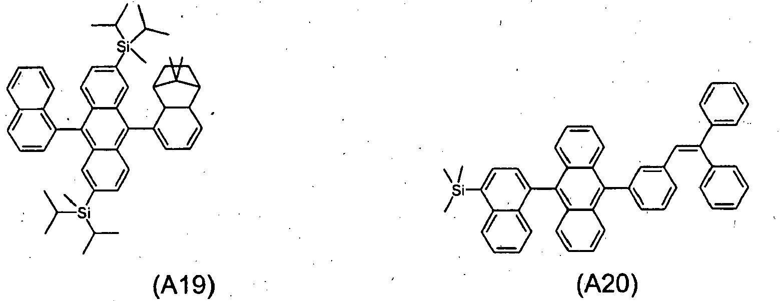

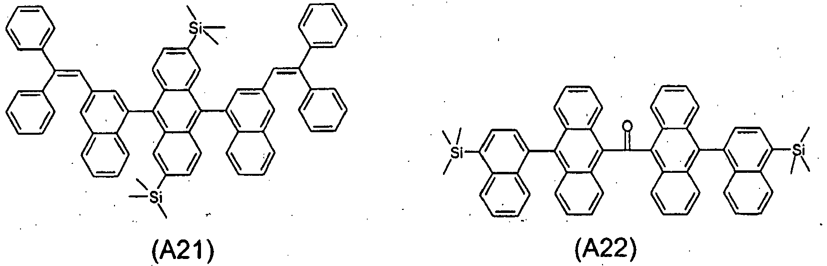

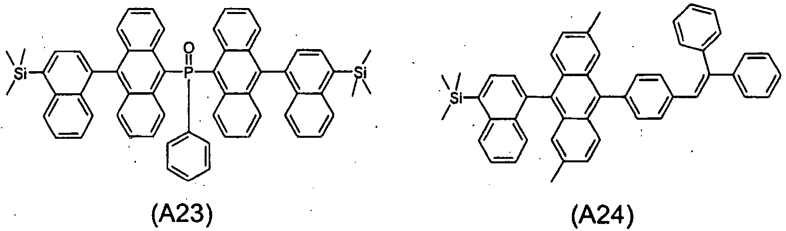

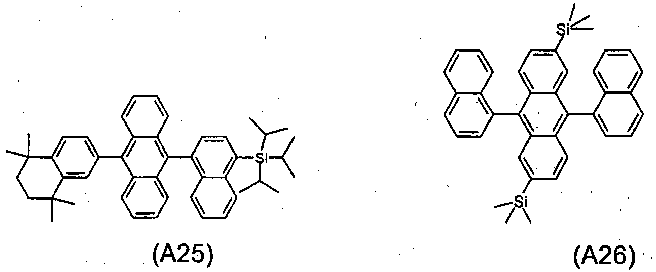

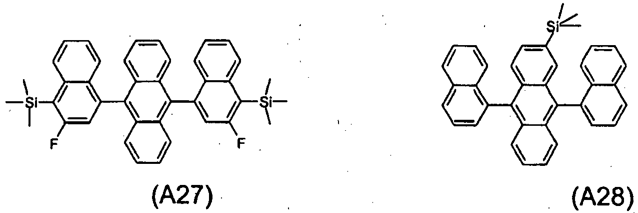

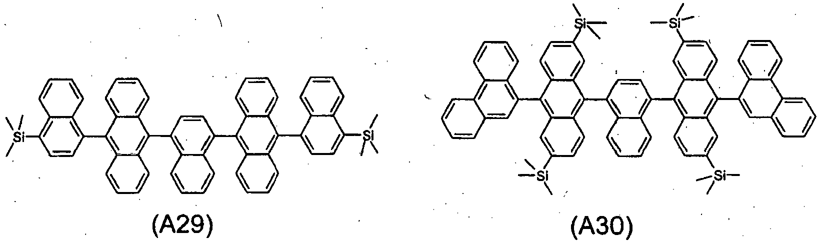

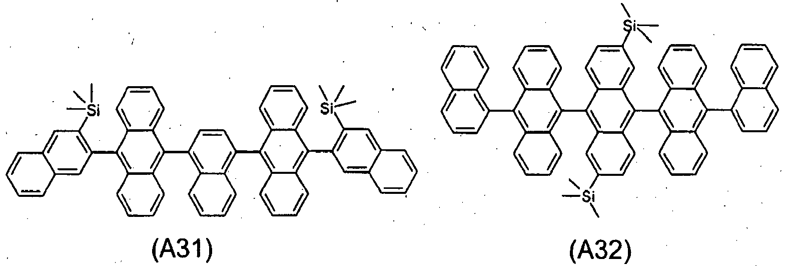

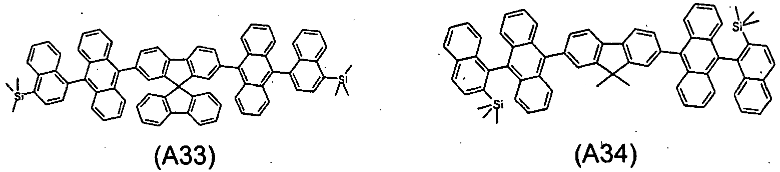

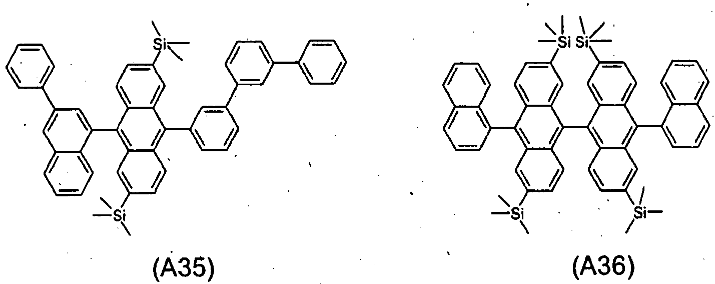

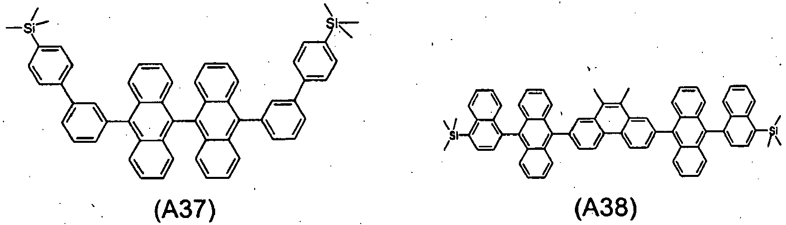

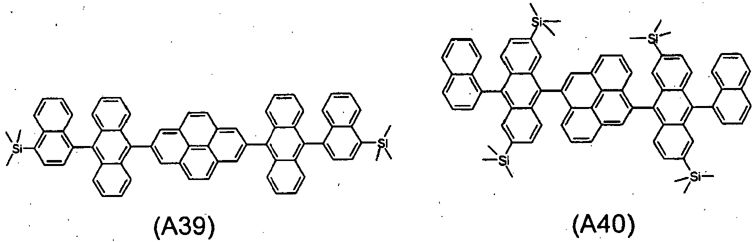

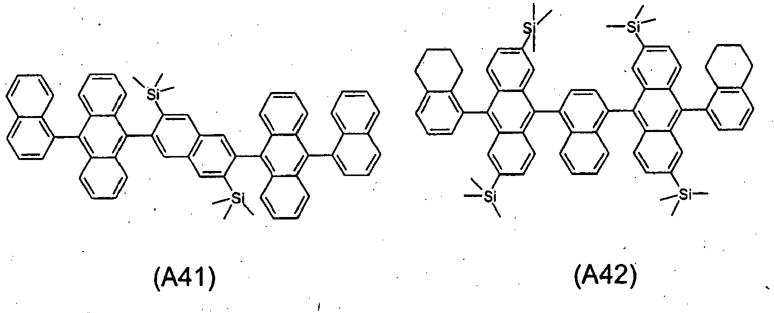

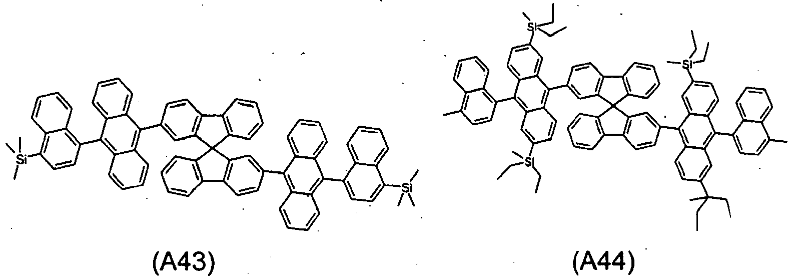

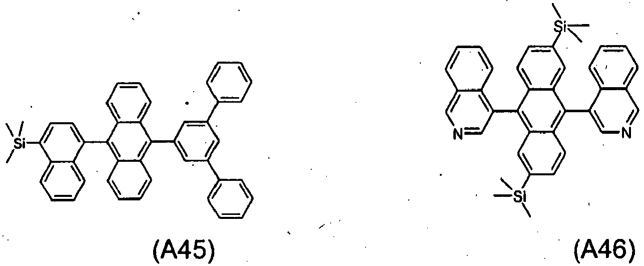

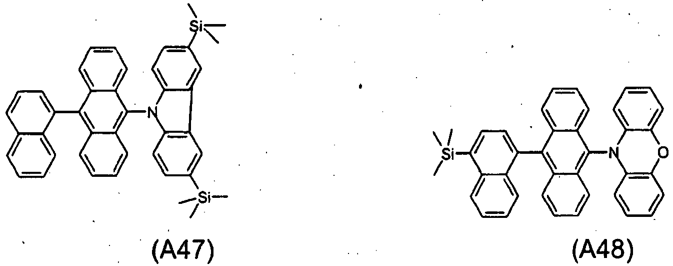

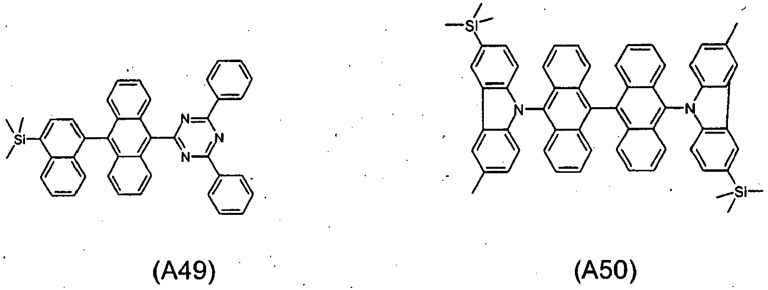

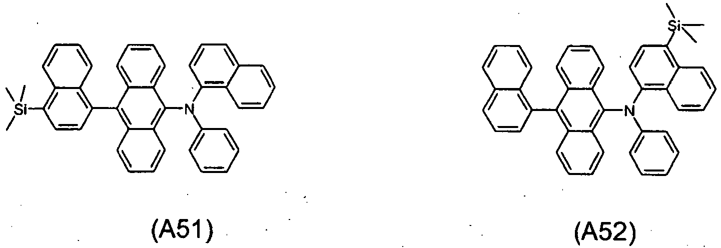

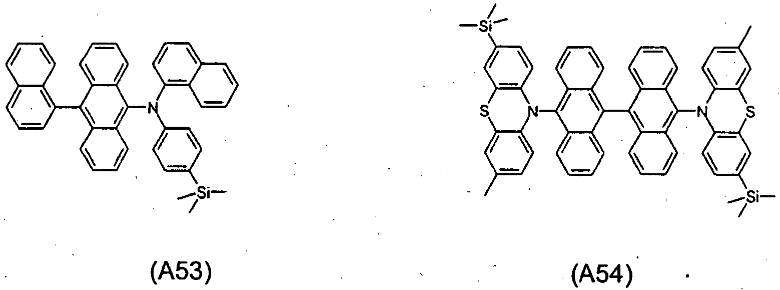

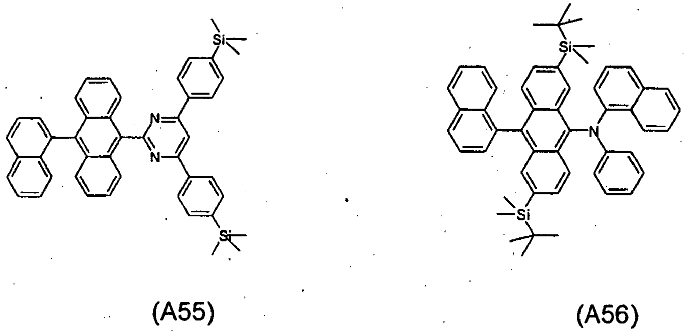

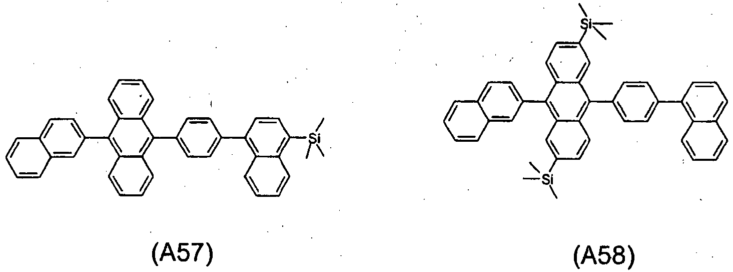

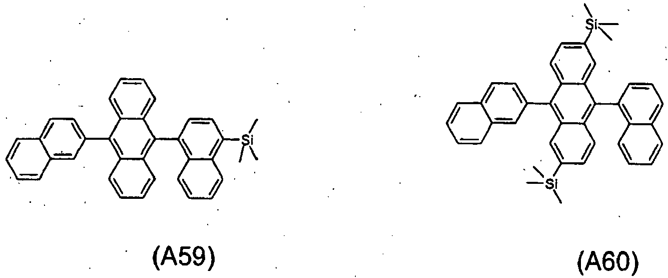

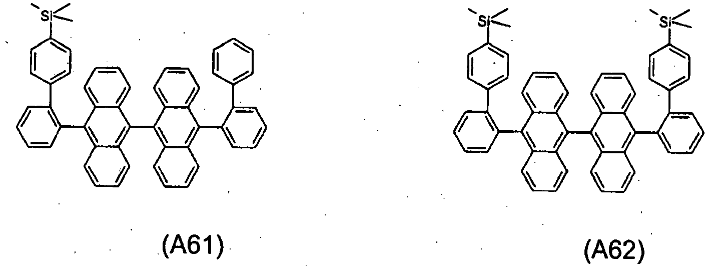

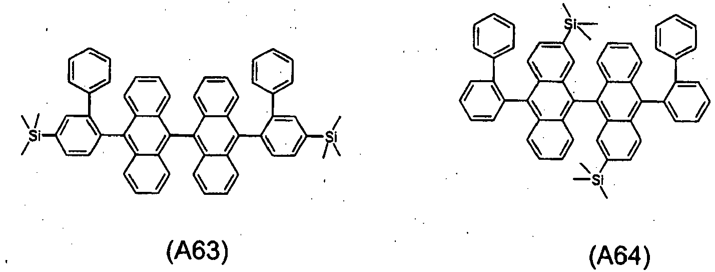

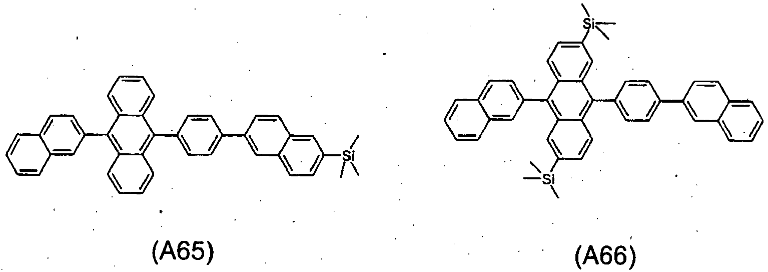

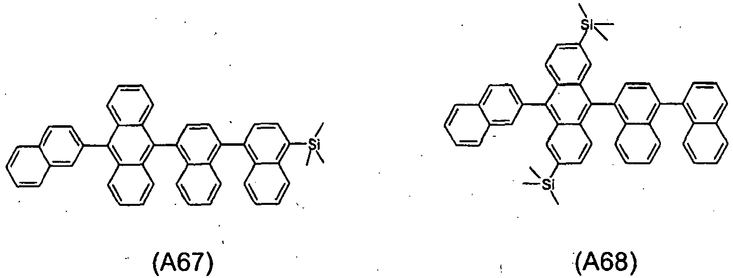

Die folgende Tabelle 1 gibt weitere bevorzugte Strukturen gemäß Formel (1) an. Dabei sind ebenso die Strukturen bevorzugt, die statt Gruppen der Formel Si(Me)₃ Gruppen der Formel SiMe₂(t-Bu), SiMe(t-Bu)2 oder Si(i-Pr)₃ enthalten. Die in der Tabelle verwendeten Symbole und Indizes beziehen sich auf die im Folgenden abgebildete Formel (3):

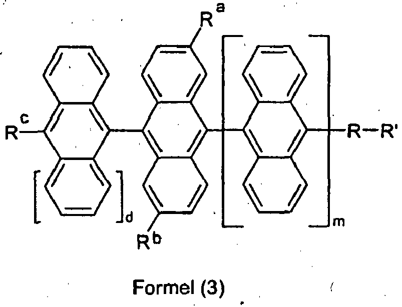

Dabei bedeutet d = 0, dass es sich bei der entsprechenden Gruppe um eine 1-Naphthylgruppe handelt. Weiterhin steht in Tabelle 1 die Abkürzung N(Ph)₂ für eine Diphenylaminogruppe, N(p-Tol)₂ für eine Bis(para-tolyl)-aminogruppe und N(Ph)(1-Naph) für eine N-Phenyl-N-(1-naphthyl)amino-gruppe.

**Tabelle 1: Bevorzugte Strukturen der Formel (3)**

| Nr. | R | Ra | Rb | Rc | d | m | R' |
|---|---|---|---|---|---|---|---|
| 1 | Phenyl | H | H | Si(Me)3 | 0 | 0 | H |
| 2 | Phenyl | H | H | Si(Me)3 | 0 | 1 | H |
| 3 | Phenyl | H | H | Si(Me)3 | 1 | 0 | H |
| 4 | Phenyl | H | H | Si(Me)3 | 1 | 1 | H |
| 5 | Phenyl | H | Si(Me)3 | H | 0 | 0 | H |
| 6 | Phenyl | H | Si(Me)3 | H | 0 | 1 | H |
| 7 | Phenyl | H | Si(Me)3 | H | 1 | 0 | H |
| 8 | Phenyl | H | Si(Me)3 | H | 1 | 1 | H |
| 9 | Phenyl | H | Si(Me)3 | Si(Me)3 | 0 | 0 | H |
| 10 | Phenyl | H | Si(Me)3 | Si(Me)3 | 0 | 1 | H |
| 11 | Phenyl | H | Si(Me)3 | Si(Me)3 | 1 | 0 | H |
| 12 | Phenyl | H | Si(Me)3 | Si(Me)3 | 1 | 1 | H |
| 13 | Phenyl | H | Si(Me)3 | Methyl | 0 | 0 | H |
| 14 | Phenyl | H | Si(Me)3 | Methyl | 0 | 1 | H |
| 15 | Phenyl | H | Si(Me)3 | Methyl | 1 | 0 | H |
| 16 | Phenyl | H | Si(Me)3 | Methyl | 1 | 1 | H |
| 17 | Phenyl | H | Si(Me)3 | F | 0 | 0 | H |
| 18 | Phenyl | H | Si(Me)3 | F | 0 | 1 | H |
| 19 | Phenyl | H | Si(Me)3 | F | 1 | 0 | H |
| 20 | Phenyl | H | Si(Me)3 | F | 1 | 1 | H |
| 21 | Phenyl | H | Si(Me)3 | Phenyl | 0 | 0 | H |
| 22 | Phenyl | H | Si(Me)3 | Phenyl | 0 | 1 | H |
| 23 | Phenyl | H | Si(Me)3 | Phenyl | 1 | 0 | H |
| 24 | Phenyl | H | Si(Me)3 | Phenyl | 1 | 1 | H |
| 25 | Phenyl | Si(Me)3 | H | H | 0 | 0 | H |
| 26 | Phenyl | Si(Me)3 | H | H | 0 | 1 | H |
| 27 | Phenyl | Si(Me)3 | H | H | 1 | 0 | H |
| 28 | Phenyl | Si(Me)3 | H | H | 1 | 1 | H |
| 29 | Phenyl | Si(Me)3 | H | Si(Me)3 | 0 | 0 | H |
| 30 | Phenyl | Si(Me)3 | H | Si(Me)3 | 0 | 1 | H |
| 31 | Phenyl | Si(Me)3 | H | Si(Me)3 | 1 | 0 | H |
| 32 | Phenyl | Si(Me)3 | H | Si(Me)3 | 1 | 1 | H |
| 33 | Phenyl | Si(Me)3 | H | Methyl | 0 | 0 | H |
| 34 | Phenyl | Si(Me)3 | H | Methyl | 0 | 1 | H |
| 35 | Phenyl | Si(Me)3 | H | Methyl | 1 | 0 | H |
| 36 | Phenyl | Si(Me)3 | H | Methyl | 1 | 1 | H |
| 37 | Phenyl | Si(Me)3 | H | F | 0 | 0 | H |
| 38 | Phenyl | Si(Me)3 | H | F | 0 | 1 | H |
| 39 | Phenyl | Si(Me)3 | H | F | 1 | 0 | H |
| 40 | Phenyl | Si(Me)3 | H | F | 1 | 1 | H |
| 41 | Phenyl | Si(Me)3 | H | Phenyl | 0 | 0 | H |
| 42 | Phenyl | Si(Me)3 | H | Phenyl | 0 | 1 | H |
| 43 | Phenyl | Si(Me)3 | H | Phenyl | 1 | 0 | H |
| 44 | Phenyl | Si(Me)3 | H | Phenyl | 1 | 1 | H |
| 45 | Phenyl | Si(Me)3 | Si(Me)3 | H | 0 | 0 | H |
| 46 | Phenyl | Si(Me)3 | Si(Me)3 | H | 0 | 1 | H |
| 47 | Phenyl | Si(Me)3 | Si(Me)3 | H | 1 | 0 | H |
| 48 | Phenyl | Si(Me)3 | Si(Me)3 | H | 1 | 1 | H |
| 49 | Phenyl | Si(Me)3 | Si(Me)3 | Si(Me)3 | 0 | 0 | H |
| 50 | Phenyl | Si(Me)3 | Si(Me)3 | Si(Me)3 | 0 | 1 | H |
| 51 | Phenyl | Si(Me)3 | Si(Me)3 | Si(Me)3 | 1 | 0 | H |
| 52 | Phenyl | Si(Me)3 | Si(Me)3 | Si(Me)3 | 1 | 1 | H |
| 53 | Phenyl | Si(Me)3 | Si(Me)3 | Methyl | 0 | 0 | H |
| 54 | Phenyl | Si(Me)3 | Si(Me)3 | Methyl | 0 | 1 | H |
| 55 | Phenyl | Si(Me)3 | Si(Me)3 | Methyl | 1 | 0 | H |
| 56 | Phenyl | Si(Me)3 | Si(Me)3 | Methyl | 1 | 1 | H |
| 57 | Phenyl | Si(Me)3 | Si(Me)3 | F | 0 | 0 | H |
| 58 | Phenyl | Si(Me)3 | Si(Me)3 | F | 0 | 1 | H |
| 59 | Phenyl | Si(Me)3 | Si(Me)3 | F | 1 | 0 | H |
| 60 | Phenyl | Si(Me)3 | Si(Me)3 | F | 1 | 1 | H |
| 61 | Phenyl | Si(Me)3 | Si(Me)3 | Phenyl | 0 | 0 | H |
| 62 | Phenyl | Si(Me)3 | Si(Me)3 | Phenyl | 0 | 1 | H |
| 63 | Phenyl | Si(Me)3 | Si(Me)3 | Phenyl | 1 | 0 | H |
| 64 | Phenyl | Si(Me)3 | Si(Me)3 | Phenyl | 1 | 1 | H |
| 65 | Phenyl | H | H | H | 0 | 0 | Si(Me)3 |
| 66 | Phenyl | H | H | H | 0 | 1 | Si(Me)3 |
| 67 | Phenyl | H | H | H | 1 | 0 | Si(Me)3 |
| 68 | Phenyl | H | H | H | 1 | 1 | Si(Me)3 |
| 69 | Phenyl | H | H | Si(Me)3 | 0 | 0 | Si(Me)3 |
| 70 | Phenyl | H | H | Si(Me)3 | 0 | 1 | Si(Me)3 |
| 71 | Phenyl | H | H | Si(Me)3 | 1 | 0 | Si(Me)3 |
| 72 | Phenyl | H | H | Si(Me)3 | 1 | 1 | Si(Me)3 |
| 73 | Phenyl | H | H. | Methyl | 0 | 0 | Si(Me)3 |
| 74 | Phenyl | H | H | Methyl | 0 | 1 | Si(Me)3 |
| 75 | Phenyl | H | H | Methyl | 1 | 0 | Si(Me)3 |
| 76 | Phenyl | H | H | Methyl | 1 | 1 | Si(Me)3 |
| 77 | Phenyl | H | H | F | 0 | 0 | Si(Me)3 |
| 78 | Phenyl | H | H | F | 0 | 1 | Si(Me)3 |
| 79 | Phenyl | H | H | F | 1 | 0 | Si(Me)3 |
| 80 | Phenyl | H | H | F | 1 | 1 | Si(Me)3 |
| 81 | Phenyl | H | H | Phenyl | 0 | 0 | Si(Me)3 |
| 82 | Phenyl | H | H | Phenyl | 0 | 1 | Si(Me)3 |
| 83 | Phenyl | H | H | Phenyl | 1 | 0 | Si(Me)3 |
| 84 | Phenyl | H | H | Phenyl | 1 | 1 | Si(Me)3 |
| 85 | Phenyl | H | Si(Me)3 | H | 0 | 0 | Si(Me)3 |
| 86 | Phenyl | H | Si(Me)3 | H | 0 | 1 | Si(Me)3 |
| 87 | Phenyl | H | Si(Me)3 | H | 1 | 0 | Si(Me)3 |
| 88 | Phenyl | H | Si(Me)3 | H | 1 | 1 | Si(Me)3 |
| 89 | Phenyl | H | Si(Me)3 | Si(Me)3 | 0 | 0 | Si(Me)3 |
| 90 | Phenyl | H | Si(Me)3 | Si(Me)3 | 0 | 1 | Si(Me)3 |
| 91 | Phenyl | H | Si(Me)3 | Si(Me)3 | 1 | 0 | Si(Me)3 |
| 92 | Phenyl | H | Si(Me)3 | Si(Me)3 | 1 | 1 | Si(Me)3 |
| 93 | Phenyl | H | Si(Me)3 | Methyl | 0 | 0 | Si(Me)3 |
| 94 | Phenyl | H | Si(Me)3 | Methyl | 0 | 1 | Si(Me)3 |
| 95 | Phenyl | H | Si(Me)3 | Methyl | 1 | 0 | Si(Me)3 |
| 96 | Phenyl | H | Si(Me)3 | Methyl | 1 | 1 | Si(Me)3 |
| 97 | Phenyl | H | Si(Me)3 | F | 0 | 0 | Si(Me)3 |
| 98 | Phenyl | H | Si(Me)3 | F | 0 | 1 | Si(Me)3 |
| 99 | Phenyl | H | Si(Me)3 | F | 1 | 0 | Si(Me)3 |
| 100 | Phenyl | H | Si(Me)3 | F | 1 | 1 | Si(Me)3 |
| 101 | Phenyl | H | Si(Me)3 | Phenyl | 0 | 0 | Si(Me)3 |
| 102 | Phenyl | H | Si(Me)3 | Phenyl | 0 | 1 | Si(Me)3 |
| 103 | Phenyl | H | Si(Me)3 | Phenyl | 1 | 0 | Si(Me)3 |
| 104 | Phenyl | H | Si(Me)3 | Phenyl | 1 | 1 | Si(Me)3 |
| 105 | Phenyl | Si(Me)3 | H | H | 0 | 0 | Si(Me)3 |
| 106 | Phenyl | Si(Me)3 | H | H | 0 | 1 | Si(Me)3 |
| 107 | Phenyl | Si(Me)3 | H | H | 1 | 0 | Si(Me)3 |
| 108 | Phenyl | Si(Me)3 | H | H | 1 | 1 | Si(Me)3 |
| 109 | Phenyl | Si(Me)3 | H | Si(Me)3 | 0 | 0 | Si(Me)3 |
| 110 | Phenyl | Si(Me)3 | H | Si(Me)3 | 0 | 1 | Si(Me)3 |
| 111 | Phenyl | Si(Me)3 | H | Si(Me)3 | 1 | 0 | Si(Me)3 |
| 112 | Phenyl | Si(Me)3 | H | Si(Me)3 | 1 | 1 | Si(Me)3 |
| 113 | Phenyl | Si(Me)3 | H | Methyl | 0 | 0 | Si(Me)3 |
| 114 | Phenyl | Si(Me)3 | H | Methyl | 0 | 1 | Si(Me)3 |
| 115 | Phenyl | Si(Me)3 | H | Methyl | 1 | 0 | Si(Me)3 |
| 116 | Phenyl | Si(Me)3 | H | Methyl | 1 | 1 | Si(Me)3 |
| 117 | Phenyl | Si(Me)3 | H | F | 0 | 0 | Si(Me)3 |
| 118 | Phenyl | Si(Me)3 | H | F | 0 | 1 | Si(Me)3 |
| 119 | Phenyl | Si(Me)3 | H | F | 1 | 0 | Si(Me)3 |
| 120 | Phenyl | Si(Me)3 | H | F | 1 | 1 | Si(Me)3 |
| 121 | Phenyl | Si(Me)3 | H | Phenyl | 0 | 0 | Si(Me)3 |
| 122 | Phenyl | Si(Me)3 | H | Phenyl | 0 | 1 | Si(Me)3 |
| 123 | Phenyl | Si(Me)3 | H | Phenyl | 1 | 0 | Si(Me)3 |
| 124 | Phenyl | Si(Me)3 | H | Phenyl | 1 | 1 | Si(Me)3 |
| 125 | Phenyl | Si(Me)3 | Si(Me)3 | H | 0 | 0 | Si(Me)3 |
| 126 | Phenyl | Si(Me)3 | Si(Me)3 | H | 0 | 1 | Si(Me)3 |
| 127 | Phenyl | Si(Me)3 | Si(Me)3 | H | 1 | 0 | Si(Me)3 |
| 128 | Phenyl | Si(Me)3 | Si(Me)3 | H | 1 | 1 | Si(Me)3 |
| 129 | Phenyl | Si(Me)3 | Si(Me)3 | Si(Me)3 | 0 | 0 | Si(Me)3 |
| 130 | Phenyl | Si(Me)3 | Si(Me)3 | Si(Me)3 | 0 | 1 | Si(Me)3 |
| 131 | Phenyl | Si(Me)3 | Si(Me)3 | Si(Me)3 | 1 | 0 | Si(Me)3 |
| 132 | Phenyl | Si(Me)3 | Si(Me)3 | Si(Me)3 | 1 | 1 | Si(Me)3 |
| 133 | Phenyl | Si(Me)3 | Si(Me)3 | Methyl | 0 | 0 | Si(Me)3 |
| 134 | Phenyl | Si(Me)3 | Si(Me)3 | Methyl | 0 | 1 | Si(Me)3 |
| 135 | Phenyl | Si(Me)3 | Si(Me)3 | Methyl | 1 | 0 | Si(Me)3 |
| 136 | Phenyl | Si(Me)3 | Si(Me)3 | Methyl | 1 | 1 | Si(Me)3 |
| 137 | Phenyl | Si(Me)3 | Si(Me)3 | F | 0 | 0 | Si(Me)3 |
| 138 | Phenyl | Si(Me)3 | Si(Me)3 | F | 0 | 1 | Si(Me)3 |
| 139 | Phenyl | Si(Me)3 | Si(Me)3 | F | 1 | 0 | Si(Me)3 |
| 140 | Phenyl | Si(Me)3 | Si(Me)3 | F | 1 | 1 | Si(Me)3 |
| 141 | Phenyl | Si(Me)3 | Si(Me)3 | Phenyl | 0 | 0 | Si(Me)3 |
| 142 | Phenyl | Si(Me)3 | Si(Me)3 | Phenyl | 0 | 1 | Si(Me)3 |
| 143 | Phenyl | Si(Me)3 | Si(Me)3 | Phenyl | 1 | 0 | Si(Me)3 |
| 144 | Phenyl | Si(Me)3 | Si(Me)3 | Phenyl | 1 | 1 | Si(Me)3 |
| 145 | 1-Naphthyl | H | H | Si(Me)3 | 0 | 0 | H |
| 146 | 1-Naphthyl | H | H | Si(Me)3 | 0 | 1 | H |
| 147 | 1-Naphthyl | H | H | Si(Me)3 | 1 | 0 | H |
| 148 | 1-Naphthyl | H | H | Si(Me)3 | 1 | 1 | H |
| 149 | 1-Naphthyl | H | Si(Me)3 | H | 0 | 0 | H |
| 150 | 1-Naphthyl | H | Si(Me)3 | H | 0 | 1 | H |
| 151 | 1-Naphthyl | H | Si(Me)3 | H | 1 | 0 | H |
| 152 | 1-Naphthyl | H | Si(Me)3 | H | 1 | 1 | H |
| 153 | 1-Naphthyl | H | Si(Me)3 | Si(Me)3 | 0 | 0 | H |
| 154 | 1-Naphthyl | H | Si(Me)3 | Si(Me)3 | 0 | 1 | H |
| 155 | 1-Naphthyl | H | Si(Me)3 | Si(Me)3 | 1 | 0 | H |
| 156 | 1-Naphthyl | H | Si(Me)3 | Si(Me)3 | 1 | 1 | H |
| 157 | 1-Naphthyl | H | Si(Me)3 | Methyl | 0 | 0 | H |
| 158 | 1-Naphthyl | H | Si(Me)3 | Methyl | 0 | 1 | H |
| 159 | 1-Naphthyl | H | Si(Me)3 | Methyl | 1 | 0 | H |
| 160 | 1-Naphthyl | H | Si(Me)3 | Methyl | 1 | 1 | H |
| 161 | 1-Naphthyl | H | Si(Me)3 | F | 0 | 0 | H |
| 162 | 1-Naphthyl | H | Si(Me)3 | F | 0 | 1 | H |
| 163 | 1-Naphthyl | H | Si(Me)3 | F | 1 | 0 | H |
| 164 | 1-Naphthyl | H | Si(Me)3 | F | 1 | 1 | H |
| 165 | 1-Naphthyl | H | Si(Me)3 | Phenyl | 0 | 0 | H |
| 166 | 1-Naphthyl | H | Si(Me)3 | Phenyl | 0 | 1 | H |
| 167 | 1-Naphthyl | H | Si(Me)3 | Phenyl | 1 | 0 | H |
| 168 | 1-Naphthyl | H | Si(Me)3 | Phenyl | 1 | 1 | H |
| 169 | 1-Naphthyl | Si(Me)3 | H | H | 0 | 0 | H |
| 170 | 1-Naphthyl | Si(Me)3 | H | H | 0 | 1 | H |
| 171 | 1-Naphthyl | Si(Me)3 | H | H | 1 | 0 | H |
| 172 | 1-Naphthyl | Si(Me)3 | H | H | 1 | 1 | H |
| 173 | 1-Naphthyl | Si(Me)3 | H | Si(Me)3 | 0 | 0 | H |
| 174 | 1-Naphthyl | Si(Me)3 | H | Si(Me)3 | 0 | 1 | H |
| 175 | 1-Naphthyl | Si(Me)3 | H | Si(Me)3 | 1 | 0 | H |
| 176 | 1-Naphthyl | Si(Me)3 | H | Si(Me)3 | 1 | 1 | H |
| 177 | 1-Naphthyl | Si(Me)3 | H | Methyl | 0 | 0 | H |
| 178 | 1-Naphthyl | Si(Me)3 | H | Methyl | 0 | 1 | H |
| 179 | 1-Naphthyl | Si(Me)3 | H | Methyl | 1 | 0 | H |
| 180 | 1-Naphthyl | Si(Me)3 | H | Methyl | 1 | 1 | H |
| 181 | 1-Naphthyl | Si(Me)3 | H | F | 0 | 0 | H |
| 182 | 1-Naphthyl | Si(Me)3 | H | F | 0 | 1 | H |
| 183 | 1-Naphthyl | Si(Me)3 | H | F | 1 | 0 | H |
| 184 | 1-Naphthyl | Si(Me)3 | H | F | 1 | 1 | H |
| 185 | 1-Naphthyl | Si(Me)3 | H | Phenyl | 0 | 0 | H |
| 186 | 1-Naphthyl | Si(Me)3 | H | Phenyl | 0 | 1 | H |
| 187 | 1-Naphthyl | Si(Me)3 | H | Phenyl | 1 | 0 | H |
| 188 | 1-Naphthyl | Si(Me)3 | H | Phenyl | 1 | 1 | H |
| 189 | 1-Naphthvl | Si(Me)3 | Si(Me)3 | H | 0 | 0 | H |
| 190 | 1-Naphthyl | Si(Me)3 | Si(Me)3 | H | 0 | 1 | H |
| 191 | 1-Naphthyl | Si(Me)3 | Si(Me)3 | H | 1 | 0 | H |
| 192 | 1-Naphthyl | Si(Me)3 | Si(Me)3 | H | 1 | 1 | H |
| 193 | 1-Naphthyl | Si(Me)3 | Si(Me)3 | Si(Me)3 | 0 | 0 | H |
| 194 | 1-Naphthyl | Si(Me)3 | Si(Me)3 | Si(Me)3 | 0 | 1 | H |
| 195 | 1-Naphthyl | Si(Me)3 | Si(Me)3 | Si(Me)3 | 1 | 0 | H |
| 196 | 1-Naphthyl | Si(Me)3 | Si(Me)3 | Si(Me)3 | 1 | 1 | H |
| 197 | 1-Naphthyl | Si(Me)3 | Si(Me)3 | Methyl | 0 | 0 | H |
| 198 | 1-Naphthyl | Si(Me)3 | Si(Me)3 | Methyl | 0 | 1 | H |
| 199 | 1-Naphthyl | Si(Me)3 | Si(Me)3 | Methyl | 1 | 0 | H |
| 200 | 1-Naphthyl | Si(Me)3 | Si(Me)3 | Methyl | 1 | 1 | H |
| 201 | 1-Naphthvl | Si(Me)3 | Si(Me)3 | F | 0 | 0 | H |
| 202 | 1-Naphthyl | Si(Me)3 | Si(Me)3 | F | 0 | 1 | H |
| 203 | 1-Naphthyl | Si(Me)3 | Si(Me)3 | F | 1 | 0 | H |
| 204 | 1-Naphthyl | Si(Me)3 | Si(Me)3 | F | 1 | 1 | H |
| 205 | 1-Naphthyl | Si(Me)3 | Si(Me)3 | Phenyl | 0 | 0 | H |
| 206 | 1-Naphthyl | Si(Me)3 | Si(Me)3 | Phenyl | 0 | 1 | H |
| 207 | 1-Naphthyl | Si(Me)3 | Si(Me)3 | Phenyl | 1 | 0 | H |
| 208 | 1-Naphthvl | Si(Me)3 | Si(Me)3 | Phenyl | 1 | 1 | H |
| 209 | 1-Naphthyl | H | H | H | 0 | 0 | Si(Me)3 |
| 210 | 1-Naphthyl | H | H | H | 0 | 1 | Si(Me)3 |
| 211 | 1-Naphthyl | H | H | H | 1 | 0 | Si(Me)3 |
| 212 | 1-Naphthyl | H | H | H | 1 | 1 | Si(Me)3 |
| 213 | 1-Naphthyl | H | H | Si(Me)3 | 0 | 0 | Si(Me)3 |
| 214 | 1-Naphthyl | H | H | Si(Me)3 | 0 | 1 | Si(Me)3 |
| 215 | 1-Naphthyl | H | H | Si(Me)3 | 1 | 0 | Si(Me)3 |
| 216 | 1-Naphthyl | H | H | Si(Me)3 | 1 | 1 | Si(Me)3 |
| 217 | 1-Naphthyl | H | H | Methyl | 0 | 0 | Si(Me)3 |
| 218 | 1-Naphthyl | H | H | Methyl | 0 | 1 | Si(Me)3 |
| 219 | 1-Naphthyl | H | H | Methyl | | 0 | Si(Me)3 |
| 220 | 1-Naphthyl | H | H | Methyl | 1 | 1 | Si(Me)3 |
| 221 | 1-Naphthyl | H | H | F | 0 | 0 | Si(Me)3 |
| 222 | 1-Naphthyl | H | H | F | 0 | 1 | Si(Me)3 |
| 223 | 1-Naphthyl | H | H | F | 1 | 0 | Si(Me)3 |
| 224 | 1-Naphthyl | H | H | F | 1 | 1 | Si(Me)3 |
| 225 | 1-Naphthyl | H | H | Phenyl | 0 | 0 | Si(Me)3 |
| 226 | 1-Naphthyl | H | H | Phenyl | 0 | 1 | Si(Me)3 |
| 227 | 1-Naphthyl | H | H | Phenyl | 1 | 0 | Si(Me)3 |
| 228 | 1-Naphthyl | H | H | Phenyl | 1 | 1 | Si(Me)3 |
| 229 | 1-Naphthyl | H | Si(Me)3 | H | 0 | 0 | Si(Me)3 |
| 230 | 1-Naphthyl | H | Si(Me)3 | H | 0 | 1 | Si(Me)3 |
| 231 | 1-Naphthyl | H | Si(Me)3 | H | 1 | 0 | Si(Me)3 |
| 232 | 1-Naphthyl | H | Si(Me)3 | H | 1 | 1 | Si(Me)3 |
| 233 | 1-Naphthyl | H | Si(Me)3 | Si(Me)3 | 0 | 0 | Si(Me)3 |
| 234 | 1-Naphthvl | H | Si(Me)3 | Si(Me)3 | 0 | 1 | Si(Me)3 |
| 235 | 1-Naphthvl | H | Si(Me)3 | Si(Me)3 | 1 | 0 | Si(Me)3 |
| 236 | 1-Naphthvl | H | Si(Me)3 | Si(Me)3 | 1 | 1 | Si(Me)3 |
| 237 | 1-Naphthyl | H | Si(Me)3 | Methyl | 0 | 0 | Si(Me)3 |
| 238 | 1-Naphthyl | H | Si(Me)3 | Methyl | 0 | 1 | Si(Me)3 |
| 239 | 1-Naphthyl | H | Si(Me)3 | Methyl | 1 | 0 | Si(Me)3 |
| 240 | 1-Naphthyl | H | Si(Me)3 | Methyl | 1 | 1 | Si(Me)3 |
| 241 | 1-Naphthyl | H | Si(Me)3 | F | 0 | 0 | Si(Me)3 |
| 242 | 1-Naphthyl | H | Si(Me)3 | F | 0 | 1 | Si(Me)3 |
| 243 | 1-Naphthyl | H | Si(Me)3 | F | 1 | 0 | Si(Me)3 |
| 244 | 1-Naphthyl | H | Si(Me)3 | F | 1 | 1 | Si(Me)3 |
| 245 | 1-Naphthyl | H | Si(Me)3 | Phenyl | 0 | 0 | Si(Me)3 |
| 246 | 1-Naphthyl | H | Si(Me)3 | Phenyl | 0 | 1 | Si(Me)3 |
| 247 | 1-Naphthyl | H | Si(Me)3 | Phenyl | 1 | 0 | Si(Me)3 |
| 248 | 1-Naphthyl | H | Si(Me)3 | Phenyl | 1 | 1 | Si(Me)3 |
| 249 | 1-Naphthyl | Si(Me)3 | H | H | 0 | 0 | Si(Me)3 |
| 250 | 1-Naphthyl | Si(Me)3 | H | H | 0 | 1 | Si(Me)3 |
| 251 | 1-Naphthyl | Si(Me)3 | H | H | 1 | 0 | Si(Me)3 |
| 252 | 1-Naphthyl | Si(Me)3 | H | H | 1 | 1 | Si(Me)3 |
| 253 | 1-Naphthyl | Si(Me)3 | H | Si(Me)3 | 0 | 0 | Si(Me)3 |
| 254 | 1-Naphthyl | Si(Me)3 | H | Si(Me)3 | 0 | 1 | Si(Me)3 |
| 255 | 1-Naphthyl | Si(Me)3 | H | Si(Me)3 | 1 | 0 | Si(Me)3 |
| 256 | 1-Naphthyl | Si(Me)3 | H | Si(Me)3 | 1 | 1 | Si(Me)3 |
| 257 | 1-Naphthyl | Si(Me)3 | H | Methyl | 0 | 0 | Si(Me)3 |
| 258 | 1-Naphthyl | Si(Me)3 | H | Methyl | 0 | 1 | Si(Me)3 |
| 259 | 1-Naphthyl | Si(Me)3 | H | Methyl | 1 | 0 | Si(Me)3 |
| 260 | 1-Naphthyl | Si(Me)3 | H | Methyl | 1 | 1 | Si(Me)3 |
| 261 | 1-Naphthyl | Si(Me)3 | H | F | 0 | 0 | Si(Me)3 |
| 262 | 1-Naphthyl | Si(Me)3 | H | F | 0 | 1 | Si(Me)3 |
| 263 | 1-Naphthyl | Si(Me)3 | H | F | 1 | 0 | Si(Me)3 |
| 264 | 1-Naphthyl | Si(Me)3 | H | F | 1 | 1 | Si(Me)3 |
| 265 | 1-Naphthyl | Si(Me)3 | H | Phenyl | 0 | 0 | Si(Me)3 |
| 266 | 1-Naphthyl | Si(Me)3 | H | Phenyl | 0 | 1 | Si(Me)3 |
| 267 | 1-Naphthyl | Si(Me)3 | H | Phenyl | 1 | 0 | Si(Me)3 |
| 268 | 1-Naphthyl | Si(Me)3 | H | Phenyl | 1 | 1 | Si(Me)3 |
| 269 | 1-Naphthyl | Si(Me)3 | Si(Me)3 | H | 0 | 0 | Si(Me)3 |
| 270 | 1-Naphthyl | Si(Me)3 | Si(Me)3 | H | 0 | 1 | Si(Me)3 |
| 271 | 1-Naphthyl | Si(Me)3 | Si(Me)3 | H | 1 | 0 | Si(Me)3 |
| 272 | 1-Naphthyl | Si(Me)3 | Si(Me)3 | H | 1 | 1 | Si(Me)3 |
| 273 | 1-Naphthyl | Si(Me)3 | Si(Me)3 | Si(Me)3 | 0 | 0 | Si(Me)3 |
| 274 | 1-Naphthyl | Si(Me)3 | Si(Me)3 | Si(Me)3 | 0 | 1 | Si(Me)3 |
| 275 | 1-Naphthyl | Si(Me)3 | Si(Me)3 | Si(Me)3 | 1 | 0 | Si(Me)3 |
| 276 | 1-Naphthyl | Si(Me)3 | Si(Me)3 | Si(Me)3 | 1 | 1 | Si(Me)3 |
| 277 | 1-Naphthyl | Si(Me)3 | Si(Me)3 | Methyl | 0 | 0 | Si(Me)3 |
| 278 | 1-Naphthyl | Si(Me)3 | Si(Me)3 | Methyl | 0 | 1 | Si(Me)3 |
| 279 | 1-Naphthyl | Si(Me)3 | Si(Me)3 | Methyl | 1 | 0 | Si(Me)3 |
| 280 | 1-Naphthyl | Si(Me)3 | Si(Me)3 | Methyl | 1 | 1 | Si(Me)3 |
| 281 | 1-Naphthyl | Si(Me)3 | Si(Me)3 | F | 0 | 0 | Si(Me)3 |
| 282 | 1-Naphthyl | Si(Me)3 | Si(Me)3 | F | 0 | 1 | Si(Me)3 |
| 283 | 1-Naphthyl | Si(Me)3 | Si(Me)3 | F | 1 | 0 | Si(Me)3 |
| 284 | 1-Naphthyl | Si(Me)3 | Si(Me)3 | F | 1 | 1 | Si(Me)3 |
| 285 | 1-Naphthyl | Si(Me)3 | Si(Me)3 | Phenyl | 0 | 0 | Si(Me)3 |
| 286 | 1-Naphthyl | Si(Me)3 | Si(Me)3 | Phenyl | 0 | 1 | Si(Me)3 |
| 287 | 1-Naphthyl | Si(Me)3 | Si(Me)3 | Phenyl | 1 | 0 | Si(Me)3 |
| 288 | 1-Naphthyl | Si(Me)3 | Si(Me)3 | Phenyl | 1 | 1 | Si(Me)3 |
| 289 | 2-Naphthyl | H | H | Si(Me)3 | 0 | 0 | H |
| 290 | 2-Naphthyl | H | H | Si(Me)3 | 0 | 1 | H |
| 291 | 2-Naphthyl | H | H | Si(Me)3 | 1 | 0 | H |
| 292 | 2-Naphthyl | H | H | Si(Me)3 | 1 | 1 | H |
| 293 | 2-Naphthyl | H | Si(Me)3 | H | 0 | 0 | H |
| 294 | 2-Naphthyl | H | Si(Me)3 | H | 0 | 1 | H |
| 295 | 2-Naphthyl | H | Si(Me)3 | H | 1 | 0 | H |
| 296 | 2-Naphthyl | H | Si(Me)3 | H | 1 | 1 | H |
| 297 | 2-Naphthyl | H | Si(Me)3 | Si(Me)3 | 0 | 0 | H |
| 298 | 2-Naphthyl | H | Si(Me)3 | Si(Me)3 | 0 | 1 | H |
| 299 | 2-Naphthyl | H | Si(Me)3 | Si(Me)3 | 1 | 0 | H |
| 300 | 2-Naphthyl | H | Si(Me)3 | Si(Me)3 | 1 | 1 | H |
| 301 | 2-Naphthyl | H | Si(Me)3 | Methyl | 0 | 0 | H |
| 302 | 2-Naphthyl | H | Si(Me)3 | Methyl | 0 | 1 | H |
| 303 | 2-Naphthyl | H | Si(Me)3 | Methyl | 1 | 0 | H |
| 304 | 2-Naphthyl | H | Si(Me)3 | Methyl | 1 | 1 | H |
| 305 | 2-Naphthyl | H | Si(Me)3 | F | 0 | 0 | H |
| 306 | 2-Naphthyl | H | Si(Me)3 | F | 0 | 1 | H |
| 307 | 2-Naphthyl | H | Si(Me)3 | F | 1 | 0 | H |
| 308 | 2-Naphthyl | H | Si(Me)3 | F | 1 | 1 | H |
| 309 | 2-Naphthyl | H | Si(Me)3 | Phenyl | 0 | 0 | H |
| 310 | 2-Naphthyl | H | Si(Me)3 | Phenyl | 0 | 1 | H |
| 311 | 2-Naphthyl | H | Si(Me)3 | Phenyl | 1 | 0 | H |
| 312 | 2-Naphthyl | H | Si(Me)3 | Phenyl | 1 | 1 | H |
| 313 | 2-Naphthyl | Si(Me)3 | H | H | 0 | 0 | H |
| 314 | 2-Naphthyl | Si(Me)3 | H | H | 0 | 1 | H |
| 315 | 2-Naphthyl | Si(Me)3 | H | H | 1 | 0 | H |
| 316 | 2-Naphthyl | Si(Me)3 | H | H | 1 | 1 | H |
| 317 | 2-Naphthyl | Si(Me)3 | H | Si(Me)3 | 0 | 0 | H |
| 318 | 2-Naphthyl | Si(Me)3 | H | Si(Me)3 | 0 | 1 | H |
| 319 | 2-Naphthyl | Si(Me)3 | H | Si(Me)3 | 1 | 0 | H |
| 320 | 2-Naphthyl | Si(Me)3 | H | Si(Me)3 | 1 | 1 | H |
| 321 | 2-Naphthyl | Si(Me)3 | H | Methyl | 0 | 0 | H |
| 322 | 2-Naphthyl | Si(Me)3 | H | Methyl | 0 | 1 | H |
| 323 | 2-Naphthyl | Si(Me)3 | H | Methyl | 1 | 0 | H |
| 324 | 2-Naphthyl | Si(Me)3 | H | Methyl | 1 | 1 | H |
| 325 | 2-Naphthyl | Si(Me)3 | H | F | 0 | 0 | H |
| 326 | 2-Naphthyl | Si(Me)3 | H | F | 0 | 1 | H |
| 327 | 2-Naphthyl | Si(Me)3 | H | F | 1 | 0 | H |
| 328 | 2-Naphthyl | Si(Me)3 | H | F | 1 | 1 | H |
| 329 | 2-Naphthyl | Si(Me)3 | H | Phenyl | 0 | 0 | H |
| 330 | 2-Naphthyl | Si(Me)3 | H | Phenyl | 0 | 1 | H |
| 331 | 2-Naphthyl | Si(Me)3 | H | Phenyl | 1 | 0 | H |
| 332 | 2-Naphthyl | Si(Me)3 | H | Phenyl | 1 | 1 | H |
| 333 | 2-Naphthyl | Si(Me)3 | Si(Me)3 | H | 0 | 0 | H |
| 334 | 2-Naphthyl | Si(Me)3 | Si(Me)3 | H | 0 | 1 | H |
| 335 | 2-Naphthyl | Si(Me)3 | Si(Me)3 | H | 1 | 0 | H |
| 336 | 2-Naphthyl | Si(Me)3 | Si(Me)3 | H | 1 | 1 | H |
| 337 | 2-Naphthyl | Si(Me)3 | Si(Me)3 | Si(Me)3 | 0 | 0 | H |
| 338 | 2-Naphthyl | Si(Me)3 | Si(Me)3 | Si(Me)3 | 0 | 1 | H |
| 339 | 2-Naphthyl | Si(Me)3 | Si(Me)3 | Si(Me)3 | 1 | 0 | H |
| 340 | 2-Naphthyl | Si(Me)3 | Si(Me)3 | Si(Me)3 | 1 | 1 | H |
| 341 | 2-Naphthyl | Si(Me)3 | Si(Me)3 | Methyl | 0 | 0 | H |
| 342 | 2-Naphthyl | Si(Me)3 | Si(Me)3 | Methyl | 0 | 1 | H |
| 343 | 2-Naphthyl | Si(Me)3 | Si(Me)3 | Methyl | 1 | 0 | H |
| 344 | 2-Naphthvl | Si(Me)3 | Si(Me)3 | Methyl | 1 | 1 | H |
| 345 | 2-Naphthyl | Si(Me)3 | Si(Me)3 | F | 0 | 0 | H |
| 346 | 2-Naphthyl | Si(Me)3 | Si(Me)3 | F | 0 | 1 | H |
| 347 | 2-Naphthyl | Si(Me)3 | Si(Me)3 | F | 1 | 0 | H |
| 348 | 2-Naphthyl | Si(Me)3 | Si(Me)3 | F | 1 | 1 | H |
| 349 | 2-Naphthyl | Si(Me)3 | Si(Me)3 | Phenyl | 0 | 0 | H |
| 350 | 2-Naphthyl | Si(Me)3 | Si(Me)3 | Phenyl | 0 | 1 | H |
| 351 | 2-Naphthyl | Si(Me)3 | Si(Me)3 | Phenyl | 1 | 0 | H |
| 352 | 2-Naphthyl | Si(Me)3 | Si(Me)3 | Phenyl | 1 | 1 | H |
| 353 | 2-Naphthyl | H | H | H | 0 | 0 | Si(Me)3 |
| 354 | 2-Naphthyl | H | H | H | 0 | 1 | Si(Me)3 |
| 355 | 2-Naphthyl | H | H | H | 1 | 0 | Si(Me)3 |
| 356 | 2-Naphthyl | H | H | H | 1 | 1 | Si(Me)3 |
| 357 | 2-Naphthyl | H | H | Si(Me)3 | 0 | 0 | Si(Me)3 |
| 358 | 2-Naphthyl | H | H | Si(Me)3 | 0 | 1 | Si(Me)3 |
| 359 | 2-Naphthyl | H | H | Si(Me)3 | 1 | 0 | Si(Me)3 |
| 360 | 2-Naphthyl | H | H | Si(Me)3 | 1 | 1 | Si(Me)3 |
| 361 | 2-Naphthyl | H | H | Methyl | 0 | 0 | Si(Me)3 |
| 362 | 2-Naphthyl | H | H | Methyl | 0 | 1 | Si(Me)3 |
| 363 | 2-Naphthyl | H | H | Methyl | 1 | 0 | Si(Me)3 |
| 364 | 2-Naphthyl | H | H | Methyl | 1 | 1 | Si(Me)3 |
| 365 | 2-Naphthyl | H | H | F | 0 | 0 | Si(Me)3 |
| 366 | 2-Naphthyl | H | H | F | 0 | 1 | Si(Me)3 |
| 367 | 2-Naphthyl | H | H | F | 1 | 0 | Si(Me)3 |
| 368 | 2-Naphthyl | H | H | F | 1 | 1 | Si(Me)3 |
| 369 | 2-Naphthyl | H | H | Phenyl | 0 | 0 | Si(Me)3 |
| 370 | 2-Naphthyl | H | H | Phenyl | 0 | 1 | Si(Me)3 |
| 371 | 2-Naphthyl | H | H | Phenyl | 1 | 0 | Si(Me)3 |
| 372 | 2-Naphthyl | H | H | Phenyl | 1 | 1 | Si(Me)3 |
| 373 | 2-Naphthyl | H | Si(Me)3 | H | 0 | 0 | Si(Me)3 |
| 374 | 2-Naphthyl | H | Si(Me)3 | H | 0 | 1 | Si(Me)3 |
| 375 | 2-Naphthyl | H | Si(Me)3 | H | 1 | 0 | Si(Me)3 |
| 376 | 2-Naphthyl | H | Si(Me)3 | H | 1 | 1 | Si(Me)3 |
| 377 | 2-Naphthyl | H | Si(Me)3 | Si(Me)3 | 0 | 0 | Si(Me)3 |
| 378 | 2-Naphthyl | H | Si(Me)3 | Si(Me)3 | 0 | 1 | Si(Me)3 |
| 379 | 2-Naphthyl | H | Si(Me)3 | Si(Me)3 | 1 | 0 | Si(Me)3 |
| 380 | 2-Naphthyl | H | Si(Me)3 | Si(Me)3 | 1 | 1 | Si(Me)3 |
| 381 | 2-Naphthyl | H | Si(Me)3 | Methyl | 0 | 0 | Si(Me)3 |
| 382 | 2-Naphthyl | H | Si(Me)3 | Methyl | 0 | 1 | Si(Me)3 |
| 383 | 2-Naphthyl | H | Si(Me)3 | Methyl | 1 | 0 | Si(Me)3 |
| 384 | 2-Naphthyl | H | Si(Me)3 | Methyl | 1 | 1 | Si(Me)3 |
| 385 | 2-Naphthyl | H | Si(Me)3 | F | 0 | 0 | Si(Me)3 |
| 386 | 2-Naphthyl | H | Si(Me)3 | F | 0 | 1 | Si(Me)3 |
| 387 | 2-Naphthyl | H | Si(Me)3 | F | 1 | 0 | Si(Me)3 |
| 388 | 2-Naphthyl | H | Si(Me)3 | F | 1 | 1 | Si(Me)3 |
| 389 | 2-Naphthyl | H | Si(Me)3 | Phenyl | 0 | 0 | Si(Me)3 |
| 390 | 2-Naphthyl | H | Si(Me)3 | Phenyl | 0 | 1 | Si(Me)3 |
| 391 | 2-naphthyl | H | Si(Me)3 | Phenyl | 1 | 0 | Si(Me)3 |
| 392 | 2-Naphthyl | H | Si(Me)3 | Phenyl | 1 | 1 | Si(Me)3 |
| 393 | 2-Naphthyl | Si(Me)3 | H | H | 0 | 0 | Si(Me)3 |
| 394 | 2-Naphthyl | Si(Me)3 | H | H | 0 | 1 | Si(Me)3 |
| 395 | 2-Naphthyl | Si(Me)3 | H | H | 1 | 0 | Si(Me)3 |
| 396 | 2-Naphthyl | Si(Me)3 | H | H | 1 | 1 | Si(Me)3 |
| 397 | 2-Naphthyl | Si(Me)3 | H | Si(Me)3 | 0 | 0 | Si(Me)3 |
| 398 | 2-Naphthyl | Si(Me)3 | H | Si(Me)3 | 0 | 1 | Si(Me)3 |
| 399 | 2-Naphthyl | Si(Me)3 | H | Si(Me)3 | 1 | 0 | Si(Me)3 |
| 400 | 2-Naphthyl | Si(Me)3 | H | Si(Me)3 | 1 | 1 | Si(Me)3 |
| 401 | 2-Naphthvl | Si(Me)3 | H | Methyl | 0 | 0 | Si(Me)3 |
| 402 | 2-Naphthyl | Si(Me)3 | H | Methyl | 0 | 1 | Si(Me)3 |
| 403 | 2-Naphthyl | Si(Me)3 | H | Methyl | 1 | 0 | Si(Me)3 |
| 404 | 2-Naphthyl | Si(Me)3 | H | Methyl | 1 | 1 | Si(Me)3 |
| 405 | 2-Naphthyl | Si(Me)3 | H | F | 0 | 0 | Si(Me)3 |
| 406 | 2-Naphthyl | Si(Me)3 | H | F | 0 | 1 | Si(Me)3 |
| 407 | 2-Naphthyl | Si(Me)3 | H | F | 1 | 0 | Si(Me)3 |
| 408 | 2-Naphthyl | Si(Me)3 | H | F | 1 | 1 | Si(Me)3 |
| 409 | 2-Naphthyl | Si(Me)3 | H | Phenyl | 0 | 0 | Si(Me)3 |
| 410 | 2-Naphthyl | Si(Me)3 | H | Phenyl | 0 | 1 | Si(Me)3 |
| 411 | 2-Naphthyl | Si(Me)3 | H | Phenyl | 1 | 0 | Si(Me)3 |
| 412 | 2-Naphthyl | Si(Me)3 | H | Phenyl | 1 | 1 | Si(Me)3 |
| 413 | 2-Naphthyl | Si(Me)3 | Si(Me)3 | H | 0 | 0 | Si(Me)3 |
| 414 | 2-Naphthyl | Si(Me)3 | Si(Me)3 | H | 0 | 1 | Si(Me)3 |
| 415 | 2-Naphthyl | Si(Me)3 | Si(Me)3 | H | 1 | 0 | Si(Me)3 |
| 416 | 2-Naphthyl | Si(Me)3 | Si(Me)3 | H | 1 | 1 | Si(Me)3 |
| 417 | 2-Naphthyl | Si(Me)3 | Si(Me)3 | Si(Me)3 | 0 | 0 | Si(Me)3 |
| 418 | 2-Naphthyl | Si(Me)3 | Si(Me)3 | Si(Me)3 | 0 | 1 | Si(Me)3 |
| 419 | 2-Naphthyl | Si(Me)3 | Si(Me)3 | Si(Me)3 | 1 | 0 | Si(Me)3 |
| 420 | 2-Naphthyl | Si(Me)3 | Si(Me)3 | Si(Me)3 | 1 | 1 | Si(Me)3 |
| 421 | 2-Naphthyl | Si(Me)3 | Si(Me)3 | Methyl | 0 | 0 | Si(Me)3 |
| 422 | 2-Naphthyl | Si(Me)3 | Si(Me)3 | Methyl | 0 | 1 | Si(Me)3 |
| 423 | 2-Naphthyl | Si(Me)3 | Si(Me)3 | Methyl | 1 | 0 | Si(Me)3 |
| 424 | 2-Naphthyl | Si(Me)3 | Si(Me)3 | Methyl | 1 | 1 | Si(Me)3 |
| 425 | 2-Naphthyl | Si(Me)3 | Si(Me)3 | F | 0 | 0 | Si(Me)3 |
| 426 | 2-Naphthyl | Si(Me)3 | Si(Me)3 | F | 0 | 1 | Si(Me)3 |
| 427 | 2-Naphthyl | Si(Me)3 | Si(Me)3 | F | 1 | 0 | Si(Me)3 |
| 428 | 2-Naphthyl | Si(Me)3 | Si(Me)3 | F | 1 | 1 | Si(Me)3 |
| 429 | 2-Naphthyl | Si(Me)3 | Si(Me)3 | Phenyl | 0 | 0 | Si(Me)3 |
| 430 | 2-Naphthyl | Si(Me)3 | Si(Me)3 | Phenyl | 0 | 1 | Si(Me)3 |
| 431 | 2-Naphthyl | Si(Me)3 | Si(Me)3 | Phenyl | 1 | 0 | Si(Me)3 |
| 432 | 2-Naphthyl | Si(Me)3 | Si(Me)3 | Phenyl | 1 | 1 | Si(Me)3 |
| 433 | para-Tolyl | H | H | Si(Me)3 | 0 | 0 | - |
| 434 | para-Tolyl | H | H | Si(Me)3 | 0 | 1 | - |
| 435 | para-Tolyl | H | H | Si(Me)3 | 1 | 0 | - |
| 436 | para-Tolyl | H | H | Si(Me)3 | 1 | 1 | - |
| 437 | para-Tolyl | H | Si(Me)3 | H | 0 | 0 | - |
| 438 | para-Tolyl | H | Si(Me)3 | H | 0 | 1 | - |
| 439 | para-Tolyl | H | Si(Me)3 | H | 1 | 0 | - |
| 440 | para-Tolyl | H | Si(Me)3 | H | 1 | 1 | - |
| 441 | para-Tolyl | H | Si(Me)3 | Si(Me)3 | 0 | 0 | - |
| 442 | para-Tolyl | H | Si(Me)3 | Si(Me)3 | 0 | 1 | - |
| 443 | para-Tolyl | H | Si(Me)3 | Si(Me)3 | 1 | 0 | - |
| 444 | para-Tolyl | H | Si(Me)3 | Si(Me)3 | 1 | 1 | - |
| 445 | para-Tolyl | H | Si(Me)3 | Methyl | 0 | 0 | - |
| 446 | para-Tolyl | H | Si(Me)3 | Methyl | 0 | 1 | - |
| 447 | para-Tolyl | H | Si(Me)3 | Methyl | 1 | 0 | - |
| 448 | para-Tolyl | H | Si(Me)3 | Methyl | 1 | 1 | - |
| 449 | para-Tolyl | H | Si(Me)3 | F | 0 | 0 | - |
| 450 | para-Tolyl | H | Si(Me)3 | F | 0 | 1 | - |
| 451 | para-Tolyl | H | Si(Me)3 | F | 1 | 0 | - |
| 452 | para-Tolyl | H | Si(Me)3 | F | 1 | 1 | - |
| 453 | para-Tolyl | H | Si(Me)3 | Phenyl | 0 | 0 | - |
| 454 | para-Tolyl | H | Si(Me)3 | Phenyl | 0 | 1 | - |
| 455 | para-Tolyl | H | Si(Me)3 | Phenyl | 1 | 0 | - |
| 456 | para-Tolyl | H | Si(Me)3 | Phenyl | 1 | 1 | - |
| 457 | para-Tolyl | Si(Me)3 | H | H | 0 | 0 | - |
| 458 | para-Tolyl | Si(Me)3 | H | H | 0 | 1 | - |
| 459 | para-Tolyl | Si(Me)3 | H | H | 1 | 0 | - |
| 460 | para-Tolyl | Si(Me)3 | H | H | 1 | 1 | - |
| 461 | para-Tolyl | Si(Me)3 | H | Si(Me)3 | 0 | 0 | - |
| 462 | para-Tolyl | Si(Me)3 | H | Si(Me)3 | 0 | 1 | - |
| 463 | para-Tolyl | Si(Me)3 | H | Si(Me)3 | 1 | 0 | - |
| 464 | para-Tolyl | Si(Me)3 | H | Si(Me)3 | 1 | 1 | - |
| 465 | para-Tolyl | Si(Me)3 | H | Methyl | 0 | 0 | - |
| 466 | para-Tolyl | Si(Me)3 | H | Methyl | 0 | 1 | - |
| 467 | para-Tolyl | Si(Me)3 | H | Methyl | 1 | 0 | - |
| 468 | para-Tolyl | Si(Me)3 | H | Methyl | 1 | 1 | - |
| 469 | para-Tolyl | Si(Me)3 | H | F | 0 | 0 | |
| 470 | para-Tolyl | Si(Me)3 | H | F | 0 | 1 | - |
| 471 | para-Tolyl | Si(Me)3 | H | F | 1 | 0 | - |
| 472 | para-Tolyl | Si(Me)3 | H | F | 1 | 1 | - |
| 473 | para-Tolyl | Si(Me)3 | H | Phenyl | 0 | 0 | - |
| 474 | para-Tolyl | Si(Me)3 | H | Phenyl | 0 | 1 | - |
| 475 | para-Tolyl | Si(Me)3 | H | Phenyl | 1 | 0 | - |
| 476 | para-Tolyl | Si(Me)3 | H | Phenyl | 1 | 1 | - |
| 477 | para-Tolyl | Si(Me)3 | Si(Me)3 | H | 0 | 0 | - |
| 478 | para-Tolyl | Si(Me)3 | Si(Me)3 | H | 0 | 1 | - |
| 479 | para-Tolyl | Si(Me)3 | Si(Me)3 | H | 1 | 0 | - |
| 480 | para-Tolyl | Si(Me)3 | Si(Me)3 | H | 1 | 1 | - |
| 481 | para-Tolyl | Si(Me)3 | Si(Me)3 | Si(Me)3 | 0 | 0 | - |
| 482 | para-Tolyl | Si(Me)3 | Si(Me)3 | Si(Me)3 | 0 | 1 | - |
| 483 | para-Tolyl | Si(Me)3 | Si(Me)3 | Si(Me)3 | 1 | 0 | - |
| 484 | para-Tolyl | Si(Me)3 | Si(Me)3 | Si(Me)3 | 1 | 1 | - |
| 485 | para-Tolyl | Si(Me)3 | Si(Me)3 | Methyl | 0 | 0 | - |
| 486 | para-Tolyl | Si(Me)3 | Si(Me)3 | Methyl | 0 | 1 | - |
| 487 | para-Tolyl | Si(Me)3 | Si(Me)3 | Methyl | 1 | 0 | - |
| 488 | para-Tolyl | Si(Me)3 | Si(Me)3 | Methyl | 1 | 1 | - |
| 489 | para-Tolyl | Si(Me)3 | Si(Me)3 | F | 0 | 0 | - |
| 490 | para-Tolyl | Si(Me)3 | Si(Me)3 | F | 0 | 1 | - |
| 491 | para-Tolyl | Si(Me)3 | Si(Me)3 | F | 1 | 0 | - |
| 492 | para-Tolyl | Si(Me)3 | Si(Me)3 | F | 1 | 1 | - |
| 493 | para-Tolyl | Si(Me)3 | Si(Me)3 | Phenyl | 0 | 0 | - |
| 494 | para-Tolyl | Si(Me)3 | Si(Me)3 | Phenyl | 0 | 1 | - |
| 495 | para-Tolyl | Si(Me)3 | Si(Me)3 | Phenyl | 1 | 0 | - |
| 496 | para-Tolyl | Si(Me)3 | Si(Me)3 | Phenyl | 1 | 1 | - |
| 497 | 2-Biphenyl | H | H | Si(Me)3 | 0 | 0 | - |
| 498 | 2-Biphenyl | H | H | Si(Me)3 | 0 | 1 | - |
| 499 | 2-Biphenyl | H | H | Si(Me)3 | 1 | 0 | - |
| 500 | 2-Biphenyl | H | H | Si(Me)3 | 1 | 1 | - |
| 501 | 2-Biphenyl | H | Si(Me)3 | H | 0 | 0 | - |
| 502 | 2-Biphenyl | H | Si(Me)3 | H | 0 | 1 | - |
| 503 | 2-Biphenyl | H | Si(Me)3 | H | 1 | 0 | - |
| 504 | 2-Biphenyl | H | Si(Me)3 | H | 1 | 1 | - |
| 505 | 2-Biphenyl | H | Si(Me)3 | Si(Me)3 | 0 | 0 | - |
| 506 | 2-Biphenyl | H | Si(Me)3 | Si(Me)3 | 0 | 1 | - |
| 507 | 2-Biphenyl | H | Si(Me)3 | Si(Me)3 | 1 | 0 | - |
| 508 | 2-Biphenyl | H | Si(Me)3 | Si(Me)3 | 1 | 1 | - |
| 509 | 2-Biphenyl | H | Si(Me)3 | Methyl | 0 | 0 | - |
| 510 | 2-Biphenyl | H | Si(Me)3 | Methyl | 0 | 1 | - |
| 511 | 2-Biphenyl | H | Si(Me)3 | Methyl | 1 | 0 | - |
| 512 | 2-Biphenyl | H | Si(Me)3 | Methyl | 1 | 1 | - |
| 513 | 2-Biphenyl | H | Si(Me)3 | F | 0 | 0 | - |
| 514 | 2-Biphenyl | H | Si(Me)3 | F | 0 | 1 | - |
| 515 | 2-Biphenyl | H | Si(Me)3 | F | 1 | 0 | - |
| 516 | 2-Biphenyl | H | Si(Me)3 | F | 1 | 1 | - |
| 517 | 2-Biphenyl | H | Si(Me)3 | Phenyl | 0 | 0 | - |
| 518 | 2-Biphenyl | H | Si(Me)3 | Phenyl | 0 | 1 | - |
| 519 | 2-Biphenyl | H | Si(Me)3 | Phenyl | 1 | 0 | - |
| 520 | 2-Biphenyl | H | Si(Me)3 | Phenyl | 1 | 1 | - |
| 521 | 2-Biphenyl | Si(Me)3 | H | H | 0 | 0 | - |
| 522 | 2-Biphenyl | Si(Me)3 | H | H | 0 | 1 | - |
| 523 | 2-Biphenyl | Si(Me)3 | H | H | 1 | 0 | - |
| 524 | 2-Biphenyl | Si(Me)3 | H | H | 1 | 1 | - |
| 525 | 2-Biphenyl | Si(Me)3 | H | Si(Me)3 | 0 | 0 | - |
| 526 | 2-Biphenvl | Si(Me)3 | H | Si(Me)3 | 0 | 1 | - |
| 527 | 2-Biphenyl | Si(Me)3 | H | Si(Me)3 | 1 | 0 | - |
| 528 | 2-Biphenyl | Si(Me)3 | H | Si(Me)3 | 1 | 1 | - |
| 529 | 2-Biphenyl | Si(Me)3 | H | Methyl | 0 | 0 | - |
| 530 | 2-Biphenyl | Si(Me)3 | H | Methyl | 0 | 1 | - |
| 531 | 2-Biphenyl | Si(Me)3 | H | Methyl | 1 | 0 | - |
| 532 | 2-Biphenyl | Si(Me)3 | H | Methyl | 1 | 1 | - |
| 533 | 2-Biphenyl | Si(Me)3 | H | F | 0 | 0 | - |
| 534 | 2-Biphenyl | Si(Me)3 | H | F | 0 | 1 | - |
| 535 | 2-Biphenyl | Si(Me)3 | H | F | 1 | 0 | - |
| 536 | 2-Biphenyl | Si(Me)3 | H | F | 1 | 1 | - |
| 537 | 2-Biphenyl | Si(Me)3 | H | Phenyl | 0 | 0 | - |
| 538 | 2-Biphenyl | Si(Me)3 | H | Phenyl | 0 | 1 | - |
| 539 | 2-Biphenyl | Si(Me)3 | H | Phenyl | 1 | 0 | - |
| 540 | 2-Biphenyl | Si(Me)3 | H | Phenyl | 1 | 1 | - |
| 541 | 2-Biphenyl | Si(Me)3 | Si(Me)3 | H | 0 | 0 | - |
| 542 | 2-Biphenyl | Si(Me)3 | Si(Me)3 | H | 0 | 1 | - |
| 543 | 2-Biphenyl | Si(Me)3 | Si(Me)3 | H | 1 | 0 | - |
| 544 | 2-Biphenyl | Si(Me)3 | Si(Me)3 | H | 1 | 1 | - |
| 545 | 2-Biphenyl | Si(Me)3 | Si(Me)3 | Si(Me)3 | 0 | 0 | - |
| 546 | 2-Biphenyl | Si(Me)3 | Si(Me)3 | Si(Me)3 | 0 | 1 | - |
| 547 | 2-Biphenyl | Si(Me)3 | Si(Me)3 | Si(Me)3 | 1 | 0 | - |
| 548 | 2-Biphenyl | Si(Me)3 | Si(Me)3 | Si(Me)3 | 1 | 1 | - |
| 549 | 2-Biphenyl | Si(Me)3 | Si(Me)3 | Methyl | 0 | 0 | - |
| 550 | 2-Biphenyl | Si(Me)3 | Si(Me)3 | Methyl | 0 | 1 | - |
| 551 | 2-Biphenyl | Si(Me)3 | Si(Me)3 | Methyl | 1 | 0 | - |
| 552 | 2-Biphenyl | Si(Me)3 | Si(Me)3 | Methyl | 1 | 1 | - |
| 553 | 2-Biphenyl | Si(Me)3 | Si(Me)3 | F | 0 | 0 | - |
| 554 | 2-Biphenyl | Si(Me)3 | Si(Me)3 | F | 0 | 1 | - |
| 555 | 2-Biphenyl | Si(Me)3 | Si(Me)3 | F | 1 | 0 | - |
| 556 | 2-Biphenyl | Si(Me)3 | Si(Me)3 | F | 1 | 1 | - |
| 557 | 2-Biphenyl | Si(Me)3 | Si(Me)3 | Phenyl | 0 | 0 | - |
| 558 | 2-Biphenyl | Si(Me)3 | Si(Me)3 | Phenyl | 0 | 1 | - |
| 559 | 2-Biphenyl | Si(Me)3 | Si(Me)3 | Phenyl | 1 | 0 | - |
| 560 | 2-Biphenyl | Si(Me)3 | Si(Me)3 | Phenyl | 1 | 1 | - |
| 561 | N(Ph)2 | H | H | Si(Me)3 | 0 | 0 | - |
| 562 | N(Ph)2 | H | H | Si(Me)3 | 0 | 1 | - |
| 563 | N(Ph)2 | H | H | Si(Me)3 | 1 | 0 | - |
| 564 | N(Ph)2 | H | H | Si(Me)3 | 1 | 1 | - |
| 565 | N(Ph)2 | H | Si(Me)3 | H | 0 | 0 | - |
| 566 | N(Ph)2 | H | Si(Me)3 | H | 0 | 1 | - |
| 567 | N(Ph)2 | H | Si(Me)3 | H | 1 | 0 | - |
| 568 | N(Ph)2 | H | Si(Me)3 | H | 1 | 1 | - |
| 569 | N(Ph)2 | H | Si(Me)3 | Si(Me)3 | 0 | 0 | - |
| 570 | N(Ph)2 | H | Si(Me)3 | Si(Me)3 | 0 | 1 | - |
| 571 | N(Ph)2 | H | Si(Me)3 | Si(Me)3 | 1 | 0 | - |
| 572 | N(Ph)2 | H | Si(Me)3 | Si(Me)3 | 1 | 1 | - |
| 573 | N(Ph)2 | H | Si(Me)3 | Methyl | 0 | 0 | - |
| 574 | N(Ph)2 | H | Si(Me)3 | Methyl | 0 | 1 | - |
| 575 | N(Ph)2 | H | Si(Me)3 | Methyl | 1 | 0 | - |
| 576 | N(Ph)2 | H | Si(Me)3 | Methyl | 1 | 1 | - |
| 577 | N(Ph)2 | H | Si(Me)3 | F | 0 | 0 | - |
| 578 | N(Ph)2 | H | Si(Me)3 | F | 0 | 1 | - |
| 579 | N(Ph)2 | H | Si(Me)3 | F | 1 | 0 | - |
| 580 | N(Ph)2 | H | Si(Me)3 | F | 1 | 1 | - |
| 581 | N(Ph)2 | H | Si(Me)3 | Phenyl | 0 | 0 | - |
| 582 | N(Ph)2 | H | Si(Me)3 | Phenyl | 0 | 1 | - |
| 583 | N(Ph)2 | H | Si(Me)3 | Phenyl | 1 | 0 | - |
| 584 | N(Ph)2 | H | Si(Me)3 | Phenyl | 1 | 1 | - |
| 585 | N(Ph)2 | Si(Me)3 | H | H | 0 | 0 | - |
| 586 | N(Ph)2 | Si(Me)3 | H | H | 0 | 1 | - |
| 587 | N(Ph)2 | Si(Me)3 | H | H | 1 | 0 | - |
| 588 | N(Ph)2 | Si(Me)3 | H | H | 1 | 1 | - |
| 589 | N(Ph)2 | Si(Me)3 | H | Si(Me)3 | 0 | 0 | - |
| 590 | N(Ph)2 | Si(Me)3 | H | Si(Me)3 | 0 | 1 | - |
| 591 | N(Ph)2 | Si(Me)3 | H | Si(Me)3 | 1 | 0 | - |
| 592 | N(Ph)2 | Si(Me)3 | H | Si(Me)3 | 1 | 1 | - |
| 593 | N(Ph)2 | Si(Me)3 | H | Methyl | 0 | 0 | - |
| 594 | N(Ph)2 | Si(Me)3 | H | Methyl | 0 | 1 | - |
| 595 | N(Ph)2 | Si(Me)3 | H | Methyl | 1 | 0 | - |
| 596 | N(Ph)2 | Si(Me)3 | H | Methyl | 1 | 1 | - |
| 597 | N(Ph)2 | Si(Me)3 | H | F | 0 | 0 | - |
| 598 | N(Ph)2 | Si(Me)3 | H | F | 0 | 1 | - |
| 599 | N(Ph)2 | Si(Me)3 | H | F | 1 | 0 | - |
| 600 | N(Ph)2 | Si(Me)3 | H | F | 1 | 1 | - |
| 601 | N(Ph)2 | Si(Me)3 | H | Phenyl | 0 | 0 | - |
| 602 | N(Ph)2 | Si(Me)3 | H | Phenyl | 0 | 1 | - |
| 603 | N(Ph)2 | Si(Me)3 | H | Phenyl | 1 | 0 | - |
| 604 | N(Ph)2 | Si(Me)3 | H | Phenyl | 1 | 1 | - |
| 605 | N(Ph)2 | Si(Me)3 | Si(Me)3 | H | 0 | 0 | - |
| 606 | N(Ph)2 | Si(Me)3 | Si(Me)3 | H | 0 | 1 | - |
| 607 | N(Ph)2 | Si(Me)3 | Si(Me)3 | H | 1 | 0 | - |
| 608 | N(Ph)2 | Si(Me)3 | Si(Me)3 | H | 1 | 1 | - |
| 609 | N(Ph)2 | Si(Me)3 | Si(Me)3 | Si(Me)3 | 0 | 0 | - |
| 610 | N(Ph)2 | Si(Me)3 | Si(Me)3 | Si(Me)3 | 0 | 1 | - |
| 611 | N(Ph)2 | Si(Me)3 | Si(Me)3 | Si(Me)3 | 1 | 0 | - |
| 612 | N(Ph)2 | Si(Me)3 | Si(Me)3 | Si(Me)3 | 1 | 1 | - |
| 613 | N(Ph)2 | Si(Me)3 | Si(Me)3 | Methyl | 0 | 0 | - |
| 614 | N(Ph)2 | Si(Me)3 | Si(Me)3 | Methyl | 0 | 1 | - |
| 615 | N(Ph)2 | Si(Me)3 | Si(Me)3 | Methyl | 1 | 0 | - |
| 616 | N(Ph)2 | Si(Me)3 | Si(Me)3 | Methyl | 1 | 1 | - |
| 617 | N(Ph)2 | Si(Me)3 | Si(Me)3 | F | 0 | 0 | - |
| 618 | N(Ph)2 | Si(Me)3 | Si(Me)3 | F | 0 | 1 | - |
| 619 | N(Ph)2 | Si(Me)3 | Si(Me)3 | F | 1 | 0 | - |
| 620 | N(Ph)2 | Si(Me)3 | Si(Me)3 | F | 1 | 1 | - |
| 621 | N(Ph)2 | Si(Me)3 | Si(Me)3 | Phenyl | 0 | 0 | - |
| 622 | N(Ph)2 | Si(Me)3 | Si(Me)3 | Phenyl | 0 | 1 | - |
| 623 | N(Ph)2 | Si(Me)3 | Si(Me)3 | Phenyl | 1 | 0 | - |
| 624 | N(Ph)2 | Si(Me)3 | Si(Me)3 | Phenyl | 1 | 1 | - |
| 625 | N(p-Tol)2 | H | H | Si(Me)3 | 0 | 0 | - |
| 626 | N(p-Tol)2 | H | H | Si(Me)3 | 0 | 1 | - |
| 627 | N(p-Tol)2 | H | H | Si(Me)3 | 1 | 0 | - |
| 628 | N(p-Tol)2 | H | H | Si(Me)3 | 1 | 1 | - |
| 629 | N(p-Tol)2 | H | Si(Me)3 | H | 0 | 0 | - |
| 630 | N(p-Tol)2 | H | Si(Me)3 | H | 0 | 1 | - |
| 631 | N(p-Tol)2 | H | Si(Me)3 | H | 1 | 0 | - |
| 632 | N(p-Tol)2 | H | Si(Me)3 | H | 1 | 1 | - |
| 633 | N(p-Tol)2 | H | Si(Me)3 | Si(Me)3 | 0 | 0 | - |
| 634 | N(p-Tol)2 | H | Si(Me)3 | Si(Me)3 | 0 | 1 | - |
| 635 | N(p-Tol)2 | H | Si(Me)3 | Si(Me)3 | 1 | 0 | - |
| 636 | N(p-Tol)2 | H | Si(Me)3 | Si(Me)3 | 1 | 1 | - |
| 637 | N(p-Tol)2 | H | Si(Me)3 | Methyl | 0 | 0 | - |
| 638 | N(p-Tol)2 | H | Si(Me)3 | Methyl | 0 | 1 | - |
| 639 | N(p-Tol)2 | H | Si(Me)3 | Methyl | 1 | 0 | - |
| 640 | N(p-Tol)2 | H | Si(Me)3 | Methyl | 1 | 1 | - |
| 641 | N(p-Tol)2 | H | Si(Me)3 | F | 0 | 0 | - |
| 642 | N(p-Tol)2 | H | Si(Me)3 | F | 0 | 1 | - |
| 643 | N(p-Tol)2 | H | Si(Me)3 | F | 1 | 0 | - |
| 644 | N(p-Tol)2 | H | Si(Me)3 | F | 1 | 1 | - |
| 645 | N(p-Tol)2 | H | Si(Me)3 | Phenyl | 0 | 0 | - |
| 646 | N(p-Tol)2 | H | Si(Me)3 | Phenyl | 0 | 1 | - |
| 647 | N(p-Tol)2 | H | Si(Me)3 | Phenyl | 1 | 0 | - |
| 648 | N(p-Tol)2 | H | Si(Me)3 | Phenyl | 1 | 1 | - |
| 649 | N(p-Tol)2 | Si(Me)3 | H | H | 0 | 0 | - |
| 650 | N(p-Tol)2 | Si(Me)3 | H | H | 0 | 1 | - |
| 651 | N(p-Tol)2 | Si(Me)3 | H | H | 1 | 0 | - |
| 652 | N(p-Tol)2 | Si(Me)3 | H | H | 1 | 1 | - |
| 653 | N(p-Tol)2 | Si(Me)3 | H | Si(Me)3 | 0 | 0 | - |
| 654 | N(p-Tol)2 | Si(Me)3 | H | Si(Me)3 | 0 | 1 | - |
| 655 | N(p-Tol)2 | Si(Me)3 | H | Si(Me)3 | 1 | 0 | - |
| 656 | N(p-Tol)2 | Si(Me)3 | H | Si(Me)3 | 1 | 1 | - |
| 657 | N(p-Tol)2 | Si(Me)3 | H | Methyl | 0 | 0 | - |
| 658 | N(p-Tol)2 | Si(Me)3 | H | Methyl | 0 | 1 | - |
| 659 | N(p-Tol)2 | Si(Me)3 | H | Methyl | 1 | 0 | - |
| 660 | N(p-Tol)2 | Si(Me)3 | H | Methyl | 1 | 1 | - |
| 661 | N(p-Tol)2 | Si(Me)3 | H | F | 0 | 0 | - |
| 662 | N(p-Tol)2 | Si(Me)3 | H | F | 0 | 1 | - |
| 663 | N(p-Tol)2 | Si(Me)3 | H | F | 1 | 0 | - |
| 664 | N(p-Tol)2 | Si(Me)3 | H | F | 1 | 1 | - |
| 665 | N(p-Tol)2 | Si(Me)3 | H | Phenyl | 0 | 0 | - |
| 666 | N(p-Tol)2 | Si(Me)3 | H | Phenyl | 0 | 1 | - |
| 667 | N(p-Tol)2 | Si(Me)3 | H | Phenyl | 1 | 0 | - |
| 668 | N(p-Tol)2 | Si(Me)3 | H | Phenyl | 1 | 1 | - |
| 669 | N(p-Tol)2 | Si(Me)3 | Si(Me)3 | H | 0 | 0 | - |
| 670 | N(p-Tol)2 | Si(Me)3 | Si(Me)3 | H | 0 | 1 | - |
| 671 | N(p-Tol)2 | Si(Me)3 | Si(Me)3 | H | 1 | 0 | - |
| 672 | N(p-Tol)2 | Si(Me)3 | Si(Me)3 | H | 1 | 1 | - |
| 673 | N(p-Tol)2 | Si(Me)3 | Si(Me)3 | Si(Me)3 | 0 | 0 | - |
| 674 | N(p-Tol)2 | Si(Me)3 | Si(Me)3 | Si(Me)3 | 0 | 1 | - |
| 675 | N(p-Tol)2 | Si(Me)3 | Si(Me)3 | Si(Me)3 | 1 | 0 | - |
| 676 | N(p-Tol)2 | Si(Me)3 | Si(Me)3 | Si(Me)3 | 1 | 1 | - |
| 677 | N(p-Tol)2 | Si(Me)3 | Si(Me)3 | Methyl | 0 | 0 | - |
| 678 | N(p-Tol)2 | Si(Me)3 | Si(Me)3 | Methyl | 0 | 1 | - |
| 679 | N(p-Tol)2 | Si(Me)3 | Si(Me)3 | Methyl | 1 | 0 | - |
| 680 | N(p-Tol)2 | Si(Me)3 | Si(Me)3 | Methyl | 1 | 1 | - |
| 681 | N(p-Tol)2 | Si(Me)3 | Si(Me)3 | F | 0 | 0 | - |
| 682 | N(p-Tol)2 | Si(Me)3 | Si(Me)3 | F | 0 | 1 | - |
| 683 | N(p-Tol)2 | Si(Me)3 | Si(Me)3 | F | 1 | 0 | - |
| 684 | N(p-Tol)2 | Si(Me)3 | Si(Me)3 | F | 1 | 1 | - |
| 685 | N(p-Tol)2 | Si(Me)3 | Si(Me)3 | Phenyl | 0 | 0 | - |
| 686 | N(p-Tol)2 | Si(Me)3 | Si(Me)3 | Phenyl | 0 | 1 | - |
| 687 | N(p-Tol)2 | Si(Me)3 | Si(Me)3 | Phenyl | 1 | 0 | - |
| 688 | N(p-Tol)2 | Si(Me)3 | Si(Me)3 | Phenyl | 1 | 1 | - |
| 689 | N(Ph)(1-Naph) | H | H | Si(Me)3 | 0 | 0 | - |
| 690 | N(Ph)(1-Naph) | H | H | Si(Me)3 | 0 | 1 | - |
| 691 | N(Ph)(1-Naph) | H | H | Si(Me)3 | 1 | 0 | - |
| 692 | N(Ph)(1-Naph) | H | H | Si(Me)3 | 1 | 1 | - |
| 693 | N(Ph)(1-Naph) | H | Si(Me)3 | H | 0 | 0 | - |
| 694 | N(Ph)(1-Naph) | H | Si(Me)3 | H | 0 | 1 | - |
| 695 | N(Ph)(1-Naph) | H | Si(Me)3 | H | 1 | 0 | - |
| 696 | N(Ph)(1-Naph) | H | Si(Me)3 | H | 1 | 1 | - |
| 697 | N(Ph)(1-Naph) | H | Si(Me)3 | Si(Me)3 | 0 | 0 | - |
| 698 | N(Ph)(1-Naph) | H | Si(Me)3 | Si(Me)3 | 0 | 1 | - |
| 699 | N(Ph)(1-Naph) | H | Si(Me)3 | Si(Me)3 | 1 | 0 | - |
| 700 | N(Ph)(1-Naph) | H | Si(Me)3 | Si(Me)3 | 1 | 1 | - |
| 701 | N(Ph)(1-Naph) | H | Si(Me)3 | Methyl | 0 | 0 | - |
| 702 | N(Ph)(1-Naph) | H | Si(Me)3 | Methyl | 0 | 1 | - |
| 703 | N(Ph)(1-Naph) | H | Si(Me)3 | Methyl | 1 | 0 | - |
| 704 | N(Ph)(1-Naph) | H | Si(Me)3 | Methyl | 1 | 1 | - |
| 705 | N(Ph)(1-Naph) | H | Si(Me)3 | F | 0 | 0 | - |
| 706 | N(Ph)(1-Naph) | H | Si(Me)3 | F | 0 | 1 | - |
| 707 | N(Ph)(1-Naph) | H | Si(Me)3 | F | 1 | 0 | - |
| 708 | N(Ph)(1-Naph) | H | Si(Me)3 | F | 1 | 1 | - |
| 709 | N(Ph)(1-Naph) | H | Si(Me)3 | Phenyl | 0 | 0 | - |
| 710 | N(Ph)(1-Naph) | H | Si(Me)3 | Phenyl | 0 | 1 | - |
| 711 | N(Ph)(1-Naph) | H | Si(Me)3 | Phenyl | 1 | 0 | - |
| 712 | N(Ph)(1-Naph) | H | Si(Me)3 | Phenyl | 1 | 1 | - |
| 713 | N(Ph)(1-Naph) | Si(Me)3 | H | H | 0 | 0 | - |
| 714 | N(Ph)(1-Naph) | Si(Me)3 | H | H | 0 | 1 | - |
| 715 | N(Ph)(1-Naph) | Si(Me)3 | H | H | 1 | 0 | - |
| 716 | N(Ph)(1-Naph) | Si(Me)3 | H | H | 1 | 1 | - |
| 717 | N(Ph)(1-Naph) | Si(Me)3 | H | Si(Me)3 | 0 | 0 | - |
| 718 | N(Ph)(1-Naph) | Si(Me)3 | H | Si(Me)3 | 0 | 1 | - |
| 719 | N(Ph)(1-Naph) | Si(Me)3 | H | Si(Me)3 | 1 | 0 | - |
| 720 | N(Ph)(1-Naph) | Si(Me)3 | H | Si(Me)3 | 1 | 1 | - |
| 721 | N(Ph)(1-Naph) | Si(Me)3 | H | Methyl | 0 | 0 | - |
| 722 | N(Ph)(1-Naph) | Si(Me)3 | H | Methyl | 0 | 1 | - |
| 723 | N(Ph)(1-Naph) | Si(Me)3 | H | Methyl | 1 | 0 | - |
| 724 | N(Ph)(1-Naph) | Si(Me)3 | H | Methyl | 1 | 1 | - |
| 725 | N(Ph)(1-Naph) | Si(Me)3 | H | F | 0 | 0 | - |
| 726 | N(Ph)(1-Naph) | Si(Me)3 | H | F | 0 | 1 | - |
| 727 | N(Ph)(1-Naph) | Si(Me)3 | H | F | 1 | 0 | - |
| 728 | N(Ph)(1-Naph) | Si(Me)3 | H | F | 1 | 1 | - |
| 729 | N(Ph)(1-Naph) | Si(Me)3 | H | Phenyl | 0 | 0 | - |
| 730 | N(Ph)(1-Naph) | Si(Me)3 | H | Phenyl | 0 | 1 | - |
| 731 | N(Ph)(1-Naph) | Si(Me)3 | H | Phenyl | 1 | 0 | - |
| 732 | N(Ph)(1-Naph) | Si(Me)3 | H | Phenyl | 1 | 1 | - |
| 733 | N(Ph)(1-Naph) | Si(Me)3 | Si(Me)3 | H | 0 | 0 | - |
| 734 | N(Ph)(1-Naph) | Si(Me)3 | Si(Me)3 | H | 0 | 1 | - |
| 735 | N(Ph)(1-Naph) | Si(Me)3 | Si(Me)3 | H | 1 | 0 | - |
| 736 | N(Ph)(1-Naph) | Si(Me)3 | Si(Me)3 | H | 1 | 1 | - |
| 737 | N(Ph)(1-Naph) | Si(Me)3 | Si(Me)3 | Si(Me)3 | 0 | 0 | - |
| 738 | N(Ph)(1-Naph) | Si(Me)3 | Si(Me)3 | Si(Me)3 | 0 | 1 | - |
| 739 | N(Ph)(1-Naph) | Si(Me)3 | Si(Me)3 | Si(Me)3 | 1 | 0 | - |
| 740 | N(Ph)(1-Naph) | Si(Me)3 | Si(Me)3 | Si(Me)3 | 1 | 1 | - |
| 741 | N(Ph)(1-Naph) | Si(Me)3 | Si(Me)3 | Methyl | 0 | 0 | - |
| 742 | N(Ph)(1-Naph) | Si(Me)3 | Si(Me)3 | Methyl | 0 | 1 | - |
| 743 | N(Ph)(1-Naph) | Si(Me)3 | Si(Me)3 | Methyl | 1 | 0 | - |
| 744 | N(Ph)(1-Naph) | Si(Me)3 | Si(Me)3 | Methyl | 1 | 1 | - |
| 745 | N(Ph)(1-Naph) | Si(Me)3 | Si(Me)3 | F | 0 | 0 | - |
| 746 | N(Ph)(1-Naph) | Si(Me)3 | Si(Me)3 | F | 0 | 1 | - |
| 747 | N(Ph)(1-Naph) | Si(Me)3 | Si(Me)3 | F | 1 | 0 | - |
| 748 | N(Ph)(1-Naph) | Si(Me)3 | Si(Me)3 | F | 1 | 1 | - |
| 749 | N(Ph)(1-Naph) | Si(Me)3 | Si(Me)3 | Phenyl | 0 | 0 | - |
| 750 | N(Ph)(1-Naph) | Si(Me)3 | Si(Me)3 | Phenyl | 0 | 1 | - |
| 751 | N(Ph)(1-Naph) | Si(Me)3 | Si(Me)3 | Phenyl | 1 | 0 | - |
| 752 | N(Ph)(1-Naph) | Si(Me)3 | Si(Me)3 | Phenyl | 1 | 1 | - |

Die Verbindungen gemäß Formel (1) können in organischen Elektrolumineszenzvorrichtungen eingesetzt werden. Je nach Substitutionsmuster eignen sie sich für den Einsatz als Hostmaterial, insbesondere für fluoreszierende Emitter, als Emitter, als Lochtransportmaterial, als Lochblockiermaterial und/oder als Elektronentransportmaterial.

Weiterer Gegenstand der Erfindung ist daher die Verwendung von Verbindungen gemäß Formel (1) in organischen elektronischen Vorrichtungen, insbesondere in organischen Elektrolumineszenzvorrichtungen, insbesondere als Hostmaterial, als Emitter, als Lochtransportmaterial, als Lochblockiermaterial und/oder als Elektronentransportmaterial.

Weiterer Gegenstand der Erfindung sind organische elektronische Vorrichtungen, insbesondere organische Elektrolumineszenzvorrichtungen, enthaltend Anode, Kathode und mindestens eine emittierende Schicht, wobei mindestens eine Schicht mindestens eine Verbindung gemäß Formel (1) enthält. Bevorzugt ist die Schicht, die die Verbindung gemäß Formel (1) enthält, eine emittierende Schicht, eine Lochtransportschicht, eine Lochinjektionsschicht, eine Lochblockierschicht oder eine Elektronentransportschicht.

Außer Kathode, Anode und der emittierenden Schicht (bzw. den emittierenden Schichten) kann die organische Elektrolumineszenzvorrichtung noch weitere Schichten enthalten. Diese können beispielsweise sein: Lochinjektionsschicht, Lochtransportschicht, Lochblockier-schicht, Elektronentransportschicht, Elektroneninjektionsschicht und/oder eine Charge-Generation Layer (T. Matsumoto et al., Multiphoton Organic EL Device Having Charge Generation Layer, IDMC 2003, Taiwan; Session 21 OLED (5)). Die Materialien in diesen Schichten können auch dotiert sein. Es muss nicht notwendigerweise jede dieser Schichten vorhanden sein. Als Lochtransportmaterialien eignen sich beispielsweise aromatische Amine, wie sie üblicherweise gemäß dem Stand der Technik verwendet werden, welche auch p-dotiert sein können. Als Elektronentransportmaterialien eignen sich beispielsweise Metallchelatkomplexe, z. B. AIQ₃, Verbindungen auf Basis elektronenarmer Heterocyclen, z. B. Triazinderivate, oder Verbindungen enthaltend aromatische Carbonyle oder Phosphinoxide, wie z. B. beschrieben in WO 05/084081 und WO 05/084082, welche jeweils auch n-dotiert sein können. Als Elektroneninjektionsmaterialien eignen sich insbesondere Fluoride und Oxide der Alkali- und Erdalkalimetalle, beispielsweise NaF, BaF₂, CaF₂, LiF oder Li₂O.

Wenn das Symbol R für ein aromatisches oder heteroaromatisches Ringsystem steht, insbesondere für eine kondensierte Aryl- oder Heteroarylgruppe, eignet sich die Verbindung gemäß Formel (1) besonders gut als Hostmaterial, insbesondere für fluoreszierende Emitter, und/oder als Elektronentransportmaterial und/oder als Lochblockiermaterial.

Unter einem Hostmaterial wird in einem System aus Host und Dotand diejenige Komponente verstanden, die in dem System im höheren Anteil vorliegt. Bei einem System aus einem Host und mehreren Dotanden wird als Host diejenige Komponente verstanden, deren Anteil der höchste in der Mischung ist.

Der Anteil des Hostmaterials gemäß der Formel (1) in der emittierenden Schicht beträgt zwischen 50.0 und 99.9 Gew.-%, bevorzugt zwischen 80.0 und 99.5 Gew.-%, besonders bevorzugt zwischen 90.0 und 99.0 Gew.-%. Entsprechend beträgt der Anteil des Dotanden in der emittierenden Schicht zwischen 0.1 und 50.0 Gew.-%, bevorzugt zwischen 0.5 und 20.0 Gew.-%, besonders bevorzugt zwischen 1.0 und 10.0 Gew.-%. Bevorzugte Dotanden sind ausgewählt aus der Klasse der aromatischen Anthracenamine, der aromatischen Anthracendiamine, der aromatischen Pyrenamine, der aromatischen Pyrendiamine, der aromatischen Chrysenamine, der aromatischen Chrysendiamine, der Monostyrylamine, der Distyrylamine, der Tristyrylamine, der Tetrastyrylamine, der Styrylphosphine, der Styrylether und der Arylamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine und Pyrendiamine bzw. aromatische Chrysenamine und Chrysendiamine sind analog dazu definiert. Unter einem Monostyrylamin wird eine Verbindung verstanden, die eine Styrylgruppe und mindestens ein, bevorzugt aromatisches, Amin enthält. Unter einem Distyrylamin wird eine Verbindung verstanden, die zwei Styrylgruppen und mindestens ein, bevorzugt aromatisches, Amin enthält. Unter einem Tristyrylamin wird eine Verbindung verstanden, die drei Styrylgruppen und mindestens ein, bevorzugt aromatisches, Amin enthält. Unter einem Tetrastyrylamin wird eine Verbindung verstanden, die vier Styrylgruppen und mindestens ein, bevorzugt aromatisches, Amin enthält. Entsprechende Phosphine und Ether sind in Analogie zu den Aminen definiert. Unter einem Arylamin bzw. einem aromatischen Amin im Sinne dieser Erfindung wird eine Verbindung verstanden, die drei aromatische oder heteroaromatische Ringsysteme direkt an den Stickstoff gebunden enthält. Die Styrylgruppen sind besonders bevorzugt Stilbene, die auch noch weiter substituiert sein können. Besonders bevorzugte Dotanden sind gewählt aus den Klassen der Tristilbenamine, der aromatischen Stilbendiamine, der Anthracendiamine und der Pyrendiamine. Ganz besonders bevorzugte Dotanden sind ausgewählt aus der Klasse der Tristyrylamine. Beispiele für derartige Dotanden sind substituierte oder unsubstituierte Tristilbenamine oder die Dotanden, die in WO 06/000388, WO 06/058737 und WO 06/000389 beschrieben sind.

Weiterhin bevorzugt sind organische Elektrolumineszenzvorrichtungen, dadurch gekennzeichnet, dass mehrere emittierende Schichten verwendet werden, wobei mindestens eine dieser Schichten mindestens eine Verbindung gemäß Formel (1) enthält. Besonders bevorzugt weisen diese Emissionsschichten insgesamt mehrere Emissionsmaxima zwischen 380 nm und 750 nm auf, so dass insgesamt weiße Emission resultiert, d. h. in der bzw. den weiteren emittierenden Schichten wird noch mindestens eine weitere emittierende Verbindung verwendet, die fluoreszieren oder phosphoreszieren kann und die gelbes, orange oder rotes Licht emittiert. Insbesondere bevorzugt sind Dreischichtsysteme, wobei mindestens eine dieser Schichten mindestens eine Verbindung gemäß Formel (1) enthält und wobei die drei Schichten blaue, grüne und orange oder rote Emission zeigen (für den prinzipiellen Aufbau siehe z. B. WO 05/011013). Ebenso eignen sich für weiße Emission Emitter, welche breitbandige Emissionsbanden aufweisen und dadurch weiße Emission zeigen.

Außer den Verbindungen gemäß Formel (1) können in der emittierenden Schicht auch weitere Substanzen vorhanden sein, beispielsweise Loch- oder Elektronentransportmaterialien.

Wenn das Symbol R für eine Gruppe N(Ar¹)₂ steht und/oder ein Substituent an der Gruppe Ar für eine Gruppe N(Ar¹)₂ steht, eignet sich die Verbindung gemäß Formel (1) besonders gut als emittierende Verbindung und/oder als Lochtransportmaterial, wie im Folgenden genauer ausgeführt.

Wenn die Verbindung der Formel (1) als Lochtransportmaterial eingesetzt wird, wird sie bevorzugt in einer Lochtransportschicht und/oder in einer Lochinjektionsschicht eingesetzt. Eine Lochinjektionsschicht im Sinne dieser Erfindung ist eine Schicht, die direkt an die Anode angrenzt. Eine Lochtransportschicht im Sinne dieser Erfindung ist eine Schicht, die zwischen einer Lochinjektionsschicht und einer Emissionsschicht liegt. Wenn die Verbindungen gemäß Formel (1) als Lochtransport- bzw. als Lochinjektionsmaterial verwendet werden, kann es bevorzugt sein, wenn sie mit Elektronenakzeptor-Verbindungen dotiert ist, beispielsweise mit F₄-TCNQ oder mit Verbindungen, wie sie in EP 1476881 oder EP 1596445 beschrieben werden.

Wenn die Verbindung der Formel (1) als emittierende Verbindung eingesetzt wird, wird sie bevorzugt in Kombination mit einem Hostmaterial eingesetzt.

Der Anteil der emittierenden Verbindung gemäß Formel (1) in der Mischung der emittierenden Schicht beträgt zwischen 0.1 und 50.0 Gew.-%, bevorzugt zwischen 0.5 und 20.0 Gew. %, besonders bevorzugt zwischen 1.0 und 10.0 Gew.-%. Entsprechend beträgt der Anteil des Hostmaterials in der Schicht zwischen 50.0 und 99.9 Gew.-%, bevorzugt zwischen 80.0 und 99.5 Gew.-%, besonders bevorzugt zwischen 90.0 und 99.0 Gew.-%.

Als Hostmaterialien kommen verschiedene Stoffklassen in Frage. Bevorzugte Hostmaterialien sind ausgewählt aus den Klassen der Oligo-arylene (z. B. 2,2',7,7'-tetraphenyl-spirobifluoren gemäß EP 676461 oder Dinaphthylanthracen), insbesondere der Oligo-arylene enthaltend kondensierte aromatische Gruppen, der Oligo-arylenvinylene (z. B. DPVBi oder Spiro-DPVBi gemäß EP 676461), der polypodalen Metallkomplexe (z. B. gemäß WO 04/081017), der lochleitenden Verbindungen (z. B. gemäß WO 04/058911), der elektronenleitenden Verbindungen, insbesondere Ketone, Phosphinoxide, Sulfoxide, etc. (z. B. gemäß WO 05/084081 oder WO 05/084082), der Atropisomere (z. B. gemäß WO 06/048268) oder der Boronsäurederivate (z. B. gemäß der nicht offen gelegten Anmeldung EP 05009643.7). Besonders bevorzugte Hostmaterialien sind ausgewählt aus den Klassen der Oligoarylene, enthaltend Naphthalin, Anthracen und/oder Pyren oder Atropisomeren dieser Verbindungen, der Oligo-arylenvinylene, der Ketone, der Phosphinoxide und der Sulfoxide. Ganz besonders bevorzugte Hostmaterialien sind ausgewählt aus den Klassen der Oligoarylene, enthaltend Anthracen und/oder Pyren oder Atropisomeren dieser Verbindungen, der Phosphinoxide und der Sulfoxide.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen gemäß Formel (1) nötig. Daher eignen sich die erfindungsgemäßen Verbindungen sehr gut für die Verarbeitung aus Lösung, da sie durch die Substitution hohe Löslichkeit in organischen Lösemitteln aufweisen.

Die erfindungsgemäßen organischen Elektrolumineszenzvorrichtungen weisen folgende überraschende Vorteile gegenüber dem Stand der Technik auf:
1. Die thermische Stabilität und insbesondere die Glasübergangstemperatur der Verbindungen wird höher im Vergleich zu Verbindungen gemäß dem Stand der Technik, welche bei ansonsten gleichem Aufbau keine Trialkylsilylgruppe enthalten.
2. Die erfindungsgemäßen Verbindungen weisen eine sehr gute Löslichkeit in gängigen organischen Lösemitteln auf, was die Reinigung der Verbindungen bei der Herstellung sowie die Reinigung der Aufdampfanlagen (beispielsweise der Schattenmasken) vereinfacht und ein Aufbringen der Verbindungen durch Lösungsprozesse ermöglicht.
3. Die erfindungsgemäßen Verbindungen weisen eine höhere Loch- und Elektronenstabilität (Redoxstabilität) auf gegenüber vergleichbaren Materialien gemäß dem Stand der Technik, die keine Si(R²)₃-Gruppen enthalten.

Im vorliegenden Anmeldetext wird auf die Verwendung erfindungsgemäßer Verbindungen in Bezug auf OLEDs und die entsprechenden Displays abgezielt.

Trotz dieser Beschränkung der Beschreibung ist es für den Fachmann ohne weiteres erfinderisches Zutun möglich, die erfindungsgemäßen Verbindungen auch für weitere Verwendungen in anderen elektronischen Vorrichtungen zu benutzen, z. B. für organische Feld-Effekt-Transistoren (O-FETs), organische Dünnfilmtransistoren (O-TFTs), organische lichtemittierende Transistoren (O-LETs), organische integrierte Schaltungen (O-ICs), organische Solarzellen (O-SCs), organische Feld-Quench-Devices (O-FQDs), organische Photorezeptoren, lichtemittierende elektrochemische Zellen (LECs) oder organische Laserdioden (O-Laser).

Die Verwendung der erfindungsgemäßen Verbindungen in den entsprechenden Vorrichtungen ebenso wie diese Vorrichtungen selbst sind ein weiterer Gegenstand der vorliegenden Erfindung.

Die Erfindung wird durch die nachfolgenden Beispiele näher erläutert, ohne sie dadurch einschränken zu wollen.

### Beispiele:

Die nachfolgenden Synthesen werden, sofern nicht anders angegeben, unter einer Schutzgasatmosphäre durchgeführt. Die Edukte können von den Firmen ALDRICH bzw. ABCR (n-Buthyllithium, 2.5 M in Hexan, Silane, Bromide, Anorganika, Lösemittel) bezogen werden. 2,6-Dibrom-anthrachinon wird nach Lee *et al*., *Org*. *Lett*. **2005**, *7(2)*, 323 dargestellt.

### Beispiel 1: 2,6-Bis(trimethylsilyl)-9,10-bis(o-tolyl)anthracen

### a) 2,6-Dibrom-9,10-bis(o-tolyl)anthracen

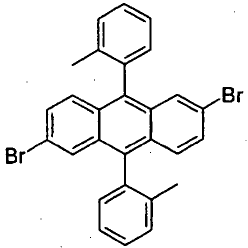

Aus 18.0 ml (150 mmol) 2-Bromtoluol in 500 ml THF wird durch Zugabe von 60 ml n-Butyllithium (2.5 M in Hexan) bei -78 °C und 1 h Nachrühren das entsprechende Organolithiumreagenz dargestellt. Dieses wird mit 27.5 g (75 mmol) 2,6-Dibromanthrachinon versetzt. Anschließend wird die Reaktionsmischung 1 h bei - 78 °C gerührt, während 5 h auf Raumtemperatur erwärmt und dann mit einem Gemisch aus 100 ml Essigsäure und 200 ml Wasser versetzt. Der Feststoff wird abgesaugt, mit 200 ml Wasser, 100 ml Ethanol und zweimal mit je 200 ml Heptan gewaschen und getrocknet. Der Feststoff wird mit 15.2 g (80 mmol) Zinn(II)chlorid (wasserfrei) in 300 ml DMF 3 h unter Rückfluss erhitzt. Nach Erkalten wird mit 500 ml 2.5 N Salzsäure versetzt und vom Feststoff abgesaugt. Der Feststoff wird dreimal mit je 100 ml 2.5 N Salzsäure, dreimal mit je 100 ml Wasser und dreimal mit je 100 ml Ethanol gewaschen, im Vakuum getrocknet und zweimal aus DMF umkristallisiert. Ausbeute: 33.0 g (64 mmol), 85.2 % d. Th.; Reinheit: 99 % nach HPLC.

### b) 2,6-Bis(trimethylsilyl)-9,10-bis(o-tolyl)anthracen

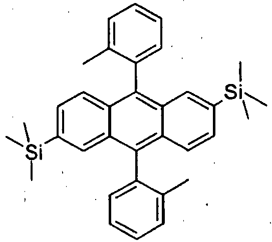

Aus 33.0 g (64 mmol) 2,6-Dibrom-9,10-di-o-tolyl-anthracen in 500 ml THF wird durch Zugabe von 77 ml n-Butyllithium (2.5 M in Hexan) bei -78 °C und 3 h Nachrühren das entsprechende Organolithiumreagenz dargestellt und anschließend mit 26.8 ml (210 mmol) Chlortrimethylsilan versetzt. Nach 1 h Nachrühren und Erwärmen auf Raumtemperatur wird das THF im Vakuum entfernt, der Rückstand wird in 500 ml Dichlormethan aufgenommen, die organische Phase wird dreimal mit je 500 ml Wasser gewaschen, getrocknet, über Celite filtriert und im Vakuum vom Lösemittel befreit. Der Rückstand wird fünfmal aus Toluol / Acetonitril umkristallisiert und dann im Hochvakuum sublimiert, p = 1 x 10⁻⁵ mbar, T = 310 °C. Ausbeute: 23.6 g (47 mmol), 73.4 % d. Th.; Reinheit: 99.8 % nach HPLC. Mischung aus zwei Atropisomeren nach ¹H-NMR-Spektroskopie.

### Beispiel 2: Synthese weiterer erfindungsgemäßer Verbindungen

Analog zu Beispiel 1 werden folgende Verbindungen dargestellt:

| Bsp. | Bromid / Schritt a) | Silan / Schritt b) | Produkt |
|---|---|---|---|
| 3 | 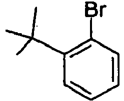 | 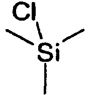 | 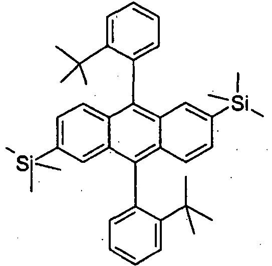 |
| 4 | 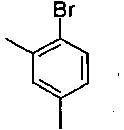 | 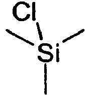 | 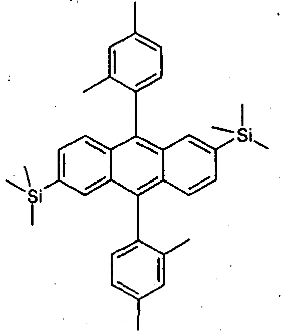 |
| 5 | 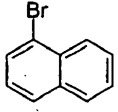 | 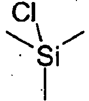 | 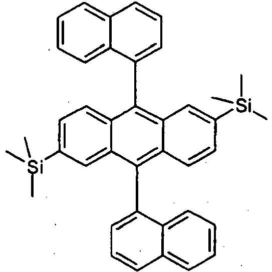 |
| 6 | 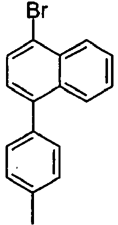 | 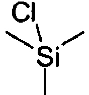 | 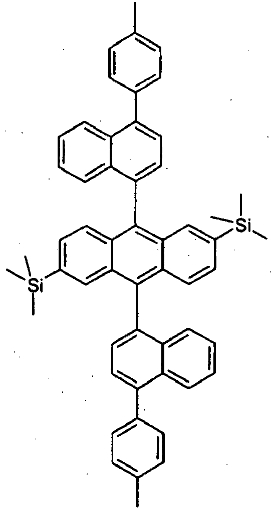 |
| 7 | 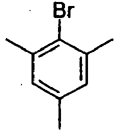 | 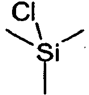 | 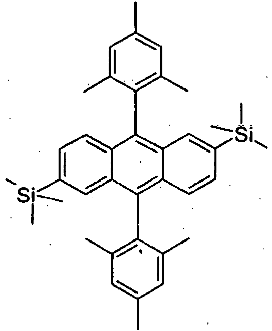 |
| 8 | 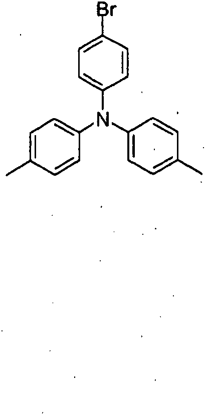 | 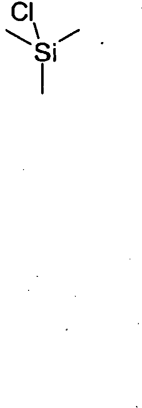 | 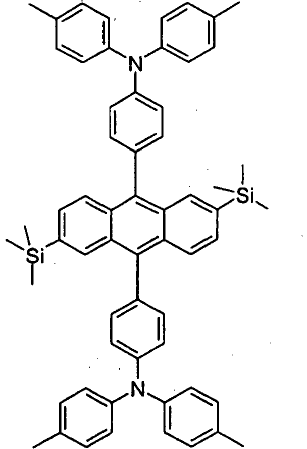 |
| 9 . | 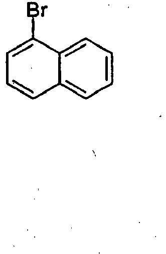 | 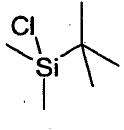 | 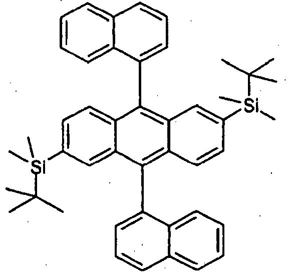 |
| 10 | 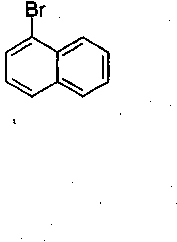 | 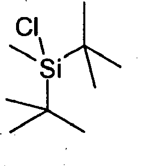 | 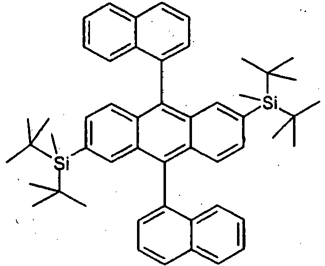 |
| 11 | 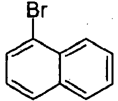 | 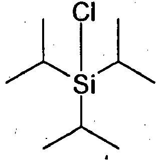 | 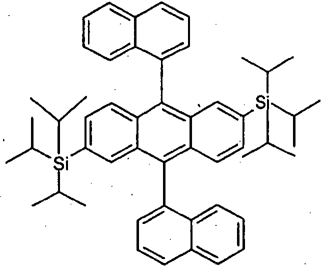 |

### Beispiel 12: 9-(4-Methylnaphth-1-yl)-10-(4-trimethylsilylnapthyl)-anthracen

### a) Synthese von (4-Bromnaphth-1-yl)-trimethylsilan

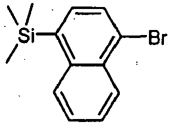

Ein Lösung aus 114.38 g (400 mmol) 1,4-Dibromnapthalin und 1 I THF (absolut) wird unter Schutzgas auf -78 °C gekühlt, anschließend bei dieser Temperatur langsam mit 160 ml (400 mmol) n-Butyllithium (2.5 M in n-Hexan) versetzt und 30 h bei -78 °C nachgerührt. Die so erhaltene Lösung wird mit einem Gemisch aus 52.3 ml (400 mmol) Chlortrimethylsilan in 200 ml THF (absolut) versetzt und langsam auf Raumtemperatur erwärmt. Nach Zugabe von 150 ml EtOH und anschließend 300 ml Wasser wird die organische Phase abgetrennt, über Magnesiumsulfat getrocknet und eingeengt. Das so erhaltene Öl wird bei 115-135 °C und 1.7 mbar destilliert. Es werden 80 g (286 mmol) (entsprechend 88 % d. Th.) des Produkts mit einer Reinheit größer 99.0 % nach HPLC erhalten.

### b) Synthese von 4-(Trimethylsilyl)napth-1-ylboronsäure

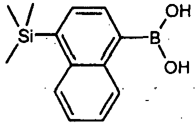

Eine auf -78 °C gekühlte Lösung von 46.8 g (167.6 mmol) (4-Bromnaphth-1-yl)-trimethylsilan in 950 ml Diethylether wird tropfenweise mit 73.7 ml (184 mmol) n-Buthyllithium (2.5 M in Hexan) versetzt. Die Reaktions-mischung wird 30 min. bei -78 °C gerührt, auf Raumtemperatur erwärmt, dann erneut auf -78 °C gekühlt und schnell mit einer Mischung von 26.4 ml (234 mmol) Trimethylborat in 50 ml Diethylether versetzt. Nach Erwärmen auf -10 °C wird mit 90 ml 2 N Salzsäure hydrolysiert. Die organische Phase wird abgetrennt, mit Wasser gewaschen, über Natriumsulfat getrocknet und zur Trockene eingeengt. Der Rückstand wird in 200 ml n-Heptan aufgenommen, der farblose Feststoff wird abgesaugt, mit n-Heptan gewaschen und im Vakuum getrocknet. Ausbeute: 26 g (106 mmol), 45 % d. Th.; Reinheit: 98 % nach ¹H-NMR.

### c) Synthese von 9-(4-Methylnaphth-1-yl)-10-(4-trimethylsilylnapthyl)-anthracen

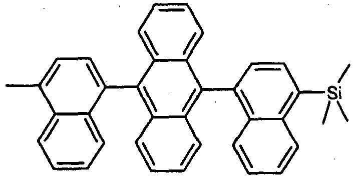

Eine gut gerührte, entgaste Suspension aus 22.8 g (93.3 mmol) 4-Trimethylsilylnapth-1-ylboronsäure, 37.4 g (93.3 mmol) 9-(4-Methyl-naphth-1-yl)anthracen und 90 g (230 mmol) Triskaliumphosphat in einem Gemisch aus 575 ml Wasser, 100 ml Dioxan und 860 ml Toluol wird mit 1.78 g (5,6 mmol) Tri-o-tolylphosphin und 0.2 g (0.9 mmol) Palladiumacetat versetzt und 60 h unter Rückfluss erhitzt. Nach Erkalten wird die organische Phase abgetrennt, dreimal mit 200 ml Wasser und einmal mit 200 ml gesättigter, wässriger Kochsalzlösung gewaschen und anschließend über Magnesiumsulfat getrocknet. Nach Abfiltrieren des Trockenmittels wird die organische Phase im Vakuum zur Trockene einrotiert. Der so erhaltene graue Rückstand wird aus Dioxan umkristallisiert. Die ausgefallenen Kristalle werden abgesaugt, mit 50 ml Ethanol gewaschen und anschließend im Vakuum getrocknet; Ausbeute: 38 g, 79 % d. Th.; Reinheit: 99.9 % nach HPLC.

### Beispiel 13: 9,10-Bis(4-Trimethylsilylnapthyl) anthracen

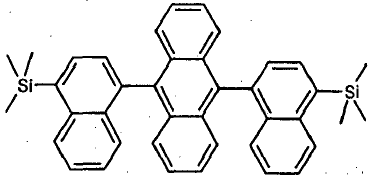

Eine gut gerührte, entgaste Suspension aus 29.7 g (122 mmol) 4-Trimethylsilylnapth-1-ylboronsäure (aus Beispiel 12 b), 13.6 g (40.6 mmol) 9,10-Dibromanthracen und 41 g (178 mmol) Triskaliumphosphat in einem Gemisch aus 163 ml Wasser, 200 ml Dioxan und 200 ml Toluol wird mit 2.6 g (9.7 mmol) Tri-o-tolylphosphin und 0.365 g (1.63 mmol) Palladiumacetat versetzt und 60 h unter Rückfluss erhitzt. Nach Erkalten wird die organische Phase abgetrennt, dreimal mit 200 ml Wasser und einmal mit 200 ml gesättigter, wässriger Kochsalzlösung gewaschen und anschließend über Magnesiumsulfat getrocknet. Nach Abfiltrieren des Trockenmittels wird die organische Phase im Vakuum zur Trockene einrotiert. Der so erhaltene graue Rückstand wird aus Dioxan umkristallisiert. Die ausgefallenen Kristalle werden abgesaugt, mit 50 ml Ethanol gewaschen und anschließend im Vakuum getrocknet; Ausbeute: 23 g, 78 % d. Th.; Reinheit: 99.9 % n. HPLC.

### Beispiel 14: Herstellung der OLEDs

Die Herstellung von OLEDs erfolgt nach einem allgemeinen Verfahren gemäß WO 04/058911, das im Einzelfall auf die jeweiligen Gegebenheiten (z. B. Schichtdickenvariation, um optimale Effizienz bzw. Farbe zu erreichen) angepasst wird. Der grundlegende Aufbau und die verwendeten Materialien (außer der emittierenden Schicht) sind in den Beispielen zur besseren Vergleichbarkeit identisch. Analog dem o. g. allgemeinen Verfahren werden OLEDs mit folgendem Aufbau erzeugt:

| | |
|---|---|
| Lochtransportschicht (HTM) | 20 nm 2,2',7,7'-Tetrakis(di-para-tolyl-amino)spiro-9,9'-bifluoren (abgekürzt als **HTM-1**) |
| Lochtransportschicht (HTM) | 20 nm NPB (N-Naphthyl-N-phenyl-4,4'-diaminobiphenyl) |
| Emissionschicht (EML) | siehe Tabelle 1 für Materialien, Konzentration und Schichtdicke |
| Elektronenleiter (ETL) | 20 nm AlQ₃ (bezogen von SynTec, Tris(chinolinato)aluminium(III)) |
| Kathode | 1 nm LiF, darauf 150 nm Al. |

Diese OLEDs werden standardmäßig charakterisiert; hierfür werden die Elektrolumineszenzspektren, die Effizienz (gemessen in cd/A), die Leistungseffizienz (gemessen in lm/W) in Abhängigkeit der Helligkeit, berechnet aus Strom-Spannungs-Helligkeit-Kennlinien (IUL-Kennlinien), und die Lebensdauer bestimmt. Als Lebensdauer wird die Zeit definiert, nach der die Anfangshelligkeit von 1000 cd/m² auf die Hälfte gesunken ist.

In Tabelle 2 sind die Ergebnisse einiger OLEDs (Beispiele 2 bis 9) zusammengefasst, die die Dotanden D1, D2 sowie die Verbindung aus Beispiel 8 enthalten, wobei jeweils die Zusammensetzung der EML inklusive der Schichtdicken mit aufgeführt ist.

Die Struktur der Dotanden ist im Folgenden abgebildet:

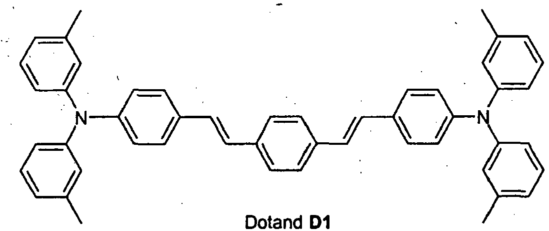

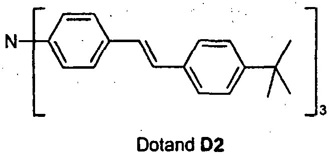

Als erfindungsgemäßes Hostmaterial werden die Verbindungen aus Beispiel 5, 10, 12 und 13 eingesetzt. Als Hostmaterial gemäß dem Stand der Technik werden zum Vergleich die Hostmaterialien **H1 und H2** eingesetzt. Die Hostmaterialien sind im Folgenden abgebildet:

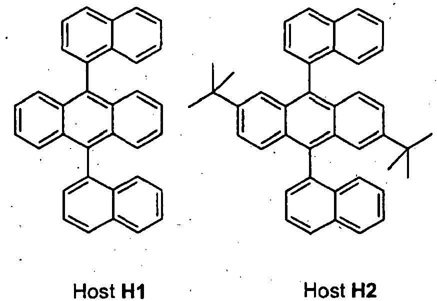

Wie man den Beispielen in der Tabelle 2 entnehmen kann, zeigen die erfindungsgemäßen Elektrolumineszenzvorrichtungen höhere Effizienz und längere Lebensdauer bei vergleichbaren Farbkoordinaten im Vergleich zu Elektrolumineszenzvorrichtungen gemäß dem Stand der Technik.

**Tabelle 2**

| **Beispiel** | **EML** | **Max Effizienz (cd/A)** | **Spannung (V) bei 100cd/m²** | **CIE** | **Lebens-dauer (h)** |
|---|---|---|---|---|---|
| Beispiel 15 (Vergleich) | **H1 : D1** (3%) (30 nm) | 11.8 | 5.5 | x=0.17; y=0.32 | 6700 |
| Beispiel 16 (Vergleich) | **H1 : D1** (5%) (30 nm) | 12.2 | 5.3 | x=0.17; y=0.33 | 7000 |
| Beispiel 17 (Vergleich) | **H1 : D1** (7%) (30 nm) | 11.5 | 5.2 | x=0.18; y=0.36 | 5300 |
| Beispiel 18 (Vergleich) | **H2 : D1** (5%) (30 nm) | 11.8 | 5.0 | x=0.17; y=0.35 | 7800 |
| Beispiel 19 | **Beispiel 13 : D1** (3%) (30 nm) | 11.0 | 5.4 | x=0.17; y=0.33 | 7200 |
| Beispiel 20 | **Beispiel** 13: **D1** (5%) (30 nm) | 12.4 | 5.2 | x=0.17; y=0.35 | 7900 |
| Beispiel 21 | **Beispiel 12 : D1** (3%) (30 nm) | 11.8 | 5.3 | x=0.17; y=0.32 | 8000 |
| Beispiel 22 | **Beispiel 12 : D1** (5%) (30 nm) | 12.8 | 5.1 | X=0.17; y=0.32 | 8500 |
| Beispiel 23 | **Beispiel 10 : D1** (5%) (30 nm) | 13 | 4.8 | X=0.18; y=0.37 | 8800 |
| Beispiel 24 | **Beispiel 5 : D1** (5%) (30 nm) | 12.8 | 5.0 | X=0.17; y=0.35 | 8400 |
| Beispiel 25 (Vergleich) | **H1 : D2** (5%) (30 nm) | 4.2 | 5.1 | x=0.15; y=0.11 | 1600 |
| Beispiel 26 | **Beispiel 10 : D2** (5%) (30 nm) | 5.1 | 5.1 | x=0.15; y=0.14 | 2200 |
| Beispiel 27 | **Beispiel 12: D2** (5%) (30 nm) | 4.5 | 5.0 | x=0.15; y=0.12 | 3000 |
| Beispiel 25 | **H1 : Beispiel 8** (5%) (30 nm) | 6.1 | 5.1 | x=0.15; y=0.17 | 4000 |
| Beispiel 25 | **Beispiel 12 : Beispiel 8** (5%) (30 nm) | 6.2 | 4.8 | x=0.15; y=0.16 | 4500 |

## Patentansprüche

1. Silyl-substituierte Verbindungen der Formel (1), 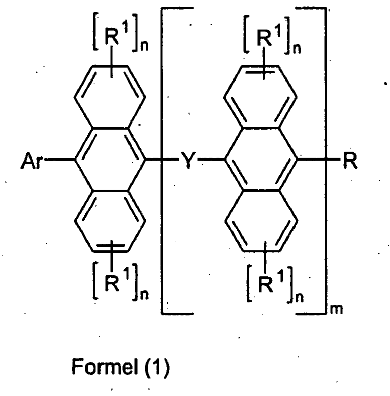 wobei für die verwendeten Symbole und Indizes gilt:
Ar ist eine 1-Naphthylgruppe oder eine 9-Anthrylgruppe, in welcher ein oder zwei Kohlenstoffatome durch N ersetzt sein können und welche mit einem oder mehreren Resten R¹ substituiert sein kann und/oder welche mit einem oder mehreren Resten N(Ar¹)₂ substituiert sein kann, wobei die beiden Reste Ar¹ auch durch einen Einfachbindung oder eine Gruppe O, S, N(R¹), C(R¹)₂ miteinander verbunden sein können;
R ist ein aromatisches oder heteroaromatisches Ringsystem mit 5 bis 40 aromatischen Ringatomen, welches mit einem oder mehreren Resten R¹ substituiert sein kann, oder eine Gruppe N(Ar¹)₂, wobei die beiden Reste Ar¹ auch durch eine Einfach-bindung oder eine Gruppe O, S, N(R¹) oder C(R¹)₂ miteinander verbunden sein können;
Ar¹ ist bei jedem Auftreten gleich oder verschieden ein aromatisches oder heteroaromatisches Ringsystem mit 5 bis 40 aromatischen Ringatomen, welches durch einen oder mehrere Reste R¹ substituiert sein kann;
Y ist bei jedem Auftreten gleich oder verschieden eine bivalente Gruppe enthaltend 1 bis 40 C-Atome oder -O-, -S-, -NR¹-, -P(=O)R¹- oder eine Einfachbindung;
R¹ ist gleich oder verschieden bei jedem Auftreten Si(R²)₃, F, Cl, Br, I, CN, N(R³)₂, NO₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R³ substituiert sein kann, wobei eine oder mehrere nicht benachbarte CH₂-Gruppen durch -R³C=CR³-, -C=C-, Si(R³)₂, Ge(R³)₂, Sn(R³)₂, C=O, C=S, C=Se, C=NR³, -O-, -S-, -N(R³)- oder -CONR³- ersetzt sein können und wobei ein oder mehrere H-Atome durch F, Cl, Br, I, CN oder NO₂ ersetzt sein können, oder eine Aryl- oder Heteroarylgruppe mit 5 bis 24 aromatischen Ringatomen, die mit einem oder mehreren Resten R³ substituiert sein kann, oder eine Aryloxy- oder Heteroaryloxygruppe mit 5 bis 24 aromatischen Ringatomen, die durch einen oder mehrere Reste R³ substituiert sein kann, oder eine Kombination aus zwei, drei, vier oder fünf dieser Systeme; dabei können auch zwei oder mehrere benachbarte Substituenten R¹ miteinander ein mono- oder polycyclisches, aliphatisches Ringsystem bilden;
R² ist bei jedem Auftreten gleich oder verschieden eine geradkettige Alkylgruppe mit 1 bis 40 C-Atomen oder eine verzweigte oder cyclische Alkylgruppe mit 3 bis 40 C-Atomen, wobei jeweils eine oder mehrere nicht benachbarte CH₂-Gruppen, die nicht direkt an das Silicium binden, durch -R³C=CR³-, -C≡C-, Si(R³)₂, Ge(R³)₂, Sn(R³)₂, C=O, C=S, C=Se, C=NR³, -O-, -S-, -N(R³)-oder -CONR³- ersetzt sein können und wobei jeweils ein oder mehrere H-Atome durch F, Cl, Br, I, CN oder NO₂ ersetzt sein können, welche auch durch eine Aryl- oder Heteroarylgruppe mit 5 bis 24 aromatischen Ringatomen, die mit einem oder mehreren Resten R³ substituiert sein kann, oder durch eine Aryloxy- oder Heteroaryloxygruppe mit 5 bis 24 aromatischen Ringatomen, die durch einen oder mehrere Reste R³ substituiert sein kann, substituiert sein kann; dabei können auch zwei oder mehrere Substituenten R² miteinander ein mono- oder polycyclisches Ringsystem bilden;
R³ ist bei jedem Auftreten gleich oder verschieden H oder ein Kohlenwasserstoffrest mit 1 bis 20 C-Atomen, welcher aliphatisch oder aromatisch oder eine Kombination aus aliphatisch und aromatisch sein kann und welcher auch durch F substituiert sein kann; dabei können auch zwei oder mehrere Reste R³ miteinander ein mono- oder polycyclisches, aliphatisches oder aromatisches Ringsystem bilden;
n ist gleich oder verschieden bei jedem Auftreten 0, 1, 2, 3 oder 4;
m ist 0, 1, 2, 3, 4 oder 5;
**dadurch gekennzeichnet, dass** mindestens ein Rest R¹ im Molekül anwesend ist, welcher eine Gruppe Si(R²)₃ darstellt.

2. Verbindung der Formel (1a) bis (1d) nach Anspruch 1, 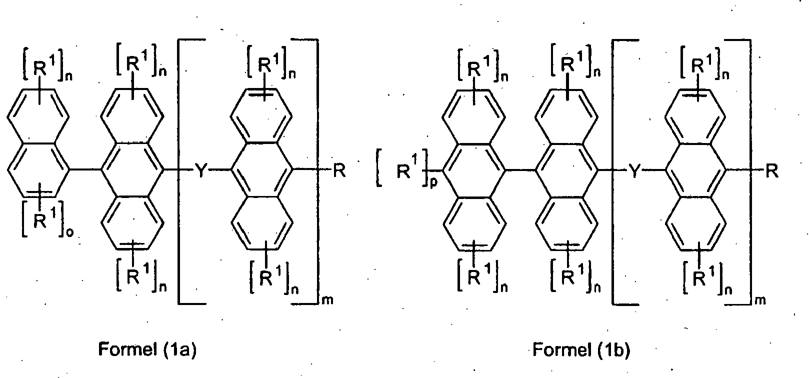 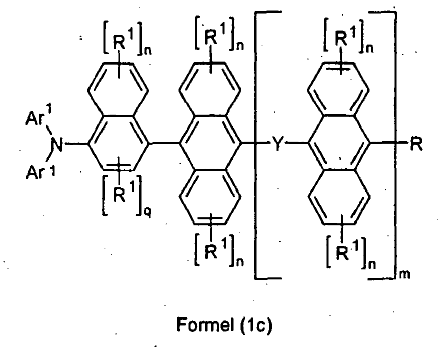 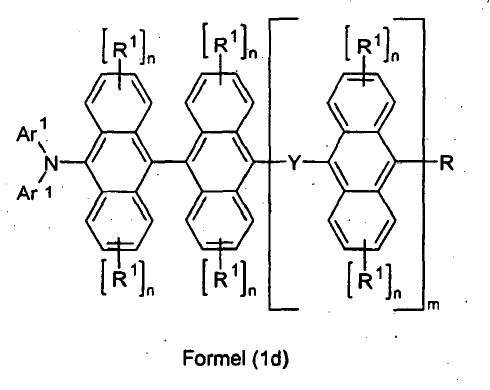 wobei R, Ar¹, R¹, Y, m und n die in Anspruch 1 definierte Bedeutung haben, wobei die beiden Reste Ar¹ auch durch eine Einfachbindung oder eine Gruppe O, S, N(R¹) oder C(R¹)₂ miteinander verbunden sein können, und weiterhin gilt:
o ist 0, 1, 2 oder 3;
p ist 0 oder 1, bevorzugt 1;
q ist 0, 1 oder 2;
**dadurch gekennzeichnet, dass** mindestens ein Rest R¹ anwesend ist, der für eine Gruppe Si(R²)₃ steht.

3. Verbindung nach Anspruch 1 oder 2, **dadurch gekennzeichnet, dass** das Symbol R für ein aromatisches oder heteroaromatisches Ringsystem mit 6 bis 24 aromatischen Ringatomen steht, welches mit einem oder mehreren Resten R¹ substituiert sein kann, oder dass das Symbol R für eine Gruppe der Formel (2a) oder (2b) steht, 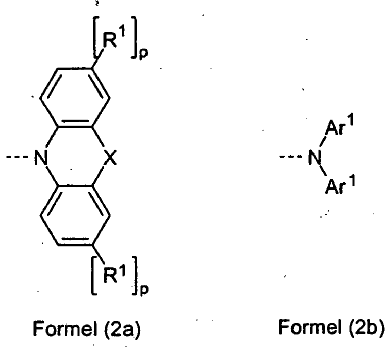 wobei R¹ und p die in Anspruch 1 und 2 aufgeführte Bedeutung haben und weiterhin gilt:
X steht für eine Einfachbindung, O, S, N(R¹) oder C(R¹)₂;
Ar¹ ist gleich oder verschieden bei jedem Auftreten eine Aryl- oder Heteroarylgruppe mit 5 bis 20 aromatischen Ringatomen, welche mit einem oder mehreren Resten R¹ substituiert sein kann, bevorzugt eine Aryl- oder Heteroarylgruppe mit 6 bis 14 aromatischen Ringatomen, welche mit einem oder mehreren Resten R¹ substituiert sein kann, besonders bevorzugt Phenyl, 1-Naphthyl oder 2-Naphthyl, welches jeweils mit einem oder mehreren Resten R¹ substituiert sein kann.

4. Verbindung nach einem oder mehreren der Ansprüche 1 bis 3, **dadurch gekennzeichnet, dass** das Symbol R, wenn es für ein aromatisches oder heteroaromatisches Ringsystem steht, für eine kondensierte Aryl- oder Heteroarylgruppe mit 10 bis 16 aromatischen Ringatomen oder für eine aromatische, gegebenenfalls überbrückte, Biarylgruppe steht, die jeweils mit einem oder mehreren Resten R¹ substituiert sein können, insbesondere für eine 1-Naphthyl-, 2-Naphthyl-, 9-Anthryl-, 2-Phenanthrenyl-, 9-Phenanthrenyl-, Chinolinyl-, Isochinolinyl-, ortho-, meta- oder para-Biphenyl-, 2-Fluorenyl- oder 2-Spirobifluorenylgruppe, die jeweils mit einem oder mehreren Resten R¹ substituiert sein kann.

5. Verbindung nach einem oder mehreren der Ansprüche 1 bis 4, **dadurch gekennzeichnet, dass** das Symbol R¹, gleich oder verschieden bei jedem Auftreten, für Si(R²)₃, F, eine geradkettige Alkyl- oder Alkoxygruppe mit 1 bis 6 C-Atomen oder eine verzweigte oder cyclische Alkyl- oder Alkoxygruppe mit 3 bis 10 C-Atomen, wobei jeweils ein oder mehrere CH₂-Gruppen durch -R³C=CR³-, Si(R³)₂, -O-, -S- oder -N(R³)- ersetzt sein können und wobei jeweils ein oder mehrere H-Atome durch F ersetzt sein können, oder eine Aryl- oder Heteroarylgruppe mit 5 bis 14 aromatischen Ringatomen, die mit einem oder mehreren Resten R³ substituiert sein kann, oder eine Kombination aus zwei oder drei dieser Systeme steht; dabei können auch zwei oder mehrere Reste R¹ miteinander ein mono-oder polycyclisches, aliphatisches Ringsystem bilden.

6. Verbindung nach einem oder mehreren der Ansprüche 1 bis 5, **dadurch gekennzeichnet, dass** das Symbol Y, gleich oder verschieden bei jedem Auftreten, eine lineare Alkylengruppe mit 1 bis 10 C-Atomen oder eine verzweigte oder cyclische Alkylen- oder Alkylidengruppe mit 3 bis 10 C-Atomen, eine bivalente aromatische Gruppe mit 6 bis 25 C-Atomen, C=O, -O-, -S- oder eine Gruppe der Formel -N(R¹)- oder -P(=O)R¹- oder eine Einfachbindung darstellt.

7. Verbindung nach einem oder mehreren der Ansprüche 1 bis 6, **dadurch gekennzeichnet, dass** diese eine, zwei, drei oder vier Gruppen der Formel Si(R²)₃ enthält.

8. Verbindung nach einem oder mehreren der Ansprüche 1 bis 7, **dadurch gekennzeichnet, dass** mindestens eine Gruppe Si(R²)₃ an die zentrale Anthraceneinheit, bevorzugt in 2-Position und/oder in 6-Position, gebunden ist und/oder dass mindestens eine Gruppe der Formel Si(R²)₃ an die Gruppe Ar gebunden ist, insbesondere in der 4-Position, wenn die Gruppe Ar eine Naphthylgruppe darstellt, oder in der 10-Position, wenn die Gruppe Ar eine Anthrylgruppe darstellt, und/oder dass mindestens eine Gruppe der Formel Si(R²)₃ an die Gruppe R gebunden ist.

9. Verbindung nach einem oder mehreren der Ansprüche 1 bis 8, **dadurch gekennzeichnet, dass** die Reste R² an der Silylgruppe aus geradkettigen Alkylgruppen mit 1 bis 10 C-Atomen oder verzweigten oder cyclischen Alkylgruppen mit 3 bis 10 C-Atomen, wobei jeweils eine oder mehrere nicht benachbarte CH₂-Gruppen, die nicht direkt an das Silicium binden, durch O ersetzt sein können und wobei jeweils ein oder mehrere H-Atome durch F ersetzt sein können, gewählt sind; dabei können auch zwei oder mehrere Substituenten R² miteinander ein mono- oder polycyclisches Ringsystem bilden.

10. Verfahren zur Herstellung von Verbindungen nach einem oder mehreren der Ansprüche 1 bis 9, welche eine oder mehrere Gruppen Si(R²)₃ an der Gruppe Ar bzw. R tragen, durch Kupplung einer funktionalisierten Gruppe Ar bzw. R, welche durch eine oder mehrere Gruppen Si(R²)₃ substituiert ist, mit einem entsprechenden Anthracenderivat.

11. Verwendung von Verbindungen nach einem oder mehreren der Ansprüche 1 bis 9 in organischen elektronischen Vorrichtungen, insbesondere in organischen Elektrolumineszenzvorrichtungen.

12. Organische elektronische Vorrichtung, enthaltend mindestens eine Verbindung nach einem oder mehreren der Ansprüche 1 bis 9.

13. Organische elektronische Vorrichtung gemäß Anspruch 12, gewählt aus organischen Elektrolumineszenzvorrichtungen (OLEDs, PLEDs), organischen Feld-Effekt-Transistoren (O-FETs), organischen Dünn-filmtransistoren (O-TFTs); organischen lichtemittierenden Transistoren (O-LETs), organischen integrierten Schaltungen (O-ICs), organischen Solarzellen (O-SCs), organischen Feld-Quench-Devices (O-FQDs), organischen Photorezeptoren, lichtemittierende elektrochemische Zellen (LECs) oder organische Laserdioden (O-Laser).

14. Organische Elektrolumineszenzvorrichtung nach Anspruch 12 oder 13, **dadurch gekennzeichnet, dass** mindestens eine emittierende Schicht, eine Lochtransportschicht, eine Lochinjektionsschicht, eine Lochblockierschicht und/oder eine Elektronentransportschicht mindestens eine Verbindung gemäß mindestens einem der Ansprüche 1 bis 9 enthält.

15. Organische Elektrolumineszenzvorrichtung nach Anspruch 14, **dadurch gekennzeichnet, dass** die Verbindung gemäß mindestens einem der Ansprüche 1 bis 9, wenn das Symbol R für ein aromatisches oder heteroaromatisches Ringsystem steht, als Host-material für fluoreszierende Emitter und/oder als Elektronentransportmaterial und/oder als, Lochblockiermaterial eingesetzt wird.

16. Organische Elektrolumineszenzvorrichtung nach Anspruch 14, **dadurch gekennzeichnet, dass** die Verbindung gemäß mindestens einem der Ansprüche 1 bis 9, wenn das Symbol R für eine Gruppe N(Ar¹)₂ steht, als emittierende Verbindung und/oder als Lochtransportmaterial eingesetzt wird.

## Claims

1. Silyl-substituted compounds of the formula (1), 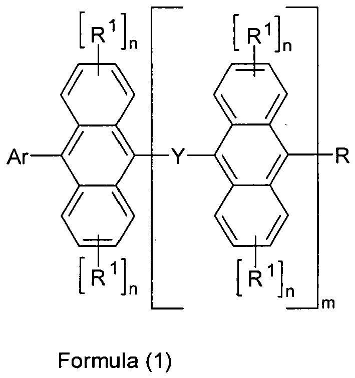 where the following applies to the symbols and indices used:
Ar is a 1-naphthyl group or a 9-anthryl group, in which one or two carbon atoms may be replaced by N and which may be substituted by one or more radicals R¹ and/or which may be substituted by one or more radicals N(Ar¹)₂, where the two radicals Ar¹ may also be connected to one another by a single bond or a group O, S, N(R¹) or C(R¹)₂;
R is an aromatic or heteroaromatic ring system having 5 to 40 aromatic ring atoms, which may be substituted by one or more radicals R¹, or an N(Ar¹)₂ group, where the two radicals Ar¹ may also be connected to one another by a single bond or a group O, S, N(R¹) or C(R¹)₂;
Ar¹ is on each occurrence, identically or differently, an aromatic or heteroaromatic ring system having 5 to 40 aromatic ring atoms, which may be substituted by one or more radicals R¹;
Y is on each occurrence, identically or differently, a divalent group containing 1 to 40 C atoms or -O-, -S-, -NR¹-, -P(=O)R¹-or a single bond;
R¹ is, identically or differently on each occurrence, Si(R²)₃, F, Cl, Br, I, CN, N(R³)₂, NO₂, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals R³, where one or more non-adjacent CH₂ groups may be replaced by -R³C=CR³-, -C=C-, Si(R³)₂, Ge(R³)₂, Sn(R³)₂, C=O, C=S, C=Se, C=NR³, -O-, -S-, -N(R³)- or -CONR³- and where one or more H atoms may be replaced by F, Cl, Br, I, CN or NO₂, or an aryl or heteroaryl group having 5 to 24 aromatic ring atoms, which may be substituted by one or more radicals R³, or an aryloxy or heteroaryloxy group having 5 to 24 aromatic ring atoms, which may be substituted by one or more radicals R³, or a combination of two, three, four or five of these systems; two or more adjacent substituents R¹ here may also form a mono- or polycyclic, aliphatic ring system with one another;
R² is on each occurrence, identically or differently, a straight-chain alkyl group having 1 to 40 C atoms or a branched or cyclic alkyl group having 3 to 40 C atoms, in each of which one or more non-adjacent CH₂ groups which are not bonded directly to the silicon may be replaced by -R³C=CR³-, -C=C-, Si(R³)₂, Ge(R³)₂, Sn(R³)₂, C=O, C=S, C=Se, C=NR³, -O-, -S-, -N(R³)- or -CONR³- and in each of which one or more H atoms may be replaced by F, Cl, Br, I, CN or NO₂, and which may also be substituted by an aryl or heteroaryl group having 5 to 24 aromatic ring atoms, which may be substituted by one or more radicals R³, or by an aryloxy or heteroaryloxy group having 5 to 24 aromatic ring atoms, which may be substituted by one or more radicals R³; two or more substituents R² here may also form a mono- or polycyclic ring system with one another;
R³ is on each occurrence, identically or differently, H or a hydrocarbon radical having 1 to 20 C atoms, which may be aliphatic or aromatic or a combination of aliphatic and aromatic and which may also be substituted by F; two or more radicals R³ here may also form a mono- or polycyclic, aliphatic or aromatic ring system with one another;
n is, identically or differently on each occurrence, 0, 1, 2, 3 or 4;
m is 0, 1, 2, 3, 4 or 5;
**characterised in that** at least one radical R¹ which represents an Si(R²)₃ group is present in the molecule.

2. Compounds of the formulae (1a) to (1d) according to Claim 1, 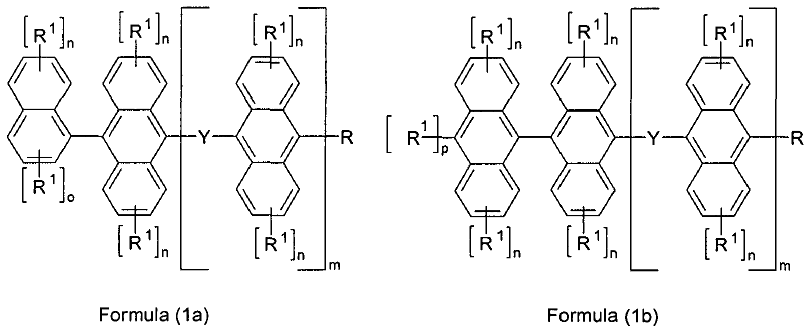 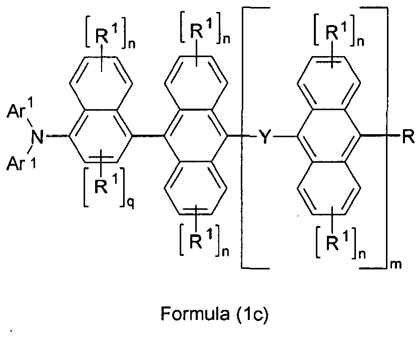 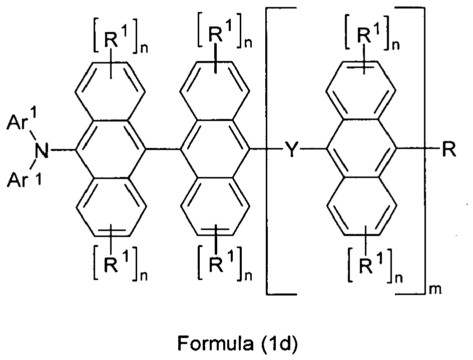 where R, Ar¹, R¹, Y, m and n have the meaning defined in Claim 1, where the two radicals Ar¹ may also be connected to one another by a single bond or an O, S, N(R¹) or C(R¹)₂ group, and furthermore the following applies:
o is 0, 1, 2 or 3;
p is 0 or 1, preferably 1;
q is 0, 1 or 2;
**characterised in that** at least one radical R¹ which stands for an Si(R²)₃ group is present.

3. Compound according to Claim 1 or 2, **characterised in that** the symbol R stands for an aromatic or heteroaromatic ring system having 6 to 24 aromatic ring atoms, which may be substituted by one or more radicals R¹, or **in that** the symbol R stands for a group of the formula (2a) or (2b), 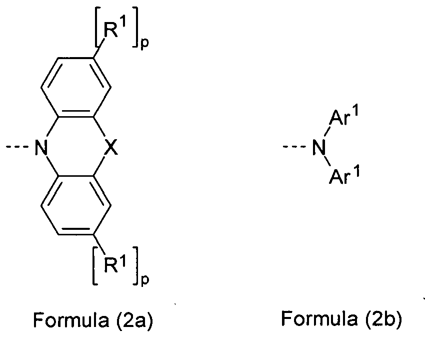 where R¹ and p have the meaning indicated in Claims 1 and 2, and furthermore the following applies:
X stands for a single bond, O, S, N(R¹) or C(R¹)₂;
Ar¹ is, identically or differently on each occurrence, an aryl or heteroaryl group having 5 to 20 aromatic ring atoms, which may be substituted by one or more radicals R¹, preferably an aryl or heteroaryl group having 6 to 14 aromatic ring atoms, which may be substituted by one or more radicals R¹, particularly preferably phenyl, 1-naphthyl or 2-naphthyl, each of which may be substituted by one or more radicals R¹.

4. Compound according to one or more of Claims 1 to 3, **characterised in that** the symbol R, if it stands for an aromatic or heteroaromatic ring system, stands for a condensed aryl or heteroaryl group having 10 to 16 aromatic ring atoms or for an aromatic, optionally bridged biaryl group, each of which may be substituted by one or more radicals R¹, in particular for a 1-naphthyl, 2-naphthyl, 9-anthryl, 2-phenanthrenyl, 9-phenanthrenyl, quinolinyl, isoquinolinyl, ortho-, meta- or para-biphenyl, 2-fluorenyl or 2-spirobifluorenyl group, each of which may be substituted by one or more radicals R¹.

5. Compound according to one or more of Claims 1 to 4, **characterised in that** the symbol R¹, identically or differently on each occurrence, stands for Si(R²)₃, F, a straight-chain alkyl or alkoxy group having 1 to 6 C atoms or a branched or cyclic alkyl or alkoxy group having 3 to 10 C atoms, in each of which one or more CH₂ groups may be replaced by -R³C=CR³-, Si(R³)₂, -O-, -S- or -N(R³)- and in each of which one or more H atoms may be replaced by F, or an aryl or heteroaryl group having 5 to 14 aromatic ring atoms, which may be substituted by one or more radicals R³, or a combination of two or three of these systems; two or more radicals R¹ here may also form a mono- or polycyclic, aliphatic ring system with one another.

6. Compound according to one or more of Claims 1 to 5, **characterised in that** the symbol Y, identically or differently on each occurrence, represents a linear alkylene group having 1 to 10 C atoms or a branched or cyclic alkylene or alkylidene group having 3 to 10 C atoms, a divalent aromatic group having 6 to 25 C atoms, C=O, -O-, -S- or a group of the formula -N(R¹)- or -P(=O)R¹- or a single bond.

7. Compound according to one or more of Claims 1 to 6, **characterised in that** it contains one, two, three or four groups of the formula Si(R²)₃.

8. Compound according to one or more of Claims 1 to 7, **characterised in that** at least one Si(R²)₃ group is bonded to the central anthracene unit, preferably in the 2-position and/or in the 6-position, and/or **in that** at least one group of the formula Si(R²)₃ is bonded to the Ar group, in particular in the 4-position if the Ar group represents a naphthyl group or in the 10-position if the Ar group represents an anthryl group, and/or **in that** at least one group of the formula Si(R²)₃ is bonded to the R group.

9. Compound according to one or more of Claims 1 to 8, **characterised in that** the radicals R² on the silyl group are selected from straight-chain alkyl groups having 1 to 10 C atoms or branched or cyclic alkyl groups having 3 to 10 C atoms, in each of which one or more non-adjacent CH₂ groups which are not bonded directly to the silicon may be replaced by O and in each of which one or more H atoms may be replaced by F; two or more substituents R² here may also form a mono- or polycyclic ring system with one another.

10. Process for the preparation of compounds according to one or more of Claims 1 to 9 which carry one or more Si(R²)₃ groups on the Ar or R group by coupling a functionalised Ar or R group which is substituted by one or more Si(R²)₃ groups to a corresponding anthracene derivative.

11. Use of compounds according to one or more of Claims 1 to 9 in organic electronic devices, in particular in organic electroluminescent devices.

12. Organic electronic device comprising at least one compound according to one or more of Claims 1 to 9.

13. Organic electronic device according to Claim 12, selected from organic electroluminescent devices (OLEDs, PLEDs), organic field-effect transistors (O-FETs), organic thin-film transistors (O-TFTs), organic light-emitting transistors (O-LETs), organic integrated circuits (O-ICs), organic solar cells (O-SCs), organic field-quench devices (O-FQDs), organic photoreceptors, light-emitting electrochemical cells (LECs) and organic laser diodes (O-lasers).

14. Organic electroluminescent device according to Claim 12 or 13, **characterised in that** at least one emitting layer, hole-transport layer, hole-injection layer, hole-blocking layer and/or electron-transport layer comprises at least one compound according to at least one of Claims 1 to 9.

15. Organic electroluminescent device according to Claim 14, **characterised in that** the compound according to at least one of Claims 1 to 9, if the symbol R stands for an aromatic or heteroaromatic ring system, is employed as host material for fluorescent emitters and/or as electron-transport material and/or as hole-blocking material.

16. Organic electroluminescent device according to Claim 14, **characterised in that** the compound according to at least one of Claims 1 to 9, if the symbol R stands for an N(Ar¹)₂ group, is employed as emitting compound and/or as hole-transport material.

## Revendications

1. Composés substitués par silyle de la formule (1) : 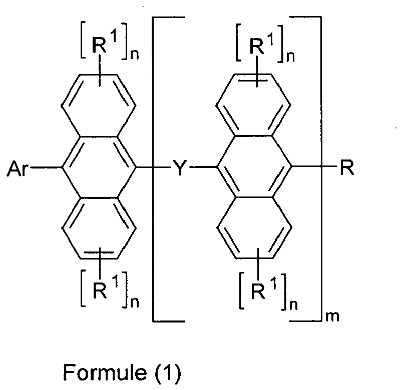 dans laquelle ce qui suit s'applique aux symboles et indices utilisés :
Ar est un groupe 1-naphtyle ou un groupe 9-anthryle, dans lequel un ou deux atome(s) de carbone peut/peuvent être remplacé(s) par N et lequel peut être substitué par un radical ou plusieurs radicaux R¹ et/ou lequel peut être substitué par un radical ou plusieurs radicaux N(Ar¹)₂, où les deux radicaux Ar¹ peuvent également être connectés l'un à l'autre par une liaison simple ou un groupe O, S, N(R¹) ou C(R¹)_{2;}
R est un système de cycle aromatique ou hétéroaromatique comportant 5 à 40 atomes de cycle aromatique, lequel peut être substitué par un radical ou plusieurs radicaux R¹, ou un groupe N(Ar¹)₂, où les deux radicaux Ar¹ peuvent également être connectés l'un à l'autre par une liaison simple ou un groupe O, S, N(R¹) ou C(R¹)₂ ;
Ar¹ est, pour chaque occurrence, de manière identique ou différente, un système de cycle aromatique ou hétéroaromatique comportant 5 à 40 atomes de cycle aromatique, lequel peut être substitué par un radical ou plusieurs radicaux R^{1 ;}
Y est, pour chaque occurrence, de manière identique ou différente, un groupe divalent contenant 1 à 40 atome(s) de C ou -O-, -S-, -NR¹-, -P(=O)R¹- ou une liaison simple ;
R¹ est, de manière identique ou différente pour chaque occurrence, Si(R²)₃, F, Cl, Br, I, CN, N(R³)₂, NO₂, un groupe alkyle, alcoxy ou thioalcoxy en chaîne droite comportant 1 à 40 atome(s) de C ou un groupe alkyle, alcoxy ou thioalcoxy ramifié ou cyclique comportant 3 à 40 atomes de C, dont chacun peut être substitué par un radical ou plusieurs radicaux R³, où un ou plusieurs groupe(s) CH₂ non adjacents peut/peuvent être remplacé(s) par -R³C=CR³-, -C≡C-, Si(R³)₂, Ge(R³)₂, Sn(R³)₂, C=O, C=S, C=Se, C=NR³, -O-, -S-, -N(R³)- ou -CONR³- et où un ou plusieurs atome(s) de H peut/peuvent être remplacé(s) par F, Cl, Br, I, CN ou NO₂, ou un groupe aryle ou hétéroaryle comportant 5 à 24 atomes de cycle aromatique, lequel peut être substitué par un radical ou plusieurs radicaux R³, ou un groupe aryloxy ou hétéroaryloxy comportant 5 à 24 atomes de cycle aromatique, lequel peut être substitué par un radical ou plusieurs radicaux R³, ou une combinaison de deux, trois, quatre ou cinq de ces systèmes ; deux substituants R¹ adjacents ou plus peuvent ici également former un système de cycle aliphatique monocyclique ou polycyclique l'un avec l'autre ou les uns avec les autres ;
R² est, pour chaque occurrence, de manière identique ou différente, un groupe alkyle en chaîne droite comportant 1 à 40 atome(s) de C ou un groupe alkyle ramifié ou cyclique comportant 3 à 40 atomes de C, et dans chacun d'eux, un ou plusieurs groupe(s) CH₂ non adjacents qui n'est/ne sont pas lié(s) directement au silicium peut/peuvent être remplacé(s) par -R³C=CR³-, -C≡C-, Si(R³)₂, Ge(R³)₂, Sn(R³)₂, C=O, C=S, C=Se, C=NR³, -O-, -S-, -N(R³)- ou -CONR³- et dans chacun d'eux, un ou plusieurs atome(s) de H peut/peuvent être remplacé(s) par F, Cl, Br, I, CN ou NO₂, et lesquels peuvent également être substitués par un groupe aryle ou hétéroaryle comportant 5 à 24 atomes de cycle aromatique, lequel peut être substitué par un radical ou plusieurs radicaux R³, ou par un groupe aryloxy ou hétéroaryloxy comportant 5 à 24 atomes de cycle aromatique, lequel peut être substitué par un radical ou plusieurs radicaux R^{3 ;} deux substituants R² ou plus peuvent ici également former un système de cycle monocyclique ou polycyclique l'un avec l'autre ou les uns avec les autres ;
R³ est, pour chaque occurrence, de manière identique ou différente, H ou un radical hydrocarbone comportant 1 à 20 atome(s) de C, lequel peut être aliphatique ou aromatique ou une combinaison de aliphatique et aromatique et lequel peut également être substitué par F ; deux radicaux R³ ou plus peuvent ici également former un système de cycle aliphatique ou aromatique monocyclique ou polycyclique l'un avec l'autre ou les uns avec les autres ;
n est, de manière identique ou différente pour chaque occurrence, 0, 1, 2, 3 ou 4 ;
m est 0, 1, 2, 3, 4 ou 5 ;
**caractérisés en ce qu'**au moins un radical R¹ qui représente un groupe Si(R²)₃ est présent dans la molécule.

2. Composés des formules (1a) à (1d) selon la revendication 1 : 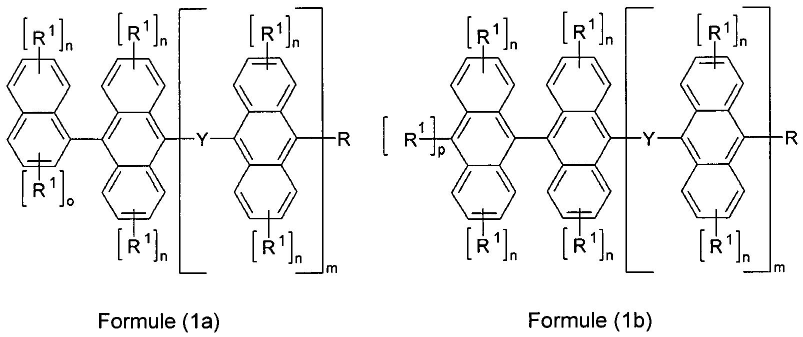 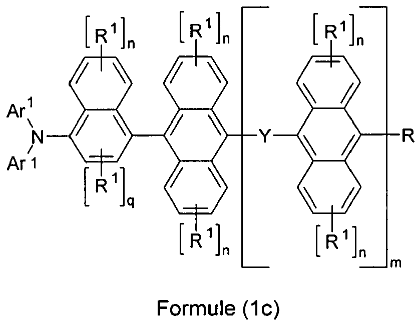 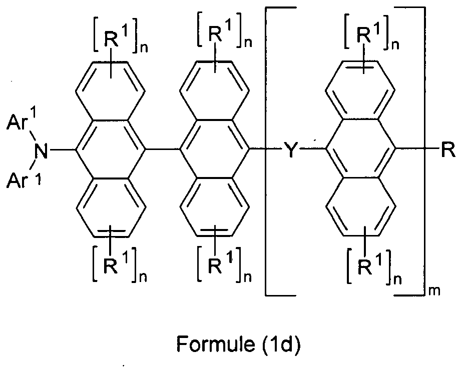 dans lesquelles R, Ar¹, R¹, Y, m et n présentent la signification définie selon la revendication 1, où les deux radicaux Ar¹ peuvent également être connectés l'un à l'autre par une liaison simple ou un groupe O, S, N(R¹) ou C(R¹)₂, et en outre, ce qui suit s'applique :
o est 0, 1, 2 ou 3;
p est 0 ou 1, de façon préférable 1 ;
q est 0, 1 ou 2 ;
**caractérisés en ce qu'**au moins un radical R¹ qui représente un groupe Si(R²)₃ est présent.

3. Composé selon la revendication 1 ou 2, **caractérisé en ce que** le symbole R représente un système de cycle aromatique ou hétéroaromatique comportant 6 à 24 atomes de cycle aromatique, lequel peut être substitué par un radical ou plusieurs radicaux R¹, ou **en ce que** le symbole R représente un groupe de la formule (2a) ou (2b) : 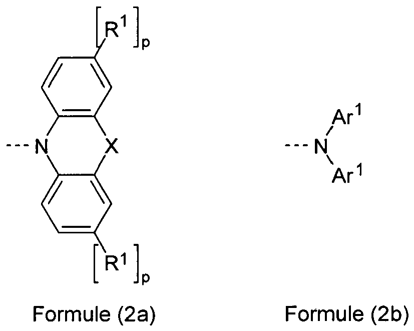 dans lesquelles R¹ et p présentent la signification indiquée selon les revendications 1 et 2, et en outre, ce qui suit s'applique :
X représente une liaison simple, O, S, N(R¹) ou C(R¹)_{2;}
Ar¹ est, de manière identique ou différente pour chaque occurrence, un groupe aryle ou hétéroaryle comportant 5 à 20 atomes de cycle aromatique, lequel peut être substitué par un radical ou plusieurs radicaux R¹, de façon préférable un groupe aryle ou hétéroaryle comportant 6 à 14 atomes de cycle aromatique, lequel peut être substitué par un radical ou plusieurs radicaux R¹, de façon particulièrement préférable phényle, 1-naphtyle ou 2-naphtyle, dont chacun peut être substitué par un radical ou plusieurs radicaux R¹.

4. Composé selon une ou plusieurs des revendications 1 à 3, **caractérisé en ce que** le symbole R, s'il représente un système de cycle aromatique ou hétéroaromatique, représente un groupe aryle ou hétéroaryle condensé comportant 10 à 16 atomes de cycle aromatique ou un groupe biaryle aromatique, en option ponté, dont chacun peut être substitué par un radical ou plusieurs radicaux R¹, en particulier un groupe 1-naphtyle, 2-naphtyle, 9-anthryle, 2-phénanthrényle, 9-phénanthrényle, quinolinyle, isoquinolinyle, ortho-, méta- ou para-biphényle, 2-fluorényle ou 2-spirobifluorényle, dont chacun peut être substitué par un radical ou plusieurs radicaux R¹.

5. Composé selon une ou plusieurs des revendications 1 à 4, **caractérisé en ce que** le symbole R¹, de manière identique ou différente pour chaque occurrence, représente Si(R²)₃, F, un groupe alkyle ou alcoxy en chaîne droite comportant 1 à 6 atome(s) de C ou un groupe alkyle ou alcoxy ramifié ou cyclique comportant 3 à 10 atomes de C, et dans chacun d'eux, un ou plusieurs groupe(s) CH₂ peut/peuvent être remplacé(s) par -R³C=CR³-, Si(R³)₂, -O-, -S- ou -N(R³)- et dans chacun d'eux, un ou plusieurs atome(s) de H peut/peuvent être remplacé(s) par F, ou un groupe aryle ou hétéroaryle comportant 5 à 14 atomes de cycle aromatique, lequel peut être substitué par un radical ou plusieurs radicaux R³, ou une combinaison de deux ou trois de ces systèmes ; deux radicaux R¹ ou plus peuvent également ici former un système de cycle aliphatique monocyclique ou polycyclique l'un avec l'autre ou les uns avec les autres.

6. Composé selon une ou plusieurs des revendications 1 à 5, **caractérisé en ce que** le symbole Y, de manière identique ou différente pour chaque occurrence, représente un groupe alkylène linéaire comportant 1 à 10 atome(s) de C ou un groupe alkylène ou alkylidène ramifié ou cyclique comportant 3 à 10 atomes de C, un groupe aromatique divalent comportant 6 à 25 atomes de C, C=O, -O-, -S- ou un groupe de la formule -N(R¹)- ou -P(=O)R¹- ou une liaison simple.

7. Composé selon une ou plusieurs des revendications 1 à 6, **caractérisé en ce qu'**il contient un, deux, trois ou quatre groupes de la formule Si(R²)₃.

8. Composé selon une ou plusieurs des revendications 1 à 7, **caractérisé en ce qu'**au moins un groupe Si(R²)₃ est lié à l'unité anthracène centrale, de façon préférable à la position 2 et/ou à la position 6, et/ou en ce qu'au moins un groupe de la formule Si(R²)₃ est lié au groupe Ar, en particulier à la position 4 si le groupe Ar représente un groupe naphtyle ou à la position 10 si le groupe Ar représente un groupe anthryle, et/ou **en ce qu'**au moins un groupe de la formule Si(R²)₃ est lié au groupe R.

9. Composé selon une ou plusieurs des revendications 1 à 8, **caractérisé en ce que** les radicaux R² sur le groupe silyle sont choisis parmi des groupes alkyle en chaîne droite comportant 1 à 10 atome(s) de C ou des groupes alkyle ramifié ou cyclique comportant 3 à 10 atomes de C, et dans chacun d'eux, un ou plusieurs groupe(s) CH₂ non adjacents qui ne sont pas liés directement au silicium peut/peuvent être remplacé(s) par O et dans chacun d'eux, un ou plusieurs atome(s) de H peut/peuvent être remplacé(s) par F ; deux substituants R² ou plus peuvent ici également former un système de cycle monocyclique ou polycyclique l'un avec l'autre ou les uns avec les autres.

10. Procédé pour la préparation de composés selon une ou plusieurs des revendications 1 à 9 qui sont porteurs d'un ou de plusieurs groupe(s) Si(R²)₃ sur le groupe Ar ou R en couplant un groupe fonctionnalisé Ar ou R qui est substitué par un ou plusieurs groupe(s) Si(R²)₃ sur un dérivé anthracène correspondant.

11. Utilisation de composés selon une ou plusieurs des revendications 1 à 9 dans des dispositifs électroniques organiques, en particulier dans des dispositifs électroluminescents organiques.

12. Dispositif électronique organique comprenant au moins un composé selon une ou plusieurs des revendications 1 à 9.

13. Dispositif électronique organique selon la revendication 12, choisi parmi des dispositifs électroluminescents organiques (OLED, PLED), des transistors à effet de champ organiques (O-FET), des transistors à film mince organiques (O-TFT), des transistors à émission de lumière organiques (O-LET), des circuits intégrés organiques (O-IC), des cellules solaires organiques (O-SC), des dispositifs à extinction de champ organiques (O-FQD), des photorécepteurs organiques, des cellules électrochimiques à émission de lumière (LEC) et des diodes laser organiques (O-laser).

14. Dispositif électroluminescent organique selon la revendication 12 ou 13, **caractérisé en ce qu'**au moins une couche d'émission, une couche de transport de trous, une couche d'injection de trous, une couche de blocage de trous et/ou une couche de transport d'électrons comprend/comprennent au moins un composé selon au moins l'une des revendications 1 à 9.

15. Dispositif électroluminescent organique selon la revendication 14, **caractérisé en ce que** le composé selon au moins l'une des revendications 1 à 9, si le symbole R représente un système de cycle aromatique ou hétéroaromatique, est utilisé en tant que matériau hôte pour des émetteurs fluorescents et/ou en tant que matériau de transport d'électrons et/ou en tant que matériau de blocage de trous.

16. Dispositif électroluminescent organique selon la revendication 14, **caractérisé en ce que** le composé selon au moins l'une des revendications 1 à 9, si le symbole R représente un groupe N(Ar¹)₂, est utilisé en tant que composé d'émission et/ou en tant que matériau de transport de trous.
